# EUROPEAN PATENT APPLICATION

(11) **EP 3 002 501 A1**
(43) Date of publication of application: **06.04.2016**
(21) Application number: 14787783.1
(22) Date of filing: 14.04.2014
(51) Int. Cl.: F21S 2/00, F21V 29/00, H01L 33/48, F21Y 101/00

(54) **LED LIGHT BULB MANUFACTURING METHOD**

(30) Priority: 22.04.2013 CN 201310140124; 22.04.2013 CN 201310140150; 22.04.2013 CN 201310140105; 22.04.2013 CN 201310140134; 22.04.2013 CN 201310140106; 22.04.2013 CN 201310140151
(71) Applicant: Guizhou Guangpusen Photoelectric Co., Ltd, Guizhou (CN)
(72) Inventor: ZHANG, Jiqiang, Guiyang Guizhou 550002 (CN); ZHANG, Zheyuan, Guiyang Guizhou 550002 (CN)
(74) Representative: Winkler, Andreas Fritz Ernst
(86) International application number: PCT/CN2014/075245
(87) International publication number: WO 2014/173239

(57) **Abstract**

An LED light bulb manufacturing method, comprising the following steps: 1) preparing a transitional epitaxial layer on a substrate to form an epitaxial wafer; 2) putting the epitaxial wafer into a reacting furnace to undergo such process steps as silicon coating, sizing, photolithography, etching, film coating, alloying, and slice grinding, the epitaxial wafer growing by layers to form an LED wafer at a specific position and relevant circuits; the LED wafer will not be cut after the completion of the growth; obtaining product A after the LED wafer passes inspection, and die bonding a relevant component on product A, and then conducting wire bonding to obtain product B; 3) on product B, performing the process steps of sealant pouring to cover the wafer and baking, and after inspection, conducting color separation and light splitting, so as to form a finished light engine module; 4) utilizing the light engine module and light bulb accessories to assemble an LED light bulb, and aging and packaging the assembled LED light bulb to obtain a finished LED light bulb. The manufacturing method realizes large-scale and intensified production of LED lighting source products, and greatly reduces the manufacturing cost of LED light.

## Description

### TECHNICAL FIELD

The present invention refers to the field of LED lighting technology, and more specifically to an LED light bulb manufacturing method.

### BACKGROUND OF THE PRESENT INVENTION

Chinese patent 201210253590.X, 201210253702.1, 201210253639.1, 201210253844.8, 201210255564.0, 201110024636.6 and others disclose multiple structural concepts for the universal and interchangeable LED light bulb; and 201210253590.X, 201210253702.1, 201210253639.1, 201210253844.8, 201210255564.0, 201110024636.6 and others disclose multiple structural concepts for LED light of which the LED bulb is convenient to be replaced. LED is used as the luminous element in the LED light bulb described in aforesaid patents and other relevant patents. The described LED bulb is light source structure which can be used independently, interchangeable, replaceable and cannot be disassembled with non-destructive means. It is convenient to replace the LED bulb of the described LED light. Moreover, compared with existing all-in-one structure of LED light, it is simpler. These technologies lay foundation for the establishment of lighting industry framework focused on LED light bulb and the basic concept of making LED light bulb (lighting source), lamps, lighting control become independent production and application terminal product. It is of profound significance to further create advanced and more standard structural components of LED light bulb for improving the existing LED lighting industry framework, especially the light engine module as the core component of LED light bulb.

### SUMMARY OF THE PRESENT INVENTION

The purpose of the present invention is to realize large-scale and intensified production of LED lighting products, and greatly reduce the manufacturing cost of LED by providing an LED illuminating lamp manufacturing method.

The technical proposal of the present invention is to provide an LED light bulb manufacturing method, characterized in that it comprises following steps:
1) preparing a transitional epitaxial layer on a substrate to form an epitaxial wafer;
2) putting the epitaxial wafer into a reacting furnace to undergo such process steps as silicon coating, sizing, photolithography, etching, film coating, alloying, and slice grinding, the epitaxial wafer growing by layers to form an LED wafer at a specific position and relevant circuits; the LED wafer will not be cut after the completion of the growth; obtaining product A after the LED wafer passes inspection, and die bonding relevant components on product A (die bonding the wafer level driving power chip and other components if have and it also can be formed through direct growth in the reacting furnace)and then conducting wire bonding to obtain product B;(conducting wire bonding to connect the LED wafer and relevant components), after step 2, the complete LED circuit can be formed on epitaxial wafer(the same with predetermined LED circuit); and the processes of epitaxial wafer growing by layers to form LED wafer (photolithography, etching and others) are all existing technologies.
3) on product B, performing the process steps of sealant pouring to cover the wafer and baking, and after inspection, conducting color separation and light splitting, so as to form a finished light engine module;
4) utilizing the light engine module and light bulb accessories to assemble an LED light bulb, and aging and packaging the assembled LED light bulb to obtain a finished LED light bulb.

In the aforesaid LED light bulb manufacturing method, the light engine plate is used as substrate directly in step 1, or thin substrate whose shape is the same with that of light engine plate is used as substrate; the specific step of the sealant pouring to cover the wafer is to use transparent sealant and/or transparent cover plate on the LED relevant components of product B to cover the wafer and only the correlated bonding pad on LED relevant components is shown; when the thin substrate whose shape is the same with that of light engine plate is used as substrate in step 1, then the product B is further needed to be bonded with light engine plate in step 3; both sides of the light engine plate are provided with gaps; the LED relevant components comprise an LED wafer, relevant circuits and relevant components. In the consideration of the production technology and cost of existing mature chips, the thin substrate whose shape is the same with that of light engine plate as substrate is utilized. The light engine module is supported by the light engine plate, so the thickness of which needs to meet a certain requirement, and the manufacturing cost is rather high because mature substrate materials are needed if utilizing the light engine plate as substrate directly; while if utilizing the thin substrate whose shape is the same with that of light engine plate as substrate and it is bonded with the light engine plate in step 3, the cost can be reduced relatively because the thinner substrate can be utilized and the light engine plate made up of common substrate materials plays the supporting role. But with the mass production of the light engine module, the cost of substrate materials will be reduced greatly, and then it will become normal utilizing the light engine plate as substrate directly.

The existing LED substrate materials can be utilized as the substrate materials, while the GaN and other materials can be utilized for transitional epitaxial layer based on grown wafer. LED wafer cutting and other process steps are not needed and the light engine module can be used on liquid-cooling light bulb in the present invention, so the requirements on material quality of substrate will be reduced greatly for the production of LED wafer, such as SiC substrate which is easy to be fracturing, SiC substrate with poor processing property, even the polycrystalline and high purity alumina material, and high purity silicon based material and others can access to the selection list of substrate materials.

The transparent material is used on the light engine plate, in this way, the lower emergent light of LED wafer can reflect inner cover of the light bulb through light engine plate and the reflector of LED light bulb, and then the luminous efficiency of wafer can be improve greatly and the junction temperature of wafer can be reduced.

The light bulb accessories mainly comprise a heat conducting support, a lens, a lens snap ring, an electric connector, a flexible built-up circuit, an inner cover, an inner ring cover and an inner snap ring.

In the aforesaid LED light bulb manufacturing method, the methods of covering LED relevant components by transparent sealant and/or transparent cover plate are as follows: filling in a little transparent sealant between LED relevant components to level, and forming the transparent sealant between the surface of LED wafer and the transparent cover plate as little as possible, then covering the transparent cover plate whose profile is the same with that of light engine plate on LED relevant components, besides, opening area is provided on transparent cover plate to show bonding pad; or filling in a little transparent sealant between LED relevant components to level, and covering the transparent cover plate whose profile is smaller than that of light engine plate on LED relevant components, then the transparent sealant is wrapped around the transparent cover plate to level the profile of transparent sealant with that of light engine plate, opening area is provided on transparent cover plate to show bonding pad; or the LED relevant components is wrapped up with the transparent sealant directly to level the profile of transparent sealant with that of light engine plate, opening area is provided on transparent cover plate to show bonding pad.

Different materials are used for two different plans on the light engine plate, in the plan of thin substrate, the role of light engine plate is equivalent to that of transparent cover plate, the other non-metal heat conducting materials of different epitaxial wafer substrates can be used to support epitaxial wafer, the phosphor and protective layer can be coated on back side of epitaxial wafer. Or the light engine plate is molded transparent fluorophor, a mixture of transparent materials and phosphor. Transparent fluorophor is prepared by the fluorescent materials and transparent materials according to the weight ratio of 5~30:100. While in the plan of utilizing light engine plate as substrate, the LED substrate material is used on light engine plate.

In the aforesaid LED light bulb manufacturing method, the small-sized light engine plate is circular plate, two inner arc gaps are provided on both sides of the circular plate symmetrically, the center of the arc gap is in the concentric circle of the periphery of circular plate; the circular hole is provided on the light engine plate for the connection with contact pin of electric connector, the bonding pad is located at the position of circular hole on LED relevant components, the contact pin of electric connector is soldered with the bonding pad after inserting into the circle hole.

In the aforesaid LED light bulb manufacturing method, the medium-sized light engine plate is circular plate, two bow shapes of the circle are removed symmetrically on both sides of the circular plate, forming two symmetrical gaps; wherein a circle hole with alignment pin is provided on the light engine plate, the circle hole is used for the alignment connection with the electric connector; wherein the bonding pad is disposed at the position of circle hole by LED relevant components through the flexible built-up circuit, wherein the electric connector is soldered with the bonding pad of the flexible built-up circuit after inserting into the circle hole.

In the aforesaid LED light bulb manufacturing method, the relatively large-sized light engine plate is circular plate, characterized in that both sides of the circular plate are provided with two symmetrical gaps, each gap is formed by cutting a string along the circle of the circular plate, moreover, both ends of the string tilt outwards to 120 degrees, and transit to the circle of the circular plate by circular arc; wherein the bonding pad is located at the inner side of the gap of the circular plate, the bonding pad is disposed at the inner side of two gaps or concentrated at the inner side of one gap therein respectively.

In the aforesaid LED light bulb manufacturing method, for the small-sized light engine plate, the circle diameter d_{G} of the circular plate is 11 mm or 16mm; when it is 11 mm, the center of two circular arc gaps is in the circle whose diameter d_{G} is 13mm (the distance between two circle centers), the radius of two circular arc gaps is 3.2mm; when it is 16 mm, the center of two circular arc gaps is in the circle whose diameter is 19mm (the distance between two circle centers), the radius of two circular arc gaps is 3.6mm, there are four circle holes connected with the contact pin of the electric connector, and they are distributed symmetrically with an equal distance of 3.5mm, the center of four circle holes is located at a distance of 2mm with the center of the circular plate , moreover, the center of four circle holes is the same distance with the two gaps.

In the aforesaid LED light bulb manufacturing method, for the medium-sized light engine plate, the circle diameter d_{G} of circular plate is 18mm or 25mm; when it is 18mm, the string length of the removed two bow shapes is 8.2mm, and the distance between two strings is 16mm; when it is 25mm, the string length of the removed two bow shapes is 9.8mm, and the distance between two strings is 23mm; the center of which is located at a distance of 2mm with the center of the circular plate, and the center of circle hole is the same distance with the two gaps.

In the aforesaid LED light bulb manufacturing method, for relatively large-sized light engine plate, the circle diameter d_{G} of the circular plate is 20mm, 38mm or 50mm; if the length between the gap subtract the outward tilting part of both sides, the length is 10mm, the radius of circular arc used for transition is 1 mm the two corresponding strings of two gaps are parallel to each other; when the circle diameter d_{G} of the circular plate is 20mm, the distance between two strings is 15mm; when the circle diameter d_{G} of the circular plate is 38mm, the distance between two strings is 33mm; when the circle diameter d_{G} of the circular plate is 50mm, the distance of two strings is 45mm;

In the aforesaid LED light bulb manufacturing method, the phosphor and protective layer are coated on the transparent cover plate and the light engine plate; or the light engine plate is molded transparent fluorophor, the transparent fluorophor is prepared by the fluorescent materials and transparent materials according to the weight ratio of 5~30:100.

In the aforesaid LED light bulb manufacturing method, there are two fixed holes provided on the light engine plate for fixing, the two fixed holes are symmetric around the center of circular plate with a distance of d_{G} -6, the diameter of fixed hole is 2.2mm; the link of two fixed holes is orthogonal with that of gaps center; when d_{G}=20mm, a fixed hole of one side need to be opened.

Another aspect of the present invention is to further provide an LED illuminating lamp manufacturing method, characterized in that it comprises following steps:
1) preparing a transitional epitaxial layer on a substrate to form an epitaxial wafer;
2) putting the epitaxial wafer into a reacting furnace to grow by layers to form an LED wafer and relevant circuits (growing by layers to form an LED wafer at a specific position based on the layout of predetermined LED circuit and the LED wafer will not be cut after the completion of the growth); obtaining product A after the LED wafer passes inspection, and die bonding relevant components on product A (conducting die bonding to the wafer level driving power chip and other components if have and it also can be formed through direct growth in the reacting furnace), and then conducting wire bonding to connect LED wafer and relevant components (if necessary) to obtain product B,
3) assembling product B into light engine module directly;
4) utilizing the light engine module and light bulb accessories to assemble an LED light bulb.
5) utilizing the assembled LED light bulb in step 4 and lamps in terminal market (or as well as lighting control products) to assemble LED illuminating lamp.

In the aforesaid LED illuminating lamp manufacturing method, the light engine plate is used as substrate directly in step 1, or thin substrate whose shape is the same with that of light engine plate is used as substrate; the concrete step of step 3 is to use transparent sealant and/or transparent cover plate on the LED relevant components of product B to cover the wafer and only the correlated bonding pad of LED relevant components is shown; when the thin substrate whose shape is the same with that of light engine plate is used as substrate in step 1, then the product B is further needed to be bonded with light engine plate in step 3; both sides of the light engine plate are provided with gap; the LED relevant components comprise an LED wafer, relevant circuits and relevant components. In the consideration of the production technology and cost of existing mature chips, the thin substrate whose shape is the same with that of light engine plate as substrate is utilized. The light engine module is supported by the light engine plate, so the thickness of which needs to meet a certain requirement, and the manufacturing cost is rather high because mature substrate materials are needed if utilizing the light engine plate as substrate directly; while if utilizing the thin substrate whose shape is the same with that of light engine plate as substrate and bond with the light engine plate in step 3, the cost can be reduced relatively because the thinner substrate can be chose and the light engine plate made up of common substrate materials plays the supporting role. But with the mass production of the light engine module, the cost of substrate materials will be reduced greatly, and then it will become normal utilizing the light engine plate as substrate directly.

The existing LED substrate materials can be utilized as substrate materials, while the GaN and other materials can be utilized for transitional epitaxial layer based on grown wafer. LED wafer cutting and other processing steps are not needed and light engine module can be used on liquid cooling light bulb in the present invention, so the requirements on material quality of substrate will be reduced greatly for the production of LED wafer, such as SiC substrate easy to be fracturing, SiC substrate with poor processing property, even the polycrystalline and high purity alumina material, and high purity silicon based material and others can access to the selection list of substrate materials.

The transparent material is used on the light engine plate, in this way, the lower emergent light of LED wafer can reflect the inner cover of the light bulb through light engine plate and the reflector of LED light bulb, and then the luminous efficiency of wafer can be improved greatly and the junction temperature of wafer can be reduced.

The specific manufacturing method of product A is putting the epitaxial wafer into a reacting furnace to undergo such process steps as silicon coating, sizing, photolithography, etching, film coating, alloying and slice grinding, the epitaxial wafer growing by layers to form an LED wafer at a specific position and relevant circuits; the LED wafer will not be cut after the completion of the growth; obtaining product A after the LED wafer passes inspection, and die bonding relevant components on product A (conducting wire bonding to connect LED wafer and relevant components).

The light bulb accessories mainly comprise a heat conducting support, a light distribution optical lens, a lens snap ring, an electric connector male, a flexible built-up circuit, a concave inner cover of the light bulb, an inner ring cover and an inner snap ring.

In the aforesaid LED illuminating lamp manufacturing method, the methods of covering LED relevant components by transparent sealant and /or transparent cover plate are as follows: filling in a little transparent sealant between LED relevant components to level, and forming the transparent sealant between the surface of LED wafer and the transparent cover plate as little as possible, then covering the transparent cover plate whose profile is the same with that of light engine plate on LED relevant components, besides, opening area is provided on transparent cover plate to show bonding pad; or filling in a little transparent sealant between LED relevant components to level, and covering the transparent cover plate whose profile is smaller than that of light engine plate on LED relevant components, then the transparent sealant is wrapped around the transparent cover plate to level the profile of transparent sealant with that of light engine plate, opening area is provided on transparent cover plate to show bonding pad; or the LED relevant components is wrapped up with the transparent sealant directly to level the profile of transparent sealant with that of light engine plate, opening area is provided on transparent cover plate to show the bonding pad.

Different materials are used for two different plans on the light engine plate, in the plan of thin substrate, the role of light engine plate is equivalent to that of transparent cover plate, the other non-metal heat conducting materials of different epitaxial wafer substrates can be used to support epitaxial wafer, the phosphor and protective layer can be coated on back side of epitaxial wafer. Or the light engine plate is molded transparent fluorophor. Transparent fluorophor is prepared by the fluorescent materials and transparent materials according to the weight ratio of 5~30:100. While in the plan of using light engine plate as substrate, the LED substrate material is used on the light engine plate.

In the aforesaid LED illuminating lamps manufacturing method, the small-sized light engine plate is circular plate, both sides of the circular plate are provided with two inner arc gaps symmetrically, the center of which is in the concentric circle outside of the circular plate; a circular hole is provided on the light engine plate for the connection with contact pin of electric connector, the bonding pad is located at the position of circular hole on LED relevant components, the contact pin of electric connector is soldered with the bonding pad after inserting into circular hole.

In the aforesaid LED illuminating lamp manufacturing method, the medium-sized light engine plate is circular plate, two bow shapes of the circle are removed symmetrically on both sides of the circular plate, forming two symmetrical gaps; wherein a circle hole with alignment pin is provided on the light engine plate, the circle hole is used for the alignment connection with the electric connector; wherein the bonding pad is disposed at the position of circle hole by LED relevant components through the flexible built-up circuit, wherein the electric connector is soldered with the bonding pad of the flexible built-up circuit after inserting into the circle hole.

In the aforesaid LED illuminating lamp manufacturing method, the relatively large-sized light engine plate is circular plate, characterized in that both sides of the circular plate are provided with two symmetrical gaps, each gap is formed by cutting a string along the circle of the circular plate, moreover, both ends of the string tilt outwards to 120 degrees, and transit to the circle of the circular plate by circular arc; wherein the bonding pad is located at the inner side of the gap of the circular plate, the bonding pad is disposed at the inner side of two gaps or concentrated at the inner side of one gap therein respectively.

In the aforesaid LED illuminating lamp manufacturing method, for the small-sized light engine plate, the circle diameter d_{G} of the circular plate is 11 mm or 16mm; when it is 11mm, the center of two circular arc gaps is in the circle whose diameter d_{G} is 13mm (the distance between two circle centers), the radius of two circular arc gaps is 3.2mm; when it is 16 mm, the center of two circular arc gaps is in the circle whose diameter is 19mm (the distance between two circle centers), the radius of two circular arc gaps is 3.6mm, there are four circle holes connected with the contact pin of the electric connector, and they are distributed symmetrically with an equal distance of 3.5mm, the center of four circle holes is located at a distance of 2mm with the center of the circular plate, moreover, the center of four circle holes is the same distance with the two gaps.

In the aforesaid LED illuminating lamp manufacturing method, for the medium-sized light engine plate, the circular plate is 18mm or 25mm; when it is 18mm, the string length of the removed two bow shapes is 8.2mm, and the distance between two strings is 16mm; when it is 25mm, the string length of the two removed bow shapes is 9.8mm, and the distance between two strings is 23mm; the center of which is located at a distance of 2mm with the center of the circular plate, and the center of circle hole is the same distance with the two gaps.

In the aforesaid LED illuminating lamp manufacturing method, for relatively large-sized light engine plate, the circle diameter d_{G} of the circular plate is 20mm, 38mm or 50mm; if the length between the gap subtract the outward tilting part of both sides, the length is 10mm, the radius of circular arc used for transition is 1 mm, the two corresponding strings of two gaps are parallel to each other; when the circle diameter d_{G} of the circular plate is 20mm, the distance between two strings is 15mm; when the circle diameter d_{G} of the circular plate is 38mm, the distance between two strings is 33mm; when the circle diameter d_{G} of the circular plate is 50mm, the distance between two strings is 45mm.

In the aforesaid LED illuminating lamp manufacturing method, the phosphor and protective layer are coated on the transparent cover plate and the light engine plate; or the light engine plate is molded transparent fluorophor. Transparent fluorophor is prepared by the fluorescent materials and transparent materials according to the weight ratio of 5~30:100.

In the aforesaid LED illuminating lamp manufacturing method, there are two fixed holes provided on the light engine plate for fixing, the two fixed holes are symmetric around the center of circular plate with a distance of dG-6, the diameter of fixed hole is 2.2mm; the link of two fixed holes is orthogonal with that of gaps center; when d_{G}=20mm, a fixed hole of one side need to be opened.

Another aspect of the present invention is to further provide a construction method of the light engine module of LED light bulb, comprising preparing the thin epitaxial wafer formed by the transitional epitaxial layer on the existing LED substrate, putting the epitaxial wafer into a reacting furnace to grow by layers to form an LED wafer and relevant circuits at a specific position, the LED wafer will not be cut after the completion of the growth; and die bonding relevant components after the LED wafer passes inspection (conducting die bonding to the wafer level driving power chip and other components if have and it also can be formed through direct growth in the reacting furnace), and then conducting wire bonding to connect LED wafer and relevant components (if necessary). The LED relevant components are formed by the LED wafer, relevant circuits and relevant components, the epitaxial wafer is bonded with the light engine plate, moreover, both sides of the epitaxial wafer and the light engine plate are provided with gap; or the second plan can be utilized, that is, putting the epitaxial wafer into a reacting furnace to grow by layers to form an LED wafer and relevant circuits at a specific position, the LED wafer will not be cut after the completion of the growth; and die bonding relevant components after the LED wafer passes inspection (conducting die bonding to the wafer level driving power chip and other components if have and it also can be formed through direct growth in the reacting furnace), and then conducting wire bonding connect LED wafer and relevant components (if necessary). LED relevant components are formed by the LED wafer, relevant circuits and relevant components; the transparent sealant and/or the transparent cover plate are used to cover the LED relevant components, and only the correlated bonding pad of the LED relevant components is shown. The existing LED substrate materials can be utilized as substrate materials, while transitional epitaxial layer can choose The GaN and other materials can be utilized for transitional epitaxial layer based on grown wafer. LED wafer cutting and other processing steps are not needed and light engine module can be used on liquid cooling light bulb in the present invention, so the requirements on material quality of substrate will be reduced greatly for the production of LED wafer, such as SiC substrate which is easy to be fracturing, SiC substrate with poor processing property, even the polycrystalline and high purity alumina material, and high purity silicon based material and others can access to the selection list of light engine plate materials in the second plan (or the substrate of epitaxial wafer in the first plan).

In the aforesaid LED light bulb light engine module, the methods of covering LED relevant components by transparent sealant and/or transparent cover plate are as follows: filling in a little transparent sealant between LED relevant components to level, and forming the transparent sealant between the surface of LED wafer and the transparent cover plate as little as possible, then covering the transparent cover plate whose profile is the same with that of light engine plate on LED relevant components, besides, opening area is provided on transparent cover plate to show bonding pad; or filling in a little transparent sealant between LED relevant components to level, and covering the transparent cover plate whose profile is smaller than that of light engine plate on LED relevant components, then the transparent sealant is wrapped around the transparent cover plate to level the profile of transparent sealant with that of light engine plate, opening area is provided on transparent cover plate to show bonding pad; or the LED relevant components is wrapped up with the transparent sealant to level the profile of transparent sealant with that of light engine plate, opening area is provided on transparent cover plate to show bonding pad

The transparent material is used on the light engine plate, in this way, the lower LED emergent light of LED wafer can reflect inner cover of the light bulb through transparent light engine plate and the reflector of LED light bulb, and then the luminous efficiency of LED wafer can be improved greatly and the junction temperature of LED wafer can be reduced.

Different materials are used for two different plans on the light engine plate, in the first plan, the role of light engine plate is equivalent to that of transparent cover plate, the other non-metal heat conducting materials of different epitaxial wafer substrates can be used to support epitaxial wafer, the phosphor and protective layer can be coated on back side of epitaxial wafer. Or the light engine plate is molded transparent fluorophor. Transparent fluorophor is prepared by the fluorescent materials and transparent materials according to the weight ratio of 5~30:100. While in the second plan, LED substrate material is used on light engine plate.

In the aforesaid LED light bulb light engine module, the small-sized light engine plate is circular plate, both sides of the circular plate are provided with two inner arc gaps symmetrically, the center of which is in the concentric circle outside of the circular plate; circular hole is provided on the light engine plate for the connection with contact pin of electric connector, the bonding pad is located at the position of circular hole on LED relevant components, the contact pin of electric connector is soldered with the bonding pad after inserting into the circle hole.

In the aforesaid light engine plate of LED light bulb, the medium-sized light engine plate is circular plate, two bow shapes of the circle are removed symmetrically on both sides of the circular plate, forming two symmetrical gaps; wherein a circle hole with alignment pin is provided on the light engine plate, the circle hole is used for the alignment connection with the electric connector; wherein the bonding pad is disposed at the position of circle hole by LED relevant components through the flexible built-up circuit, wherein the electric connector is soldered with the bonding pad of the flexible built-up circuit after inserting into the circle hole.

In the aforesaid light engine plate of LED light bulb, the relatively large-sized light engine plate is circular plate, characterized in that both sides of the circular plate is provided with two symmetrical gaps, each gap is formed by cutting a string along the circle of the circular plate, moreover, both ends of the string tilt outwards to 120 degrees, and transit to the circle of the circular plate by circular arc; wherein the bonding pad is located at the inner side of the gap of the circular plate, the bonding pad is disposed at the inner side of two gaps or concentrated at the inner side of one gap therein respectively.

In the aforesaid light engine plate of LED light bulb, for the small-sized light engine plate, the circle diameter d_{G} of the circular plate is 11 mm or 16mm; when it is 11 mm, the center of two circular arc gaps is in the circle whose diameter d_{G} is 13mm (the distance between two circle centers), the radius of two circular arc gaps is 3. 2mm; when it is 16 mm, the center of two circular arc gaps is in the circle whose diameter is 19mm (the distance between two circle centers), the radius of two circular arc gaps is 3.6mm, there are four circle holes connected with the contact pin of the electric connector (11), and they are distributed symmetrically with an equal distance of 3.5mm, the center of four circle holes is located at a distance of 2mm with the center of the circular plate, moreover, the center of four circle holes is the same distance with the two gaps.

In the aforesaid light engine plate of LED light bulb, for the medium-sized light engine plate, the circular plate is 18mm or 25mm; when it is 18mm, the string length of the two removed bow shapes is 8.2mm, and the distance between two strings is 16mm; when it is 25mm, the string length of the cut two bow shapes is 9.8mm, and the distance between two strings is 23mm; the center of which is located at a distance of 2mm with the center of the circular plate, and the center of circle hole is the same distance with the two gaps.

In the aforesaid light engine plate of LED light bulb, for relatively large-sized light engine plate, the circle diameter d_{G} of the circular plate is 20mm, 38mm or 50mm; if the length between the gap subtract the outward tilting part of both sides, the length is 10mm, the radius of circular arc used for transition is 1 mm; the two corresponding strings of two gaps are parallel to each other; when the circle diameter of the circular plate is 20mm, the distance between two strings is 15mm; when the circle diameter d_{G} of the circular plate is 38mm, the distance between two strings is 33mm; when the circle diameter d_{G} of the circular plate is 50mm, the distance two strings is 45mm;

In the aforesaid light engine module of LED light bulb, the phosphor and protective layer are coated on the transparent cover plate and /or the light engine plate; or the transparent cover plate and /or the light engine plate (43) are molded transparent fluorophor. Transparent fluorophor is prepared by the fluorescent materials and transparent materials according to the weight ratio of 5-30:100.

In the aforesaid light engine plate of LED light bulb, there are two fixed holes provided on the light engine plate for fixing, the two fixed holes are symmetric around the center of the circular plate with a distance of dG-6, the diameter of fixed hole is 2.2mm, the link of two fixed holes is orthogonal with that of gaps center; when d_{G} =20mm, a fixed hole of one side need to be opened.

Another aspect of the present invention is to further provide a liquid-cooling method of small-sized LED light bulb, comprising light engine core members and periphery members of LED light bulb, wherein the light engine core members of light bulb comprise a heat conduction support, passing through the heat conduction support, the electric connector is bonded on the heat conduction support, the contact pin on the top end of the electric connector is soldered with the bonding pad on a light engine module after aligning the position and inserting from four holes of the backside of the light engine module, moreover, the inner cover is provided around a periphery of the light engine module, the inner cover is bonded in the inserting recess of the heat conduction support, a confined space is formed between the heat conduction support and the light engine module, and the confined space is filled with transparent insulated heat conduction, the light engine module is immersed into the transparent insulated heat conduction fluid, the reflector is provided on the surface of the covered part of the heat conduction supported by the inner cover; the upper emergent light on the light engine module reflect toward downward and side by the reflector, in this way, the LED light can emit through the inner cover and the luminous efficiency will be increased; wherein the pressure relief hole is provided on the inner cover, the pressure relief hole is covered with the pressure relief membrane, the transparent insulated heat conduction fluid is injected through the pressure relief hole; when the temperature of the inner cover is anormal, the fluid will break through the pressure relief membrane and leak out of the pressure relief hole, preventing the expansion of accident.

In the aforesaid liquid-cooling method of small-sized LED light bulb, the light engine module comprises an light engine plate; wherein the light engine plate is preparing the thin epitaxial wafer formed by the transitional epitaxial layer on the existing LED substrate putting the epitaxial wafer into reacting furnace to grow by layers to form an LED wafer and relevant circuits, the LED wafer will not be cut after the completion of the growth; and die bonding relevant components after the LED wafer passes inspection (conducting die bonding to the wafer level driving chip and other components if have and it can be formed through direct growth in the reacting furnace), and then conducting wire bonding to connect LED wafer and relevant components (if necessary). The LED relevant components are formed by the LED wafer, relevant circuits and relevant components, the epitaxial wafer is bonded with the light engine plate, moreover both sides of the epitaxial wafer and the light engine plate are provided with gaps; or preparing the transitional epitaxial layer on the light engine plate, putting the epitaxial wafer into a reacting furnace to grow by layers to form an LED wafer and relevant circuits; and die bonding relevant components, the LED wafer passes inspection (conducting die bonding to the wafer level driving power chip and other components if have and it can be formed through direct growth in the reacting furnace)and then conducting wire bonding to connect the LED wafer and relevant components (if necessary). The LED relevant components are formed by the LED wafer, relevant circuits and relevant components; or the light engine plate is transparent material substrate, utilizing the existing wafer, fitting, printing, die bonding, wire bonding and other technologies to realize LED wafer, relevant circuits and relevant components on the light engine plate. Wherein the LED relevant components are formed by the LED wafer, relevant circuits and relevant components; the transparent sealant and/or the transparent cover plate are used to cover the LED relevant components, and only the correlated bonding pad of the LED relevant components is shown.

In the aforesaid liquid-cooling method of small LED light bulb, the periphery members of the light bulb are divided into three types:
The first type: the lens snap ring is provided on the heat conduction support, the edge of the heat conduction support is wrapped up with the lens snap ring, six uniformly distributed flange holes are provided on the edge of the heat conduction support as fixed holes of light bulb, the corresponding fixed holes of light bulb are also provided on the lens snap ring, the fixed screw is provided in the fixed hole of the light bulb to fix the light bulb, forming a basic support structure for light bulb; the lens is provided at the bottom of the lens snap ring, and the lens is connected with the inner cover through bonding; the heat conduction pad is provided on the surface of the heat conduction support.
The second type: six uniformly distributed flange holes are provided on the heat conduction support as fixed holes of light bulb, the light bulb is fixed by the fixed screw, thereby forming a basic support structure of light bulb; the heat conduction pad is provided on the surface of the heat conduction support; wherein the bottom of the inner cover is bonded with the lens; the lens snap ring is provided around a periphery of the inner cover, in this way, the lens will be got stuck.
The third type: the heat conduction support is fixed on the inner cover by bonding, forming a basic support structure of light bulb; the heat conduction pad is provided on the surface of the heat conduction support; wherein the bottom of the inner cover is bonded with the lens; the lens snap ring is provided around a periphery of the inner cover, in this way, the lens will be got stuck, and the lens snap is connected with the periphery of the inner cover and the heat conduction support ring by bonding, six uniformly distributed flange holes are provided on the heat conduction support as fixed holes of light bulb, the light bulb is fixed by the fixed screw of light bulb.

In the aforementioned liquid-cooling method of small-sized LED light bulb, the methods of covering LED relevant components by transparent sealant and/or transparent cover plate are as follows: filling in a little transparent sealant between LED relevant components to level, and forming the transparent sealant between the surface of LED wafer and the transparent cover plate as little as possible, then covering the transparent cover plate whose profile is the same with that of light engine plate on LED relevant components, besides, opening area is provided on transparent cover plate to show bonding pad; or filling in a little transparent sealant between LED relevant components to level, and covering the transparent cover plate whose profile is smaller than that of light engine plate on LED relevant components, then the transparent sealant is wrapped around the transparent cover plate to level the profile of transparent sealant with that of light engine plate, opening area is provided on transparent cover plate to show bonding pad; or the LED relevant components is wrapped up with the transparent sealant directly to level the profile of transparent sealant with that of light engine plate, opening area is provided on transparent cover plate to show the bonding pad.

The light engine plate is circular plate, both sides of the circular plate are provided with two inner arc gaps symmetrically, the center of which is in the concentric circle outside of the circular plate; a circle hole is provided on the light engine plate for the connection with contact pin of electric connector, the bonding pad is located at the position of circular hole on LED relevant components, the contact pin of electric connector is soldered with the bonding pad through insertion into circular hole.

In the aforesaid liquid-cooling method of small-sized LED light bulb, the circle diameter d_{G} of the circular plate is 11 mm or 16mm; when it is 11 mm, the center of two circular arc gaps is in the circle whose diameter d_{G} is 13mm (the distance between two circle centers), the radius of two circular arc gaps is 3.2mm; when it is 16 mm, the center of two circular arc gaps is in the circle whose diameter is 19mm (the distance between two circle centers), the radius of two circular arc gaps is 3.6mm, there are four circle holes connected with the contact pin of the electric connector, and they are distributed symmetrically with an equal distance of 3.5mm, the center of four circle holes is located at a distance of 2mm with the center of the circular plate, moreover, the center of four circle holes is the same distance with the two gaps.

In the aforesaid liquid-cooling method of small-sized LED light bulb, the lens can be replaced by the outer cover, if the outer cover is used in the light bulb, the outer cover need to be bonding disposed around a periphery of the inner cover or the lens snap ring.

In the aforesaid liquid-cooling method of small-sized LED light bulb, the phosphor and protective layer are coated on the transparent cover plate, or the transparent cover plate is molded transparent fluorophor. Transparent fluorophor is prepared by the fluorescent materials and transparent materials according to the weight ratio of 5~30:100.

In the aforesaid liquid-cooling method of small-sized LED light bulb, the concave part can be protruded to the outside to increase the volume to accommodate the inflated volume of the transparent insulated heat conduction fluid, preventing the failure of the cover sealing due to the swelling of transparent insulated heat conduction fluid; the phosphor and protective layer are coated on the surface of the inner cover; or the inner cover is molded transparent fluorophor. Transparent fluorophor is prepared by the fluorescent materials and transparent materials according to the weight ratio of 5~30:100.

Another aspect of the present invention is to further provide a liquid-cooling method of medium-sized LED light bulb, characterized in that it comprises light engine core members and periphery members of LED light bulb, wherein the light core members of light bulb comprise a heat conduction support, the heat conduction support is passed through the heat conduction support, the center hole of the light engine module is inserted by the electric connector exactly, and the electric connector is soldered with the contact pin of the electric connector by the flexible built-up circuit; moreover, the inner cover is provided around a periphery of the light engine plate, the inner cover is bonded the inserting recess of the heat conduction support, a confined space is formed between the heat conduction support and the light engine module, and the confined space is filled with transparent insulated heat conduction, the light engine module is immersed into the transparent insulated heat conduction fluid, the reflector is provided on the surface of the covered part of the heat conduction supported by the inner cover; the upper emergent light on the light engine module reflect toward downward and side by the reflector, in this way, the LED light can emit through the inner cover and the luminous efficiency will be increased; wherein the pressure relief is provided on the inner cover, the pressure relief hole is covered with the pressure relief membrane, the transparent insulated heat conduction fluid is injected through the pressure relief hole; when the temperature of the inner cover is anormal, the fluid will break through the pressure relief membrane and leak out of the pressure relief hole, preventing the expansion of accident.

In the aforesaid liquid-cooling method of medium-sized LED light bulb, the light engine module comprises the light engine plate; wherein the light engine plate is preparing the thin epitaxial wafer formed by the transitional epitaxial layer on the existing LED substrate putting the epitaxial wafer into reacting furnace to grow by layers to form an LED wafer and relevant circuits, the LED wafer will not be cut after the completion of the growth; and die bonding relevant components after the LED wafer passes inspection (conducting die bonding to the wafer level driving chip and other components if have and it can be formed through direct growth in the reacting furnace), and then conducting wire bonding connect LED wafer and relevant components (if necessary). The LED relevant components are formed by the LED wafer, relevant circuits and relevant components, the epitaxial wafer is bonded with the light engine plate, moreover both sides of the epitaxial wafer and the light engine plate are provided with gap; or preparing the transitional epitaxial layer on the light engine plate, putting the epitaxial wafer into a reacting furnace to grow by layers to form an LED wafer and relevant circuits; and die bonding relevant components the LED wafer passes inspection (conducting die bonding to the wafer level driving power chip and other components if have and it can be formed through direct growth in the reacting furnace)and then conducting wire bonding connect LED wafer and relevant components (if necessary). The LED relevant components are formed by the LED wafer, relevant circuits and relevant components; or the light engine plate is transparent material substrate, Wherein the LED relevant components are formed by the LED wafer, relevant circuits and relevant components; the transparent sealant and/or the transparent cover plate are used to cover the LED relevant components, and only the correlated bonding pad of the LED relevant components is shown.

In the aforesaid liquid-cooling method of medium-sized LED light bulb, the periphery members of the light bulb are divided into five types:
The first type: six uniformly distributed flange holes are provided on the heat conduction support as fixed holes of light bulb, the light bulb is fixed by the fixed screw of light bulb , the support bushing is riveted to the below of the heat conduction support, the basic support structure of light bulb is formed by the heat conduction support and the support bushing; the heat conduction pad is provided on the heat conduction support; the lens is bonded with the below of the support bushing, a confined space is formed between the heat conduction support, the support bushing and the lens (the heat conduction support and the lens are the top and bottom surfaces and the support bushing is the side), the confined space is provided with the light engine plate and the inner cover, passing through the heat conduction support, the electric connector is fixed on the heat conduction support through the fixed end, and the electric connector is connected with the light engine module through the flexible built-up circuit; the inner cover is provided around a periphery of the light engine module; the lens snap ring is provided around a periphery of the support bushing, in this way, the lens will be got stuck, the lens snap ring is fixed on the support bushing through the fixed screw, preventing lens accidental detachment.
The second type: the lens snap ring is provided on the lens snap ring, the edge of the heat conduction support is wrapped up with the lens snap ring, six uniformly distributed flange holes are provided on the edge of the heat conduction support as fixed holes of light bulb, the corresponding fixed holes of light bulb are also provided on the lens snap ring, the fixed screw is provided in the fixed hole of the light bulb to fix the light bulb, and the inner snap ring is provided below the heat conduction support (the inner snap ring is connected with the heat conduction support by bonding and fixing screw), a basic support structure of light bulb is formed by the lens snap ring, the heat conduction support and the inner snap ring; the heat conduction pad is provided on the heat conduction support; the lens is connected with the inner snap ring by bonding, the lens can be got stuck by the lens snap ring; a confined space is formed between the heat conduction support, the inner snap ring and the lens (the heat conduction support and the lens are the top and bottom surfaces and the support bushing is the side), the inner cover and the light engine module is fixed therein; passing through the heat conduction support, the electric connector is fixed on the heat conduction support by the fixed end, and the electric connector is connected with the light engine module through the flexible built-up circuit;
The third type: six uniformly distributed flange holes are provided on the heat conduction support as fixed holes of light bulb, the light bulb is fixed by the fixed screw of light bulb, the inner snap ring is connected with the below of the heat conduction support by bonding and fixing the screw, thereby forming the basic support structure of light bulb; the heat conduction pad is provided on the heat conduction support; the lens is bonded with the inner snap ring by bonding, a confined space is formed between the heat conduction support, the support bushing and the lens (the heat conduction support and the lens are the top and bottom surfaces and the support bushing is the side),the inner cover and the light engine module are fixed therein, passing through the heat conduction support, the electric connector is fixed on the heat conduction support through the fixed end, and the electric connector is connected with the light engine module through the flexible built-up circuit; the lens snap ring is provided around a periphery of the inner snap ring, in this way, the lens will be got stuck, the lens snap ring is fixed on the support bushing through the fixed screw, preventing lens accidental detachment.
The fourth type: the heat conduction support is fixed on the inner snap ring by bonding; the lens snap ring is connected with the inner snap ring by bonding, thereby forming the basic support structure of light bulb; the heat conduction pad is provided on the heat conduction support; the lens is bonded with the inner snap ring by bonding, a confined space is formed between the heat conduction support, the inner snap ring and the lens (the heat conduction support and the lens are the top and bottom surfaces and the inner snap ring is the side),the inner cover and the light engine module are fixed therein, passing through the heat conduction support, the electric connector is fixed on the heat conduction support through the fixed end, and the electric connector is connected with the light engine module through the flexible built-up circuit; the lens snap ring is provided around a periphery of the inner snap ring, in this way, the lens will be got stuck, the lens snap ring is connected with the inner snap ring by bonding, six uniformly distributed flange holes are disposed on the lens snap ring as the fixed holes of light bulb, the light bulb is fixed through the fixed screw of light bulb.
The fifth type: the heat conduction support is fixed in the lens by bonding, thereby forming the basic support structure of light bulb. the heat conduction pad is provided on the heat conduction support; a confined space is formed between the heat conduction support and the lens, the light engine module are fixed therein, passing through the heat conduction support, the electric connector is fixed on the heat conduction support through the fixed end, and the electric connector is connected with the light engine module through the flexible built-up circuit; the lens snap ring is provided around a periphery of the lens, in this way, the lens will be got stuck, the lens snap ring is connected with the lens by bonding, six uniformly distributed flange holes are disposed on the lens snap ring as the fixed holes of light bulb, the light bulb is fixed through the fixed screw of light bulb.

In the aforementioned liquid-cooling method of medium-sized LED light bulb, the methods of covering LED relevant components by transparent sealant and/or transparent cover plate are as follows: filling in a little transparent sealant between LED relevant components to level, and forming the transparent sealant between the surface of LED wafer and the transparent cover plate as little as possible, then covering the transparent cover plate whose profile is the same with that of light engine plate on LED relevant components, besides, opening area is provided on transparent cover plate to show bonding pad; or filling in a little transparent sealant between LED relevant components to level, and covering the transparent cover plate whose profile is smaller than that of light engine plate on LED relevant components, then the transparent sealant is wrapped around the transparent cover plate to level the profile of transparent sealant with that of light engine plate, opening area is provided on transparent cover plate to show bonding pad; or the LED relevant components is wrapped up with the transparent sealant directly to level the profile of transparent sealant with that of light engine plate, opening area is provided on transparent cover plate to show the bonding pad

In the aforesaid liquid-cooling method of medium-sized LED light bulb, the light engine plate is circular plate, two bow shapes of the circle are removed symmetrically on both sides of the circular plate, forming two symmetrical gaps; wherein the circle hole with alignment pin is provided on the light engine plate, the circle hole is used for the alignment connection with the electric connector; wherein the bonding pad is disposed at the position of circle hole by LED relevant components through the flexible built-up circuit, wherein the electric connector is soldered with the bonding pad of the flexible built-up circuit after inserting into the circle hole.

In the aforesaid liquid-cooling method of medium-sized LED light bulb, the circle diameter of the circular plate is 18mm or 25mm; when it is 18mm, the string length of the removed two bow shapes is 8.2mm , and the distance between two strings is 16mm; when it is 25mm, the string length of the removed two bow shapes is 9.8mm, and the distance between two strings is 23mm; the center of which is located at a distance of 2mm with the center of the circular plate, and the center of circle hole is the same distance with the two gaps.

In the aforesaid liquid-cooling method of medium-sized LED light bulb, the lens can be replaced by the outer cover, if the outer cover is used in the light bulb, the outer cover need to be bonding disposed around a periphery of the inner cover or the lens snap ring, or the lens can be replaced by the outer cover with lens-type interface directly.

In the aforesaid liquid-cooling method of medium-sized LED light bulb, the phosphor and protective layer are coated on the transparent cover plate, or the transparent cover plate is molded transparent fluorophor. Transparent fluorophor is prepared by the fluorescent materials and transparent materials according to the weight ratio of 5-30:100.

In the aforesaid liquid-cooling method of medium-sized LED light bulb, the concave part can be protruded to the outside to increase the volume to accommodate the inflated volume of the transparent insulated conduction fluid, preventing the failure of the sealing due to the swelling of transparent insulated heat conduction fluid; the phosphor and protective layer are coated on the surface of the cover; or the cover is molded transparent fluorophor. Transparent fluorophor is prepared by the fluorescent materials and transparent materials according to the weight ratio of 5-30:100.

Another aspect of the present invention is to further provide a liquid-cooling method of large-sized LED light bulb, characterized in that it comprises light engine core members and periphery members of LED light bulb. The core members of LED light bulb comprise a heat conduction support, the inner cover is provided below the heat conduction support, the inner cover is bonded in the inserting recess of the heat conduction support, a confined space is formed between the heat conduction support and the inner cover, and the confined space is filled with transparent insulated heat conduction, wherein the light engine module is provided on the inner cover, steps are provided in the inner cover to support the light engine module, the light engine module is immersed into the transparent insulated heat conduction fluid; the light engine module is soldered with the contact pin of the electric connector around a periphery of the inner cover by flexible built-up circuit, passing through the heat conduction support, the electric connector is fixed on the heat conduction heat by the fixed end; the reflector is provided on the surface of the covered part of the heat conduction supported by the inner cover; the upper emergent light on the light engine module reflect toward downward and side by the reflector, in this way, the LED light can emit through the inner cover and the luminous efficiency will be increased; wherein the pressure relief is provided on the inner cover, the pressure relief hole is covered with the pressure relief membrane, the transparent insulated heat conduction fluid is injected the pressure relief hole ; when the temperature of the inner cover is anormal, the fluid will break through the pressure relief membrane and leak out of the pressure relief hole, preventing the expansion of accident

In the aforesaid liquid-cooling method of large-sized LED light bulb, the light engine module comprises the light engine plate; wherein the light engine plate is preparing the thin epitaxial wafer formed by the transitional epitaxial layer on the existing LED substrate putting the epitaxial wafer into reacting furnace to grow by layers to form an LED wafer and relevant circuits, the LED wafer will not be cut after the completion of the growth; and die bonding relevant components after the LED wafer passes inspection (conducting die bonding to the wafer level driving chip and other components if have and it can be formed through direct growth in the reacting furnace), and then conducting wire bonding connect LED wafer and relevant components (if necessary). The LED relevant components are formed by the LED wafer, relevant circuits and relevant components, the epitaxial wafer is bonded with the light engine plate, moreover both sides of the epitaxial wafer and the light engine plate are provided with gap; or preparing the transitional epitaxial layer on the light engine plate, putting the epitaxial wafer into a reacting furnace to grow by layers to form an LED wafer and relevant circuits; and die bonding relevant components the LED wafer passes inspection (conducting die bonding to the wafer level driving power chip and other components if have and it can be formed through direct growth in the reacting furnace)and then conducting wire bonding connect LED wafer and relevant components (if necessary). The LED relevant components are formed by the LED wafer, relevant circuits and relevant components; or the light engine plate is transparent material substrate, wherein the LED relevant components are formed by the LED wafer, relevant circuits and relevant components; the transparent sealant and/or the transparent cover plate are used to cover the LED relevant components, and only the correlated bonding pad of the LED relevant components is shown.

In the aforesaid liquid-cooling method of large-sized LED light bulb, the periphery members of the light bulb are divided into five types:
The first type: six uniformly distributed flange holes are provided on the heat conduction support as fixed holes of light bulb, the light bulb is fixed by the fixed screw of light bulb, the support bushing is riveted to the below of the heat conduction support, the basic support structure of light bulb is formed by the heat conduction support and the support bushing; the heat conduction pad is provided on the heat conduction support; the lens is bonded with the below of the support bushing, a confined space is formed between the heat conduction support, the support bushing and the lens (the heat conduction support and the lens are the top and bottom surfaces and the support bushing is the side), the confined space is provided with the light engine plate and the inner cover, passing through the heat conduction support, the electric connector is fixed on the heat conduction support through the fixed end, and the electric connector is connected with the light engine module through the flexible built-up circuit; the inner cover is provided around a periphery of the light engine module; the lens snap ring is provided around a periphery of the support bushing, in this way, the lens will be got stuck, the lens snap ring is fixed on the support bushing through the fixed screw, preventing lens accidental detachment.
The second type: the lens snap ring is provided on the lens snap ring, the edge of the heat conduction support is wrapped up with the lens snap ring, six uniformly distributed flange holes are provided on the edge of the heat conduction support as fixed holes of light bulb, the corresponding fixed holes of light bulb are also provided on the lens snap ring, the fixed screw is provided in the fixed hole of the light bulb to fix the light bulb, and the inner snap ring is provided below the heat conduction support (the inner snap ring is connected with the heat conduction support by bonding and fixing screw), a basic support structure of light bulb is formed by the lens snap ring, the heat conduction support and the inner snap ring; the heat conduction pad is provided on the heat conduction support; the is connected with the inner snap ring by bonding, the can be got stuck by the lens snap ring; a confined space is formed between the heat conduction support, the inner snap ring and the lens (the heat conduction support and the lens are the top and bottom surfaces and the support bushing is the side), the inner cover and the light engine module is fixed therein; passing through the heat conduction support, the electric connector is fixed on the heat conduction support by the fixed end, and the electric connector is connected with the light engine module through the flexible built-up circuit;
The third type: six uniformly distributed flange holes are provided on the heat conduction support as fixed holes of light bulb, the light bulb is fixed by the fixed screw of light bulb, the inner snap ring is connected with the below of the heat conduction support by bonding and fixing the screw, thereby forming the basic support structure of light bulb; the heat conduction pad is provided on the heat conduction support; the lens is bonded with the inner snap ring by bonding, a confined space is formed between the heat conduction support, the support bushing and the lens (the heat conduction support and the lens are the top and bottom surfaces and the support bushing is the side), the inner cover and the light engine module are fixed therein, passing through the heat conduction support, the electric connector is fixed on the heat conduction support through the fixed end, and the electric connector is connected with the light engine module through the flexible built-up circuit; the lens snap ring is provided around a periphery of the inner snap ring, in this way, the lens will be got stuck, the lens snap ring is fixed on the support bushing through the fixed screw, preventing lens accidental detachment.
The fourth type: the heat conduction support is fixed on the inner snap ring by bonding, the lens snap ring is connected with the inner snap ring by bonding, thereby forming the basic support structure of light bulb. the heat conduction pad is provided on the heat conduction support; the lens is bonded with the inner snap ring by bonding, a confined space is formed between the heat conduction support, the inner snap ring and the lens (the heat conduction support and the lens are the top and bottom surfaces and the inner snap ring is the side), the inner cover and the light engine module are fixed therein, passing through the heat conduction support, the electric connector is fixed on the heat conduction support through the fixed end, and the electric connector is connected with the light engine module through the flexible built-up circuit; the lens snap ring is provided around a periphery of the inner snap ring, in this way, the lens will be got stuck, the lens snap ring is connected with the inner snap ring by bonding, six uniformly distributed flange holes are disposed on the lens snap ring as the fixed holes of light bulb, the light bulb is fixed through the fixed screw of light bulb.
The fifth type: the heat conduction support is fixed in the lens by bonding, thereby forming the basic support structure of light bulb. the heat conduction pad is provided on the heat conduction support; a confined space is formed between the heat conduction support and the lens, the light engine module are fixed therein, passing through the heat conduction support, the electric connector is fixed on the heat conduction support through the fixed end, and the electric connector is connected with the light engine module through the flexible built-up circuit; the lens snap ring is provided around a periphery of the lens, in this way, the lens will be got stuck, the lens snap ring is connected with the lens by bonding, six uniformly distributed flange holes are disposed on the lens snap ring as the fixed holes of light bulb, the light bulb is fixed through the fixed screw of light bulb.

In the aforementioned liquid-cooling method of large-sized LED light bulb manufacturing, the methods of covering LED relevant components by transparent sealant and/or transparent cover plate are as follows: filling in a little transparent sealant between LED relevant components to level, and forming the transparent sealant between the surface of LED wafer and the transparent cover plate as little as possible, then covering the transparent cover plate whose profile is the same with that of light engine plate on LED relevant components, besides, opening area is provided on transparent cover plate to show bonding pad; or filling in a little transparent sealant between LED relevant components to level, and covering the transparent cover plate whose profile is smaller than that of light engine plate on LED relevant components, then the transparent sealant is wrapped around the transparent cover plate to level the profile of transparent sealant with that of light engine plate, opening area is provided on transparent cover plate to show bonding pad; or the LED relevant components is wrapped up with the transparent sealant directly to level the profile of transparent sealant with that of light engine plate, opening area is provided on transparent cover plate to show the bonding pad.

In the aforesaid liquid-cooling method of large-sized LED bulb, the light engine plate is circular plate, both sides of the circular plate are provided with two symmetrical gaps, each gap is formed by cutting a string along the circle the circular plate, moreover, both ends of the string tilt outwards to 120 degrees, and transit to the circle of the circular plate by circular arc; wherein the bonding pad is located the inner side of the gap of the circular plate, the bonding pad is disposed at the inner side of two gaps or concentrated at the inner side of one gap therein respectively.

In the aforesaid liquid-cooling method of large-sized LED bulb, the circle diameter d_{G} the circular plate is 20mm 38mm or 50mm; if the length between the gap subtract the outward tilting part, the length is 10mm, the radius of circular arc used for transition is 1 mm the two corresponding strings of two gaps are parallel to each other; when the circle diameter d_{G} of the circular plate is 20mm, the distance between two strings is 15mm; when the circle diameter d_{G} of the circular plate is 38mm, the distance between two strings is 33mm when the circle diameter d_{G} of the circular plate is 50mm the distance two strings is 45mm;There are two fixed holes provided on the light engine plate for fixing, the two fixed holes are symmetric around the center of circular plate with a distance of d_{G} -6, the diameter of fixed hole is 2.2mm; the link of two fixed holes is orthogonal with that of gaps center; when d_{G} =20mm, a fixed hole of one side need to be opened.

In the aforesaid liquid-cooling method of large-sized LED light bulb, the lens can be replaced by the outer cover, if the outer cover is used in the light bulb, the outer cover need to be bonding disposed around a periphery of the inner cover or the lens snap ring, or the lens can be replaced by the outer cover with lens-type interface directly.

In the aforesaid liquid-cooling method of large-sized LED light bulb, the inner ring cover is provided around a periphery of the inner cover, when utilizing the small driving power, the driving power can be disposed in the inner cover with annular shape, the orientation of the light engine module input end does a 180-degree rotation from +X to -X. The shape of the flexible built-up circuit has also been changed, the A-type flexible built-up circuit will be connected with the annular driving power and the electric connector; the inner cover has a function of beautification by covering the fixed end of the electric connector and components of the annular driving power.

In the aforesaid liquid-cooling method of large-sized LED light bulb, the phosphor and protective layer are coated on the transparent cover plate, or the transparent cover plate is molded transparent fluorophor. Transparent fluorophor is prepared by the fluorescent materials and transparent materials according to the weight ratio of 5~30:100.

In the aforesaid liquid-cooling method of large-sized LED light bulb, the concave part can be protruded to the outside to increase the volume to accommodate the inflated volume of the transparent insulated heat conduction fluid, preventing the failure of the cover sealing due to the swelling of transparent insulated heat conduction fluid; the phosphor and protective layer are coated on the surface of the inner cover; or the inner cover is molded transparent fluorophor. Transparent fluorophor is prepared by the fluorescent materials and transparent materials according to the weight ratio of 5~30:100.

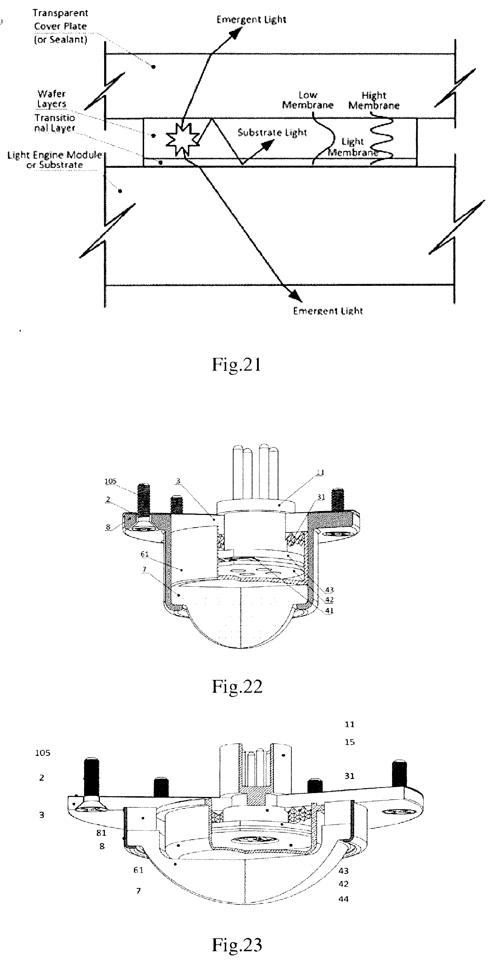

Compared with the existing technologies, the existing LED lighting industry continues the thinking model of the traditional semi-conductor industry, that is, only the chip shape can meet various requirements of integral LED illuminating lamp, so the chip becomes the center of LED lighting industry, the wafer substrate material, the epitaxial wafer and other relevant industries will be formed by upward stretch, and wafer packaging, driving power, lamp manufacturing, lamp accessories and other relevant industries will be formed by downward stretch, but there exists a lots of drawbacks from the analysis of industry structure. Firstly, based on wafer growth and cutting, there is extremely high demand to the substrate material of wafer, at present, only several materials with high demand to manufacturing technique can meet the demand, such as the single crystal alumina; secondly, processes such as substrate and epitaxial wafer, wafer growth, cutting, screening, packaging to assembling lamp, driving power, automated control are scattered and lengthy, which results in the problem of labor-consuming and time-consuming; thirdly, the universality and interchangeability of existing integral LED illuminating lamp are poor, the users are scattered in the process of manufacturing and it is not very intensive. based on the aforesaid plan, the light bulb of the present invention covers the light requirements of a majority of luminous environment, the technical proposal of the present invention is to centralize all light engine module of LED light bulb on three types, that is, seven specific products, the specification of the light engine module is few, so the upper and middle enterprises adjust the development and manufacturing center to the light engine module with limited specification, thereby organizing large-scale and intensive manufacturing. The LED wafer and relevant circuits are formed by the epitaxial wafer growth directly, that is, the LED wafer processing enterprises can obtain the light engine module, the core member used to LED light bulb manufacturing directly without cutting and other processes after the LED wafer and relevant circuits are formed directly on the epitaxial wafer or the light engine plate, all need to do is simple soldering and pasting, then the LED light bulb can be obtained by simple assembling. The center of LED lighting system is not transferred to the wafer but light bulb, which is easy to solve the problem of universality and interchangeability existed in integral LED illuminating lamp at present, moreover, it weakens in essence and local eliminates foreign patent barrier, and provides a good development space for Chinese LED lighting industry; besides, the industry framework centered on light bulb is of simple lamp structure, low technical content, so traditional lamp manufacturer can transfer to manufacture LED lamp immediately, which has positive significance in reducing the LED lighting cost. As for other specific technical effects, in the present invention, the LED relevant components are sealed between the transparent light engine plate and the transparent cover plate, LED wafer is close to the transparent cover plate, transparent sealant is less and the phosphor is disposed outside the transparent cover plate to keep away from the LED wafer, in this way, phosphor and transparent cover plate are not easy to be aging, which has great significance for ensuring stable and highly efficient operation of LED light bulb; besides, refer to Fig. 21 and Fig.22, the lower emergent light of wafer can reflect the inner cover of light bulb through transparent light engine plate and the reflector of LED light bulb, therefore, the luminous efficiency of wafer can be greatly improved and the junction temperature of wafer can be reduced; moreover, it is convenient for the design of gaps on both sides of light engine plate to connect external wiring, meanwhile, it can work normally in a fluid environment, after the light engine module is assembled into inner cover of LED light bulb with transparent insulated heat conduction fluid, the heated transparent insulated heat conduction fluid can complete smooth circulating through gaps for thermal cycle, in this way, the light engine module of the present invention can be of excellent heat dissipation effect at work, thereby improving the luminous efficiency of LED. Moreover, for the light engine plate of different sizes, gaps of different shapes and sizes are opened after the repeat studying, experiment and summary by the applicant of the present invention, so that the light engine plate can achieve the best effect of liquid flow without affecting the space of LED relevant components, thereby realizing the best heat dissipation effect.

### BRIEF DESCRIPTIONOF THE PRESENT INVENTION

Fig.1 is an architecture diagram of LED lighting industry according to the present invention.
Fig.2 is an outline schematic diagram of light engine module whose profile of transparent cover plate is the same with that of light engine plate according to the embodiments 1-1, 2-1, 3-1, and 4-1 ~4-3.
Fig.3 is an exploded view of light engine module as Fig.2 shown.
Fig.4 is an outline schematic diagram of light engine module using the transparent sealant according to the embodiments 1-1, 2-1, 3-1, and 4-1 ~4-3.
Fig.5 is an outline schematic diagram of light engine module whose profile of transparent cover plate is smaller than that of light engine plate according to the embodiments 1-1, 2-1, 3-1, and 4-1~4-3.
Fig.6 is an exploded view of light engine module as Fig. 5 shown.
Fig.7 is an opening schematic diagram of light engine plate using the transparent sealant according to the embodiments 1-1, 2-1, 3-1, and 4-1 ~4-3.
Fig.8 is an installation diagram of light engine plate and connector according to the embodiments 1-1, 2-1, 3-1, and 4-1 ~4-3.
Fig.9 is a schematic diagram of application structure according to the embodiments 1-1, 2-1, 3-1, and 4-1~4-3.
Fig.10 is an outline schematic diagram of light engine module using the transparent sealant according to the embodiments 1- 2, 2-2, 3-2, and 5-1 ~ 4-5.
Fig.11 is an exploded view of light engine module whose profile of transparent cover plate is the same with that of light engine module plate according to the embodiments 1-2, 2-2, 3-2, and 5-1~4-5.
Fig.12 is a structure diagram of light engine module whose profile of transparent cover plate is smaller than that of light engine plate according to the embodiments 1- 2, 2-2, 3-2, and 5-1 ~ 4-5.
Fig.13 is an installation diagram of light engine plate and connector according to the embodiments, 2-2, 3-2, and 5-1 ~ 4-5.
Fig.14 is an opening schematic diagram of light engine plate according to the embodiments, 2-2, 3-2, and 5-1 ~ 4-5.
Fig.15 is a schematic diagram of application structure according to the embodiments 2-2, 3-2, and 5-1 ~ 4-5.
Fig.16 is an outline schematic diagram of light engine module using the transparent sealant according to the embodiments 1-3, 2-3, 3-3, and 6-1~6-5.
Fig.17 is an exploded view of light engine module whose profile of transparent cover plate is the same with that of light engine module plate according to the embodiments 1-3, 2-3, 3-3, and 6-1~6-5.
Fig.18 is a structure diagram of light engine module whose profile of transparent cover plate is smaller than that of light engine plate according to the embodiments 1-3, 2-3, 3-3, and 6-1 ~6-5.
Fig.19 is an opening schematic diagram of light engine plate using the transparent sealant according to the embodiments 1-3, 2-3, 3-3, and 6-1 ~6-5.
Fig.20 is a schematic diagram of application structure according to the embodiments 1- 3, 2-3, 3-3, and 6-1~6-5.
Fig.21 is a luminous principle diagram of GaN-based LED according to the present invention.
Fig.22 is a structure diagram of LED light bulb manufactured by the method according to embodiments 1-1 and 2-1 in the present invention.
Fig.23 is a structure diagram of LED light bulb manufactured by the method of the present invention according to embodiments 1-2 and 2-2.
Fig.24 is a structure diagram of LED light bulb manufactured by the method according to embodiments 1-3 and 2-3 in the present invention.
Fig.25 is a structure diagram used on street lamps of LED light bulb manufactured by the method according to embodiments 1-3 and 2-3 in the present invention.
Fig. 26 is an architecture diagram of LED lighting lamp industry according to the present invention as Fig.1 shown.
Fig.27 is a structure diagram used on tunnel lamps of LED light bulb established by light engine module and manufactured by the method of embodiment 2-3 of the present invention.
Fig.28 is a structure diagram used on down lamps of LED light bulb established by light engine module and manufactured by the method of an embodiment of the present invention.
Fig.29 is a structure diagram of embodiment 4-1 of the present invention.
Fig.30 is a structure diagram of embodiment 4-2 of the present invention.
Fig.31 is a structure diagram of embodiment 4-3 of the present invention.

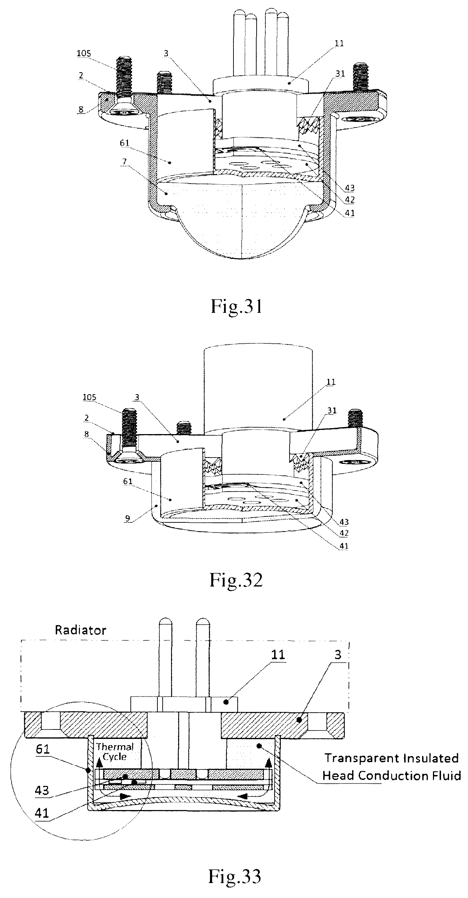

Fig.31 is a structure diagram of replacing outer cover of light bulb with lens according to embodiment 4-3 of the present invention.
Fig. 33 is a schematic diagram of thermal cycle according to embodiments 4-1, 4-2, and 4-3 of the present invention.

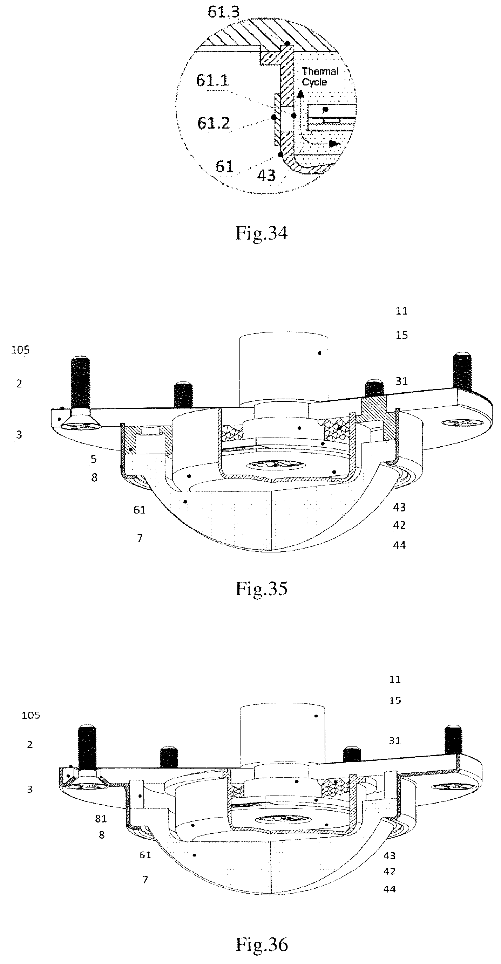

Fig.34 is a partially enlarged view of inner cover of Fig.33.
Fig.35 is a structure diagram of embodiment 5-1 of the present invention.
Fig.36 is a structure diagram of embodiment 5-2 of the present invention.

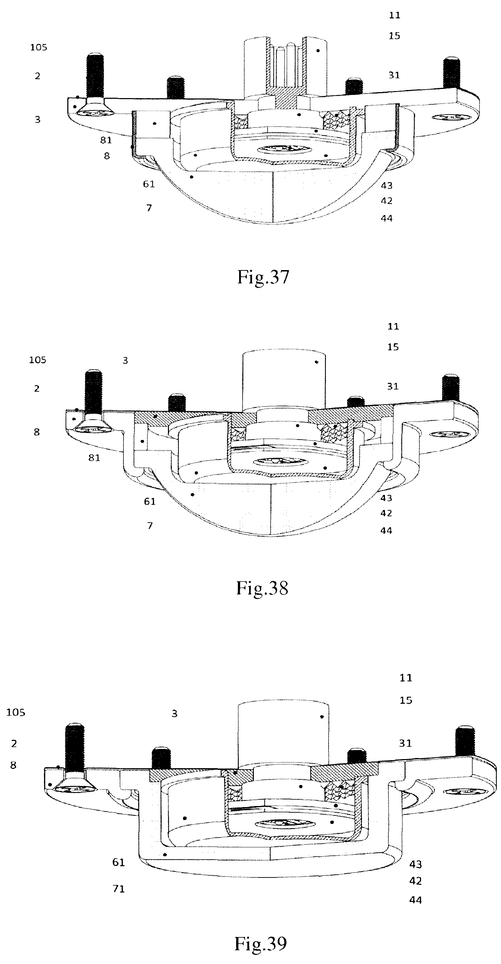

Fig.37 is a structure diagram of embodiment 5-3 of the present invention.
Fig.38 is a structure diagram of embodiment 5- 4 of the present invention.
Fig.39 is a structure diagram of embodiment 5- 5 of the present invention.
Fig.31 is a structure diagram of replacing outer cover of light bulb with lens according to embodiments 5-1, 5-2, 5-3, 5-4 and 5-5of the present invention.

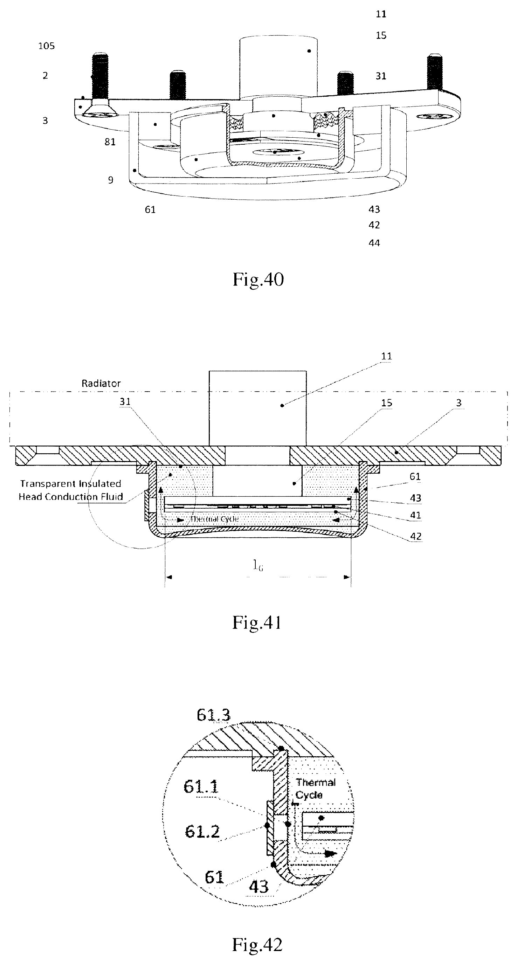

Fig. 41 is a schematic diagram of thermal cycle according to embodiments 5-1, 5-2, 5-3, 5-4 and 5-5 of the present invention.
Fig.42 is a partially enlarged view of inner cover of Fig.41.

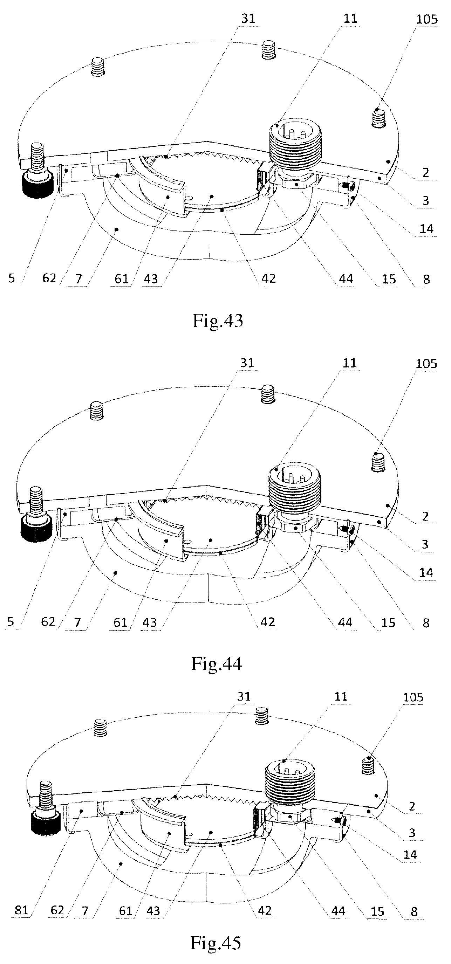

Fig.43 is a structure diagram of embodiment 6-1 of the present invention.
Fig.44 is a structure diagram of embodiment 6-2 of the present invention.
Fig.45 is a structure diagram of embodiment 6-3 of the present invention.

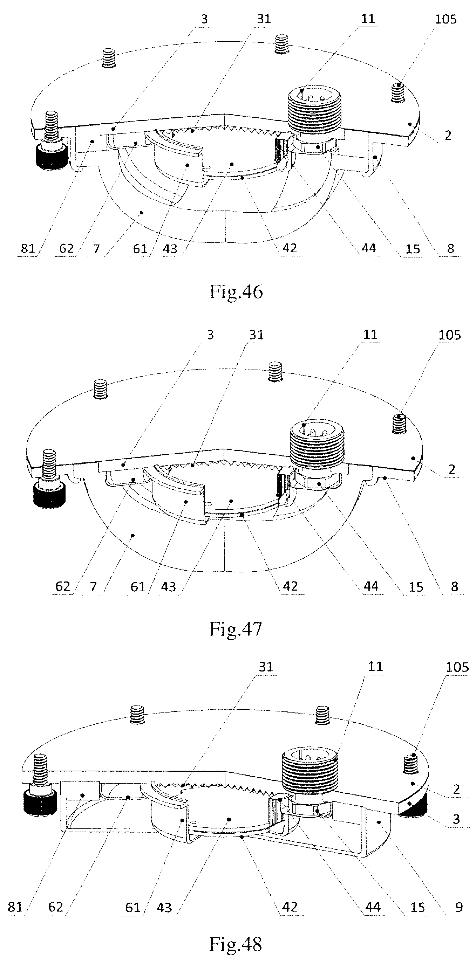

Fig.46 is a structure diagram of embodiment 6-4 of the present invention.
Fig.47 is a structure diagram of embodiment 6-5 of the present invention.
Fig.31 is a structure diagram of replacing outer cover of light bulb with lens according to embodiments 6-1, 6-2, 6-3, 6-4 and 6-5 of the present invention.

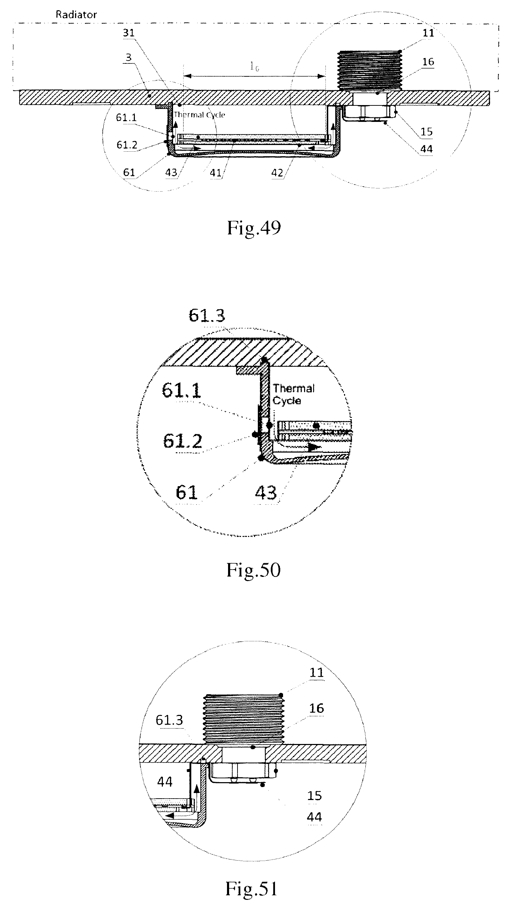

Fig. 49 is a schematic diagram of thermal cycle according to embodiments 6-1, 6-2, 6-3, 6-4 and 6-5 of the present invention.
Fig.50 is a partially enlarged view of inner cover of Fig.49.
Fig.51 is a partially enlarged view of electric connector part of Fig.49.

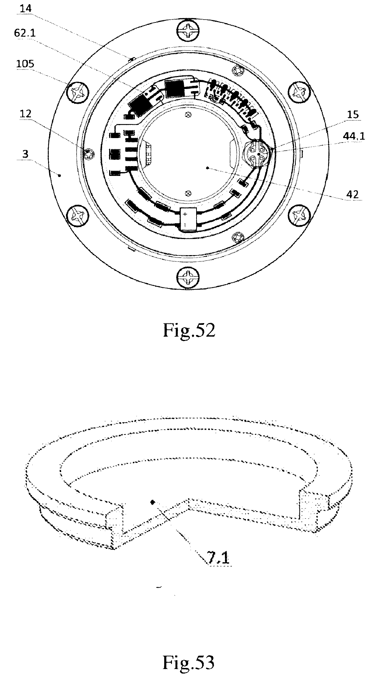

Fig.52 is a schematic diagram of miniaturized power supply for inner ring cover of light bulb.
Fig.53 is a structure diagram of outer cover of lenticular interface.

### DETAILED DESCRIPTION OF PREFERRED EMBODIMENTS

The present invention will be further explained with reference to drawings and embodiments, but the present invention is not limited thereto. An LED light bulb manufacturing method, comprising following steps:
1) preparing a transitional epitaxial layer on a substrate to form an epitaxial layer;
2) putting the epitaxial wafer into a reacting furnace to undergo such process steps as silicon coating, sizing, photolithography, etching, film coating, alloying, and slice grinding, the epitaxial wafer growing by layers to form an LED wafer at a specific position and relevant circuits; the LED wafer will not be cut after the completion of the growth; obtaining product A after the LED wafer passes inspection, and die bonding relevant components on product A (die bonding the wafer level driving power chip and other components if have and it also can be formed through direct growth in the reacting furnace)and then wire bonding (conducting wire bonding to connect LED wafer and relevant components) to obtain product B, after step 2, the complete LED circuit can be formed on epitaxial wafer (the same with predetermined LED circuit); and the processes of epitaxial wafer growing by layers to LED wafer (photolithography etching and others) are existing technologies.
3) on product B, performing the process steps of sealant pouring to cover the wafer and baking, and after inspection, conducting color separation and light splitting, so as to form a finished light engine module;
4) utilizing the light engine module and light bulb accessories to assemble an LED light bulb, and aging and packaging the assembled LED light bulb to obtain a finished LED light bulb.

The light engine plate is used as substrate directly in step 1, or thin substrate layer whose shape is the same with that of the light engine plate is used as substrate; the specific step of the sealant pouring to cover the wafer is to use transparent sealant (45) and/or transparent cover plate (42) on the LED relevant components (41) of product B to cover the wafer and only the correlated bonding pad of LED relevant components (41) is shown; when the thin substrate whose shape is the same with that of light engine plate is used as substrate in step 1, then the product B is further needed to be bonded with light engine plate (43) in step 3; both sides of the light engine plate (43) are provided with gaps; the LED relevant components (41) comprise an LED wafer, relevant circuits and relevant components.

The light bulb accessories mainly comprise a heat conducting support (3), a light distribution optical lens (7), a lens snap ring (8), an electric connector male (11), a flexible built-up circuit (44), an inner cover (61), an inner ring cover (62) and an inner snap ring (81).

Wherein the transparent sealant (45) and/or the transparent cover plate (42) are used on the LED relevant components (41) to cover, and only the correlated bonding pad on the LED relevant components (41) is shown. The methods of covering LED relevant components by transparent sealant (45) and/or transparent cover plate (42) are as follows: filling in a little transparent sealant between LED relevant components (41) to level, and forming the transparent sealant between the surface of LED wafer and the transparent cover plate as little as possible, then covering the transparent cover plate (42) whose profile is the same with that of light engine plate (43) on LED relevant components, besides, opening area is provided on transparent cover plate (42) to show the bonding pad; or filling in a little transparent sealant between LED relevant components (41) to level, and forming the transparent sealant between the surface of LED wafer and the transparent cover plate (42) as little as possible, then covering the transparent cover plate (42) whose profile is smaller than that of light engine plate (43) on LED relevant components (41), then the transparent sealant (45) is wrapped around transparent cover plate (42)to level the profile of transparent sealant (45) with that of light engine plate (43), opening area is provided on transparent cover plate (42) to show the bonding pad; or the LED relevant components (41) is wrapped up with the transparent sealant (45)directly to level the profile of transparent sealant (45) with that of light engine plate (43), opening area is provided on transparent cover plate (42) to show the bonding pad. The phosphor and protective layer are coated on the transparent cover plate (42), or the transparent cover plate (42) is molded transparent fluorophor. Transparent fluorophor is prepared by the fluorescent materials and transparent materials according to the weight ratio of 5~30:100.

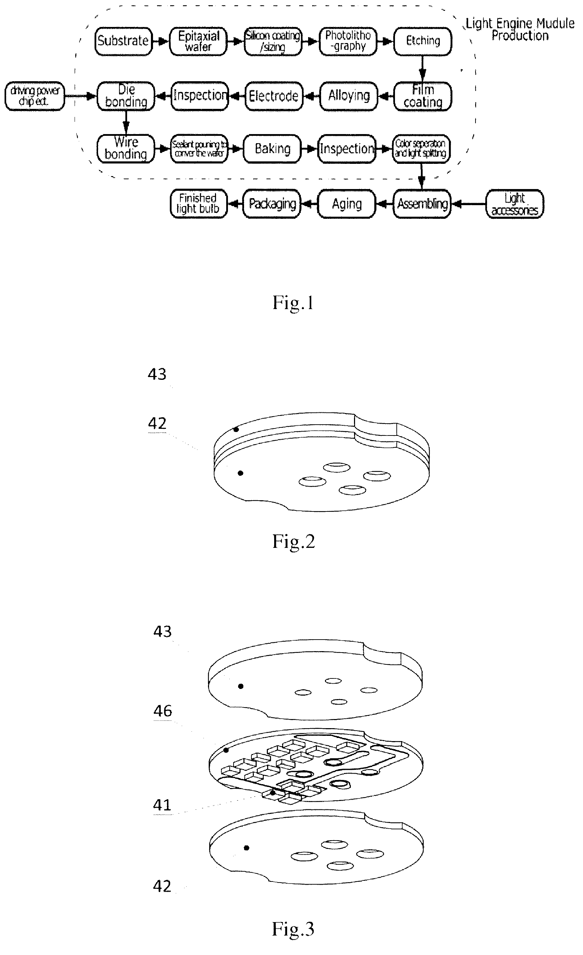

The method of the present invention can produce industry framework as Fig.1 shown. And three types of light engine module can be assembled with the method of the present invention.

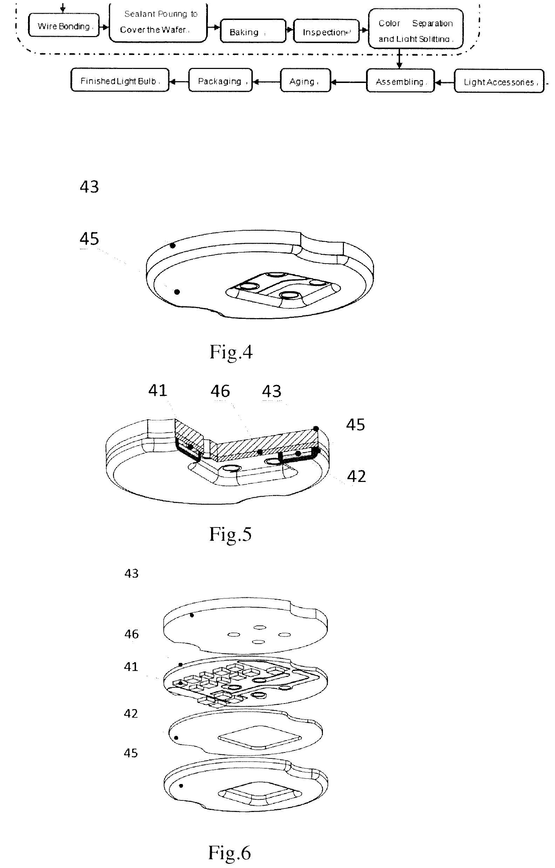

Embodiment 1-1: A light engine module used for small-sized LED light bulb, comprising preparing the thin epitaxial wafer (46) formed by the transitional epitaxial layer on the existing LED substrate, putting the epitaxial wafer (46) into a reacting furnace to grow by layers to form an LED wafer and relevant circuits, and the epitaxial wafer (46) is soldered with relevant components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer (46) is soldered with relevant components, then conducting wire bonding to connect the LED wafer and relevant components. The LED relevant components (41) are formed by the LED wafer, relevant circuits and relevant components; the transparent sealant (45) and/or the transparent cover plate (42) are used to cover the LED relevant components (41), and only the correlated bonding pad of the LED relevant components (41) is shown. The methods of covering LED relevant components by transparent sealant (45) and /or transparent cover plate (42) are as follows as Fig.2 and Fig.3 shown: filling in a little transparent sealant between LED relevant components (41) to level, and forming the transparent sealant between the surface of LED wafer and the transparent cover plate as little as possible, then covering the transparent cover plate (42) whose profile is the same with that of light engine plate (43) on LED relevant components, besides, opening area is provided on transparent cover plate (42) to show the bonding pad; or as Fig.5 and Fig.6 shown, filling in a little transparent sealant between LED relevant components (41) to level, and forming the transparent sealant between the surface of LED wafer and the transparent cover plate as little as possible, then covering the transparent cover plate (42) whose profile is smaller than that of light engine plate on LED relevant components (41), then the transparent sealant (45) is wrapped around the transparent cover plate (42) to level the profile of transparent sealant (45) with that of the light engine plate (43), opening area is provided on the transparent cover plate (42) to show the bonding pad; or as Fig.4 shown, the LED relevant components (41) are wrapped up with the transparent sealant (45) directly to level the profile of transparent sealant (45) with that of light engine plate (43), opening area is provided on transparent cover plate (42) to show the bonding pad.

The phosphor and protective layer are coated on the transparent cover plate (42) and /or the light engine plate (43); or the transparent cover plate (42) and /or the light engine plate (43) are molded transparent fluorophor. Transparent fluorophor is prepared by the fluorescent materials and transparent materials according to the weight ratio of 5~30:100.

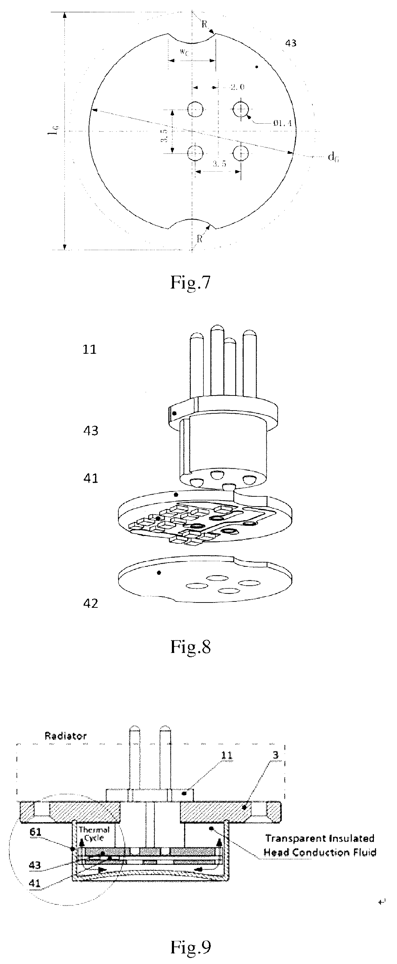

As Fig.7 shown, the light engine plate (43) is circular plate, two inner arc gaps are provided symmetrically on both sides of the circular plate, the center of gaps is at the concentric circle of the periphery of the circular plate, the cutting way is to cut both sides of the circle according to the diameter of d_{G}, the symmetry of X axis, the length of I_{G}, the radius of R, and the string length of w_{G}, thereby forming two circle gaps whose radius is R. when the light engine module is used for the plan of liquid-cooling method, the heated transparent insulated heat conduction fluid can conduct thermal cycle from gaps; circle holes used for the connection with the contact pin of the electric connector (11) are further provided on the light engine plate (43), there are four circle holes whose diameter is 1.4mm distributed symmetrically utilizing the 2mm position of X axis of the light engine plate (43) as the center with the spacing of 3.5mm; the bonding pad, located at the position of the circle hole, is on the LED relevant components (41), the contact pin of the electric connector (11) is soldered with the bonding pad after inserting into the circle hole, as Fig.8 shown. there are four circle holes connected with the contact pin of the electric connector (11), and they are distributed symmetrically with an equal distance of 3.5mm, the center of four circle holes is located at a distance of 2mm with the center of the circular plate, moreover, the center of four circle holes is the same distance with the two gaps. That is, there are four circle holes whose diameter is 1.4mm distributed symmetrically utilizing the 2mm position of X axis of the light engine plate (43) as the center with the spacing of 3.5mm. The circle diameter dG of the circular plate is 11 mm or 16mm; when it is 11 mm, the center of two circular arc gaps is in the circle whose diameter dG is 13mm, the radius of two circular arc gaps is 3.2mm; when it is 16 mm, the center of two circular arc gaps is in the circle whose diameter is 19mm, the radius of two circular arc gaps is 3.6mm.

The LED light bulb of the present invention is assembled as follows: passing through the heat conduction support (3), the electric connector (11) is soldered with the heat conduction support (3), ,the contact pin of the electric connector (11) is soldered with the bonding pad on the LED relevant components (41) after inserting the circle hole of the light engine plate (43), the concave inner cover (61) is provided around a periphery of the light engine module of LED light bulb, finally, the light engine module of LED light bulb is disposed at the confined space between the heat conduction support (3) and the concave inner cover (61), the external diameter of light engine plate for the light engine module of LED light bulb is tightly closed to the inner diameter of the inner cover (61). In this way, a core structure of LED light bulb is formed, and finally the transparent insulated heat conduction fluid is injected into the inner cover (61) as Fig. 9 shown, the pressure relief hole (61.1) and the pressure relief membrane (61.2) used to seal are provided on the concave inner cover (61). Both the structures of Fig.8 and Fig.9 are the plan of preparing the transitional epitaxial layer on the light engine plate directly.

Fig.22 is an illustration of LED light bulb manufactured by the present invention (assembled by small-sized light engine module), the lens snap ring (8) is provided around a periphery of the concave inner cover (61), in this way, the light distribution optical lens (7) can be got stock by the lens snap ring (8), the lens snap ring (8) is fixed on the heat conduction support (3); the fixed screw of light bulb (105) is used for fixing the light bulb when assembling.

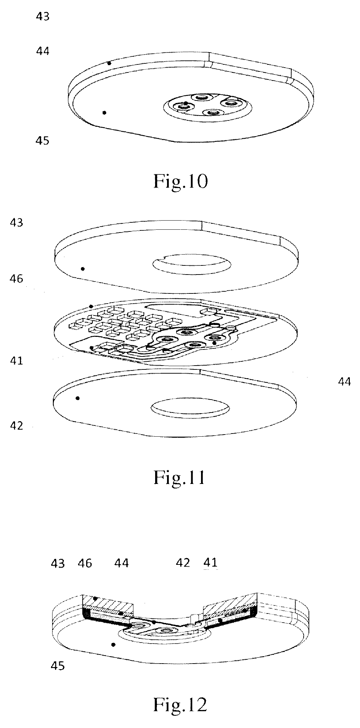

Embodiment 1-2: A light engine module used for medium-sized LED light bulb, comprising preparing the thin epitaxial wafer (46) formed by the transitional epitaxial layer on the existing LED substrate, putting the epitaxial wafer (46) into a reacting furnace to grow by layers to form an LED wafer and relevant circuits, and the epitaxial wafer (46) is soldered with relevant components, then conducting wire bonding to connect LED wafer and relevant components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer (46) is soldered with relevant components, then conducting wire bonding to connect the LED wafer and relevant components. The LED relevant components (41) are formed by the LED wafer, relevant circuits and relevant components; the transparent sealant (45) and/or the transparent cover plate (42) are used to cover the LED relevant components (41), and only the correlated bonding pad of the LED relevant components (41) is shown. The methods of covering LED relevant components by transparent sealant (45) and/or transparent cover plate (42) are as follows: filling in a little transparent sealant between LED relevant components (41) to level, and forming the transparent sealant between the surface of LED wafer and the transparent cover plate as little as possible, then covering the transparent cover plate (42) whose profile is the same with that of light engine plate (43) on LED relevant components, besides, opening area is provided on transparent cover plate (42) to show the bonding pad, as Fig.11 shown; or filling in a little transparent sealant between LED relevant components (41) to level, and forming the transparent sealant between the surface of LED wafer and the transparent cover plate (42) as little as possible, then covering the transparent cover plate (42) whose profile is smaller than that of light engine plate (43) on LED relevant components (41), then the transparent sealant (45) is wrapped around the transparent cover plate (42) to level the profile of transparent sealant (45) with that of light engine plate (43), opening area is provided on transparent cover plate (42) to show the bonding pad, as Fig.12 shown; or as Fig.10 shown, the LED relevant components (41) is wrapped up with the transparent sealant (45) directly to level the profile of transparent sealant (45) with that of light engine plate (43), opening area is provided on transparent cover plate (42) to show the bonding pad. The phosphor and protective layer are coated on the transparent cover plate (42) and /or the light engine plate (43); or the transparent cover plate (42) and /or the light engine plate (43) are molded transparent fluorophor. Transparent fluorophor is prepared by the fluorescent materials and transparent materials according to the weight ratio of 5~30:100.

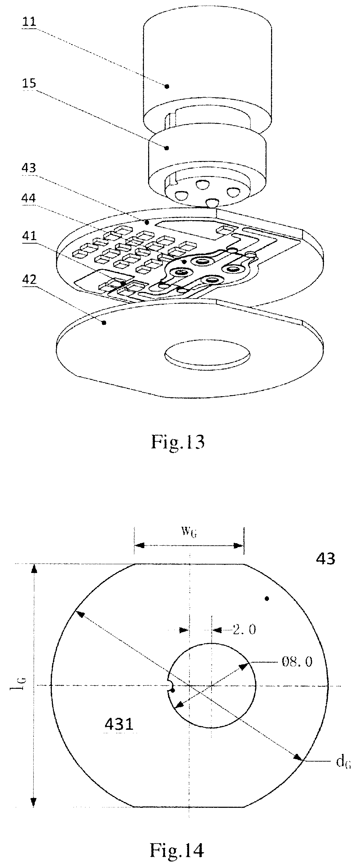

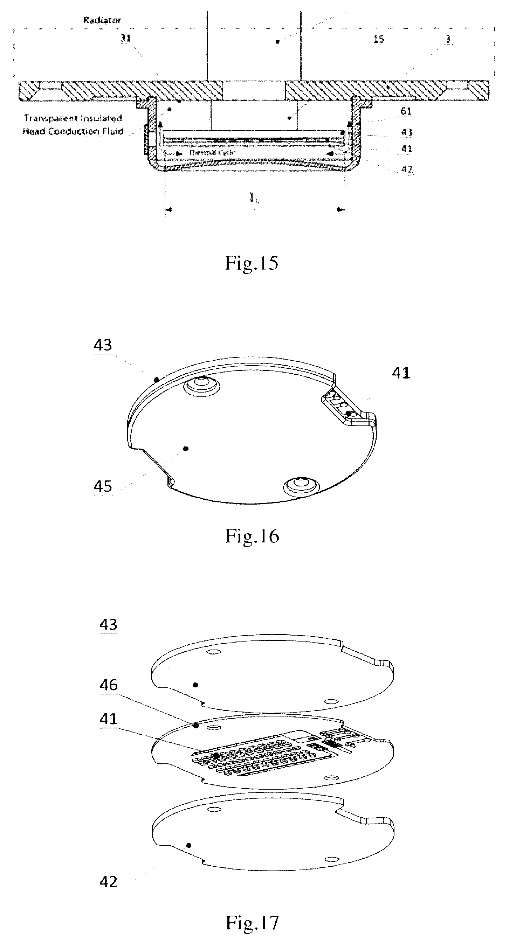

As Fig. 14 shown, the light engine plate (43) is circular plate, two symmetrical gaps are formed by removing the two bow shapes of the circle on both sides of the circular plate symmetrically; the circle hole with alignment pin is provided on the light engine plate (43), the circle hole is used for the alignment connection with the electric connector (11); the gaps are formed by cutting the both sides of the circle utilizing the d_{G} as diameter, the symmetry of X axis, the length of I_{G}, and the string length of w_{G}, when the light engine module is used for the plan of liquid-cooling method, the heated transparent insulated heat conduction fluid can conduct thermal cycle from gaps, as Fig. 15 shown. The circle utilizing the 2mm position of X axis of the light engine plate (43) as the center and 8mm as the diameter is opened, the alignment pin (431) of the electric connector (11) is provided on the circle, as Fig.14 shown; the flexible built-up circuit (44) is soldered with the connection point of the LED relevant components (41). The circle diameter of the circular plate is 18mm or 25mm When it is 18mm, the string length of the removed two bow shape is 8.2mm, and the distance between two strings is 16mm; when it is 25mm, the string length of the removed two bow shape is 9.8mm, and the distance between two strings is 23mm; wherein the diameter of circle hole with alignment pin is 8mm, the center of which is located at a distance of 2mm with the center of the circular plate, and the center of circle hole is the same distance with the two gaps, that is, the circle utilizing the 2mm position of X axis of the light engine plate (43) as the center and 8mm as the diameter is opened, the alignment pin (431) of the electric connector (11) is provided on the circle. The bonding pad is disposed at the position of circle center by LED relevant components (41) through the flexible built-up circuit (44), the electric connector (11) is soldered with the bonding pad after inserting into circle hole, as Fig. 13 shown.

The LED light bulb of the present invention is assembled as follows: the electric connector (11) is fixed on the heat conduction support (3) by the fixed end (15), the electric connector (11) is soldered with the bonding pad on the flexible built-up circuit (44) after inserting the circle hole with alignment pin of the light engine plate (43), the concave inner cover (61) is provided around a periphery of the light engine module of LED light bulb, finally, the light engine module of LED light bulb is disposed at the confined space between the heat conduction support (3) and the concave inner cover (61), the external diameter of light engine plate (43) for the light engine module of LED light bulb is tightly closed to the inner diameter of the inner cover (61). In this way, a core structure of LED light bulb is formed, and finally the transparent insulated heat conduction fluid is injected into the inner cover (61) as Fig.15 shown, the pressure relief hole ( 61.1) and the pressure relief membrane (61.2) used to seal are provided on the concave inner cover (61). Both the structures of Fig.13 and Fig.15 are the plan of preparing the transitional epitaxial layer on the light engine plate directly.

Fig.23 is an illustration of LED light bulb manufactured by the present invention (assembled by medium-sized light engine module), the light distribution optical lens (7) is provided around a periphery of the concave inner cover (61), in this way, the light distribution optical lens (7) is fixed on the heat conduction support (3) by the inner snap ring (81) and lens snap ring (8); the fixed screw of light bulb (105) is used for fixing the light bulb when assembling.

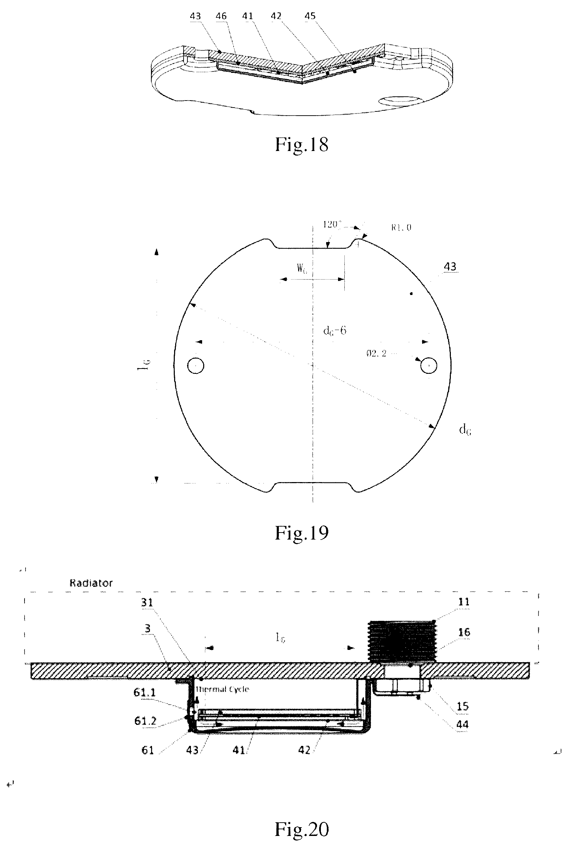

Embodiment 1-3: A light engine module of LED light bulb, comprising preparing the thin epitaxial wafer (46) formed by the transitional epitaxial layer on the existing substrate, putting the epitaxial wafer (46) into a reacting furnace to grow by layers to form an LED wafer and relevant circuits, and the epitaxial wafer (46) is soldered with relevant components, then conducting wire bonding to connect LED wafer and relevant components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer (46) is soldered with relevant components, then conducting wire bonding to connect the LED wafer and relevant components. The LED relevant components (41) are formed by the LED wafer, relevant circuits and relevant components; the transparent sealant (45) and/or the transparent cover plate (42) are used to cover the LED relevant components (41), and only the correlated bonding pad of the LED relevant components (41) is shown. The methods of covering LED relevant components by transparent sealant (45) and/or transparent cover plate (42) are as follows: filling in a little transparent sealant between LED relevant components (41) to level, and forming the transparent sealant between the surface of LED wafer and the transparent cover plate as little possible, then covering the transparent cover plate (42) whose profile is the same with that of light engine plate (43) on LED relevant components, besides, opening area is provided on transparent cover plate (42) to show the bonding pad, as Fig. 17 shown; or filling in a little transparent sealant between LED relevant components (41) to level, and forming the transparent sealant between the surface of LED wafer and the transparent cover plate(42) as little as possible, then covering the transparent cover plate (42) whose profile is smaller than that of light engine plate (43) on LED relevant components (41), then the transparent sealant (45) is wrapped around transparent cover plate (42) to level the profile of transparent sealant (45) with that of light engine plate (43), opening area is provided on transparent cover plate (42) to show the bonding pad, as Fig. 18 shown; or the LED relevant components (41) is wrapped up with the transparent sealant (45) directly to level the profile of transparent sealant (45) with that of light engine plate (43), opening area is provided on transparent cover plate (42) to show the bonding pad and fix holes, as Fig.16 shown.

As Fig.19 shown, the light engine plate (43) is circular plate, both sides of the circular plate is provided with two symmetrical gaps, each gap is formed by cutting a string along the circle the circular plate, moreover, both ends of the string tilt outwards to 120 degrees and transit to the circle of the circular plate by circular arc; the shape is to cut both sides of the circle according to the diameter of d_{G}, the symmetry of X axis, the length of I_{G}, the string length of w_{G}, the ends of the string tilt outwards to 120 degrees, and it is transited to the diameter d_{G} with the arc of R=1.0mm, thereby forming the gaps, when the light engine module is used for the plan of liquid-cooling method, the heated transparent insulated heat conduction fluid can conduct thermal cycle from gaps. As Fig.18 shown, the circle diameter d_{G} of the circular plate is 20mm 38mm or 50mm; if the length between the gap subtract the outward tilting part, the length is 10mm, the radius of circular arc used for transition is 1 mm, the two corresponding strings of two gaps are parallel to each other; when it is 20mm, the distance between two strings is 15mm; when it is 38mm, the distance between two strings is 33mm when it is 50mm, the distance two strings is 45mm;The bonding pad is located at the inner side of the gaps of circular plate, each pad is disposed on the inner side of two gaps or that of one gap respectively, the electric connector (11) is connected with the bonding pad through the flexible built-up circuit (44).

The phosphor and protective layer are coated on the transparent cover plate (42) and /or the light engine plate (43); or the transparent cover plate (42) and /or the light engine plate (43) are molded transparent fluorophor. Transparent fluorophor is prepared by the fluorescent materials and transparent materials according to the weight ratio of 5-30:100. There are two fixed holes provided on the light engine module (43), the two fixed holes are symmetric around the center circular plate with a distance of dG-6, the diameter of fixed holes is 2.2mm, the link of two fixed holes is orthogonal with that of gaps center; when the diameter d_{G}= 20mm, a fixed hole of one side need to be opened, that is, two fixed holes whose diameter is 2.2mm are disposed symmetrically on the light engine plate (43) utilizing Y axis as the center and dG-6 as the diameter, when the diameter d_{G}=20mm, a fixed hole of one side need to be opened.

The LED light bulb of the present invention is assembled as follows: the opening is provided on the heat conduction support (3), the electric connector (11) is fixed on the heat conduction support (3) after inserting the opening and through the fixed end (15), the electric connector (11) is soldered with the bonding pad on the LED relevant components (41), the light engine module of LED light bulb is disposed at the confined space between the heat conduction support (3) and the concave inner cover (61), steps are provided on the light engine module of LED light bulb, the light engine module is laid on the steps and fixed on the steps through the periphery of the light engine module, besides, the external diameter of light engine plate for the light engine module of LED light bulb is tightly closed to the inner diameter of the concave inner cover (61). The differences with embodiment 1 and embodiment are as follows, the connector, located at the periphery of the concave inner cover (61), is connected with the bonding pad of LED relevant components (41) in the concave inner cover (61) by the flexible built-up circuit (44), and finally the transparent insulated heat conduction fluid is injected into the inner cover (61), the pressure relief hole (61.1) and the pressure relief membrane (61.2) used to seal are provided on the concave inner cover (61), as Fig.20 shown, the structure is the plan of preparing the transitional epitaxial layer on the light engine plate directly.

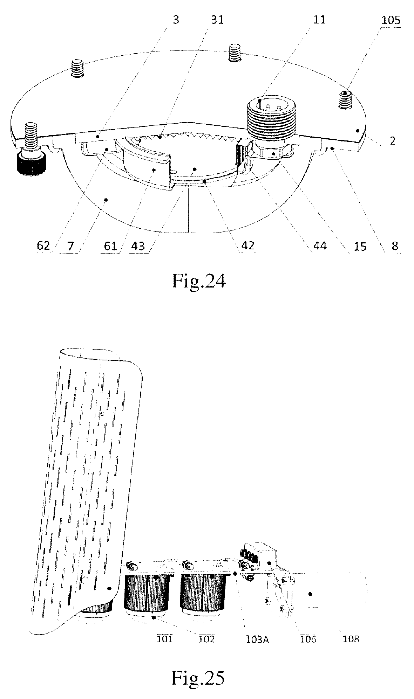

Fig.24 is an illustration of LED light bulb manufactured by the present invention (assembled by large-sized light engine module), the light distribution optical lens (7) is provided around a periphery of the concave inner cover (61), the lens snap ring (8) is fixed on the heat conduction support (3) by the inner snap ring (81) and the lens snap ring (8); the welding point of the flexible built-up circuit (44) and the electric connector (11) is covered by the inner ring cover (62) for decoration, the fixed screw of light bulb (105) is used for the light bulb when assembling.

Fig.25 is an illustration of LED light bulb manufactured by the method of the present invention used on street lamps, a lampshade (101) and a driving power with lighting control (106) are fixed on an assembly interface board (103A) by the fixed screw, a light bulb (102)with radiator is fixed on the assembly interface board (103A) by the fixed screw, the light bulb (102) with waterproof connector male with nut(10A) is connected with the driving power with lighting control (106), the assembly interface board (103A) is fixed on a lamp post (108) by the fixed screw.

The following seven specifications of the light engine module are realized by above three embodiments, which can meet a majority of lighting requirements.

| Types of the module | d_{G}/mm | I_{G}/mm | w_{G}/mm | h_{G}/mm | notes |
|---|---|---|---|---|---|
| Embodiment 1 | 11 | 13 | 3.2 | 0.6-3.0 (it is for reference, not a compulsive demand) | |
| | 16 | 19 | 3.6 | | |
| Embodiment 2 | 18 | 16 | 8.2 | | |
| | 25 | 23 | 9.8 | | |
| Embodiment 3 | 20 | 15 | 10.0 | | |
| | 38 | 33 | 10.0 | | |
| | 50 | 45 | 10.0 | | |

The mark of figures in the embodiments 3-1, 3-2 and 3-3 is respectively: (2)-heat conduction pad, (3)-heat conduction support, (4)-light engine module, (7)-light distribution optical lens, (8)-lens snap ring, (10)-electric connector female with flange, (10A) -waterproof connector male with nut, (11)-electric connector, (15)-fixed end, (16)-waterproof rubber ring, (25)-fixed screw of connector female, (31)-reflector, (41)-LED relevant components, (42)-transparent cover plate, (43)-light engine plate, (44)-flexible built-up circuit, (45)-transparent sealant, (61)-concave inner cover of light bulb, (61.1)-pressure relief hole, (61.2)-pressure relief membrane, (81)-inner snap ring, (101)-lampshade, (101A)-lampshade piece, (102)-LED light bulb, (103)-compressive radiator, (103A)-assembly interface board, (104)-fixed screw, (105)-fixed screw of light bulb, (106)-driving power with lighting control, (107)-spring fixing clip, (108)-lamp post, (110)- supporting cover of lampshade piece, (117)-radiator support, (118)-steering fixed screw, (431)-alignment pin.

An LED illuminating lamp manufacturing method, comprising following steps:
1) preparing a transitional epitaxial layer on a substrate to form an epitaxial wafer;
2) putting the epitaxial wafer into a reacting furnace and growing by layers to form an LED wafer; the LED wafer will not be cut after the completion of the growth; obtaining product A after the LED wafer passes inspection, and die bonding relevant components on product A and conducting wire bonding to connect LED wafer and relevant components to obtain product B;
3) assembling product B into light engine module directly;
4) utilizing the light engine module and light bulb accessories to assemble an LED light bulb.
5) utilizing the assembled LED light bulb in step 4 and lamps in terminal market and/or lighting control products to assemble the LED illumination lamp.

The light engine plate is used as substrate directly in step 1, or thin substrate layer whose shape is the same with that of the light engine plate is used as substrate; the specific step of step 3 is to use transparent sealant (45) and/or transparent cover plate (42) on the LED relevant components (41) of product B to cover the wafer and only the correlated bonding pad of LED relevant components (41) is shown; when the thin substrate whose shape is the same with that of light engine plate is used as substrate in step 1, then the product B is further needed to be bonded with light engine plate (43) in step 3; both sides of the light engine plate (43) are provided with gaps; the LED relevant components (41) comprise an LED wafer, relevant circuits and relevant components.

The light accessories mainly comprise a heat conducting support (3), a light distribution optical lens (7), a lens snap ring (8), an electric connector male (11), a flexible built-up circuit (44), a light bulb concave inner cover (61), an inner ring cover (62) and an inner snap ring (81).

Wherein the transparent sealant (45) and/or the transparent cover plate (42) are used on the LED relevant components (41) to cover, and only the correlated bonding pad on the LED relevant components (41) is shown. The methods of covering LED relevant components by transparent sealant (45) and/or transparent cover plate (42) are as follows: filling in a little transparent sealant between LED relevant components (41) to level, and forming the transparent sealant between the surface of LED wafer and the transparent cover plate as little as possible, then covering the transparent cover plate (42) whose profile is the same with that of light engine plate (43) on LED relevant components, besides, opening area is provided on transparent cover plate (42) to show the bonding pad; or filling in a little transparent sealant between LED relevant components (41) to level, and forming the transparent sealant between the surface of LED wafer and the transparent cover plate (42) as little as possible, then covering the transparent cover plate (42) whose profile is smaller than that of light engine plate (43) on LED relevant components (41), then the transparent sealant (45) is wrapped around transparent cover plate (42) to level the profile of transparent sealant (45) with that of light engine plate (43), opening area is provided on transparent cover plate (42) to show the bonding pad; or the LED relevant components (41) is wrapped up with the transparent sealant (45) directly to level the profile of transparent sealant (45) with that of light engine plate (43), opening area is provided on transparent cover plate (42) to show the bonding pad. The phosphor and protective layer are coated on the transparent cover plate (42), or the transparent cover plate (42) is molded transparent fluorophor. Transparent fluorophor is prepared by the fluorescent materials and transparent materials according to the weight ratio of 5~30:100.

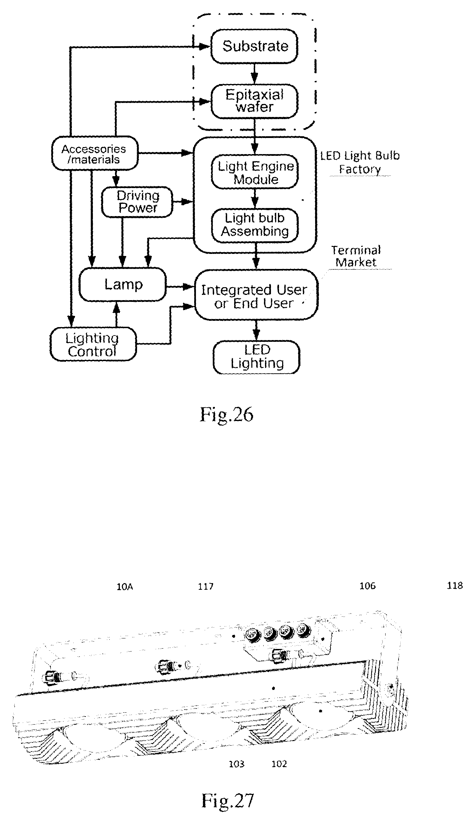

The aforesaid method of the present invention can produce industry framework as Fig. 26 shown. And three types of light engine module can be assembled with the method of the present invention.

Embodiment 2-1: A light engine module used for small-sized LED light bulb, comprising preparing the thin epitaxial wafer (46) formed by the transitional epitaxial layer on the existing LED substrate, putting the epitaxial wafer (46) into a reacting furnace to grow by layers to form an LED wafer and relevant circuits, and the epitaxial wafer (46) is soldered with relevant components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer (46) is soldered with relevant components, then conducting wire bonding to connect the LED wafer and relevant components. The LED relevant components (41) are formed by the LED wafer, relevant circuits and relevant components; the transparent sealant (45) and/or the transparent cover plate (42) are used to cover the LED relevant components (41), and only the correlated bonding pad of the LED relevant components (41) is shown. The methods of covering LED relevant components by transparent sealant (45) and /or transparent cover plate (42) are as follows as Fig.2 and Fig.3 shown: filling in a little transparent sealant between LED relevant components (41) to level, and forming the transparent sealant between the surface of LED wafer and the transparent cover plate as little as possible, then covering the transparent cover plate (42) whose profile is the same with that of light engine plate (43) on LED relevant components, besides, opening area is provided on transparent cover plate (42) to show the bonding pad; or as Fig.5 and Fig.6 shown, filling in a little transparent sealant between LED relevant components (41) to level, and forming the transparent sealant between the surface of LED wafer and the transparent cover plate as little as possible, then covering the transparent cover plate (42) whose profile is smaller than that of light engine plate on LED relevant components (41), then the transparent sealant (45) is wrapped around the transparent cover plate (42) to level the profile of transparent sealant (45) with that of the light engine plate (43), opening area is provided on the transparent cover plate (42) to show the bonding pad; or as Fig. 4 shown, the LED relevant components (41) are wrapped up with the transparent sealant (45) directly to level the profile of transparent sealant (45) with that of light engine plate (43), opening area is provided on transparent cover plate (42) to show the bonding pad.

The phosphor and protective layer are coated on the transparent cover plate (42) and /or the light engine plate (43); or the transparent cover plate (42) and /or the light engine plate (43) are molded transparent fluorophor. Transparent fluorophor is prepared by the fluorescent materials and transparent materials according to the weight ratio of 1:10.

As Fig.7 shown, the light engine plate (43) is circular plate, two inner arc gaps are provided symmetrically on both sides of the circular plate, the center of gaps is at the concentric circle of the periphery of the circular plate, the cutting way is to cut both sides of the circle according to the diameter of d_{G}, the symmetry of X axis, the length of I_{G}, the radius of R, and the string length of w_{G}, thereby forming two circle gaps whose radius is R. when the light engine module is used for the plan of liquid-cooling method, the heated transparent insulated heat conduction fluid can conduct thermal cycle from gaps; circle holes used for the connection with the contact pin of the electric connector (11) are further provided on the light engine plate (43), there are four circle holes whose diameter is 1.4mm distributed symmetrically utilizing the 2mm position of X axis of the light engine plate (43) as the center with the spacing of 3.5mm; the bonding pad, located at the position of the circle hole, is on the LED relevant components (41), the contact pin of the electric connector (11) is soldered with the bonding pad after inserting into the circle hole, as Fig.8 shown, there are four circle holes connected with the contact pin of the electric connector 11, and they are distributed symmetrically with an equal distance of 3.5mm, the center of four circle holes is located at a distance of 2mm with the center of the circular plate , moreover, the center of four circle holes is the same distance with the two gaps. That is, there are four circle holes whose diameter is 1.4mm distributed symmetrically utilizing the 2mm position of X axis of the light engine plate (43) as the center with the spacing of 3.5mm. The circle diameter d_{G} of the circular plate is 11 mm or 16mm; when it is 11 mm, the center of two circular arc gaps is in the circle whose diameter d_{G} is 13mm, the radius of two circular arc gaps is 3.2mm; when it is 16 mm, the center of two circular arc gaps is in the circle whose diameter is 19mm, the radius of two circular arc gaps is 3.6mm.

The method of the light engine module of the present invention used for assemble the LED light bulb is as follows: passing through the heat conduction support (3), the electric connector (11) is soldered with the heat conduction support (3), the contact pin of the electric connector (11) is soldered with the bonding pad on the LED relevant components (41) after inserting the circle hole of the light engine plate (43), the concave inner cover (61) is provided around a periphery of the light engine module of LED light bulb, finally, the light engine module of LED light bulb is disposed at the confined space between the heat conduction support (3) and the concave inner cover (61), the external diameter of light engine plate for the light engine module of LED light bulb is tightly closed to the inner diameter of the inner cover (61). In this way, a core structure of LED light bulb is formed, and finally the transparent insulated heat conduction fluid is injected into the inner cover (61) as Fig. 9 shown, the pressure relief hole (61.1) and the pressure relief membrane (61.2) used to seal are provided on the concave inner cover (61). Both the structures of Fig.8 and Fig.9 are the plan of preparing the transitional epitaxial layer on the light engine plate directly.

Fig.22 is an illustration of LED light bulb manufactured by the present invention (assembled by small-sized light engine module), the lens snap ring (8) is provided around a periphery of the concave inner cover (61), in this way, the light distribution optical lens (7) can be got stock by the lens snap ring (8), the lens snap ring (8) is fixed on the heat conduction support (3); the fixed screw of light bulb (105) is used for fixing the light bulb when assembling.

Embodiment 2-2: A light engine module used for medium-sized LED light bulb, comprising preparing the thin epitaxial wafer (46) formed by the transitional epitaxial layer on the existing LED substrate, putting the epitaxial wafer (46) into a reacting furnace to grow by layers to form an LED wafer and relevant circuits, and the epitaxial wafer (46) is soldered with relevant components, then conducting wire bonding to connect LED wafer and relevant components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer (46) is soldered with relevant components, then conducting wire bonding to connect the LED wafer and relevant components. The LED relevant components (41) are formed by the LED wafer, relevant circuits and relevant components; the transparent sealant (45) and/or the transparent cover plate (42) are used to cover the LED relevant components (41), and only the correlated bonding pad of the LED relevant components (41) is shown. The methods of covering LED relevant components by transparent sealant (45) and/or transparent cover plate (42) are as follows: filling in a little transparent sealant between LED relevant components (41) to level, and forming the transparent sealant between the surface of LED wafer and the transparent cover plate as little as possible, then covering the transparent cover plate (42) whose profile is the same with that of light engine plate (43) on LED relevant components, besides, opening area is provided on transparent cover plate (42) to show the bonding pad, as Fig.11 shown; or filling in a little transparent sealant between LED relevant components (41) to level, and forming the transparent sealant between the surface of LED wafer and the transparent cover plate (42) as little as possible, then covering the transparent cover plate (42) whose profile is smaller than that of light engine plate (43) on LED relevant components (41), then the transparent sealant (45) is wrapped around transparent cover plate (42) to level the profile of transparent sealant (45) with that of light engine plate (43), opening area is provided on transparent cover plate (42) to show the bonding pad, as Fig. 12 shown; or as Fig.10 shown, the LED relevant components (41) is wrapped up with the transparent sealant (45) directly to level the profile of transparent sealant (45) with that of light engine plate (43), opening area is provided on transparent cover plate (42) to show the bonding pad. The phosphor and protective layer are coated on the transparent cover plate (42) and /or the light engine plate (43); or the transparent cover plate (42) and /or the light engine plate (43) are molded transparent fluorophor. Transparent fluorophor is prepared by the fluorescent materials and transparent materials according to the weight ratio of 1:10.

As Fig. 14 shown, the light engine plate (43) is circular plate, two symmetrical gaps are formed by removing the two bow shapes of the circle on both sides of the circular plate symmetrically; the circle hole with alignment pin is provided on the light engine plate (43), the circle hole is used for the alignment connection with the electric connector (11); the gaps are formed by cutting the both sides of the circle utilizing the d_{G} as diameter, the symmetry of X axis, the length of I_{G}, and the string length of w_{G}, when the light engine module is used for the plan of liquid-cooling method, the heated transparent insulated heat conduction fluid can conduct thermal cycle from gaps, as Fig. 15 shown. The circle utilizing the 2mm position of X axis of the light engine plate (43) as the center and 8mm as the diameter is opened, the alignment pin (431) of the electric connector (11) is provided on the circle, as Fig.14 shown; the flexible built-up circuit (44) is soldered with the connection point of the LED relevant components (41). The circle diameter of the circular plate is 18mm or 25mm When it is 18mm, the string length of the removed two bow shape is 8.2mm, and the distance between two strings is 16mm; when it is 25mm, the string length of the removed two bow shape is 9.8mm, and the distance between two strings is 23mm; wherein the diameter of circle hole with alignment pin is 8mm, the center of which is located at a distance of 2mm with the center of the circular plate, and the center of circle hole is the same distance with the two gaps, that is, The circle utilizing the 2mm position of X axis of the light engine plate (43) as the center and 8mm as the diameter is opened, the alignment pin (431) of the electric connector (11) is provided on the circle. The bonding pad is disposed at the position of circle center by LED relevant components (41) through the flexible built-up circuit (44), the electric connector (11) is soldered with the bonding pad after inserting into circle hole, as Fig. 13 shown.

The method of light engine module of the present invention to assemble the LED light bulb is as follows: the electric connector (11) is fixed on the heat conduction support (3) by the fixed end (15), the electric connector (11) is soldered with the bonding pad on the flexible built-up circuit (44) after inserting the circle hole with alignment pin of the light engine plate (43), the concave inner cover (61) is provided around a periphery of the light engine module of LED light bulb, finally, the light engine module of LED light bulb is disposed at the confined space between the heat conduction support (3) and the concave inner cover (61), the external diameter of light engine plate (43) for the light engine module of LED light bulb is tightly closed to the inner diameter of the inner cover (61). In this way, a core structure of LED light bulb is formed, and finally the transparent insulated heat conduction fluid is injected into the inner cover (61) as Fig.15 shown, the pressure relief hole (61.1) and the pressure relief membrane (61.2) used to seal are provided on the concave inner cover (61). Both the structures of Fig.13 and Fig.15 are the plan of preparing the transitional epitaxial layer on the light engine plate directly.

Fig. 23 is an illustration of LED light bulb manufactured by the present invention (assembled by medium-sized light engine module), the light distribution optical lens (7) is provided around a periphery of the concave inner cover (61), in this way, the light distribution optical lens (7) is fixed on the heat conduction support (3) by the inner snap ring (81) and the lens snap ring (8); the fixed screw of light bulb (105) is used for fixing the light bulb when assembling.

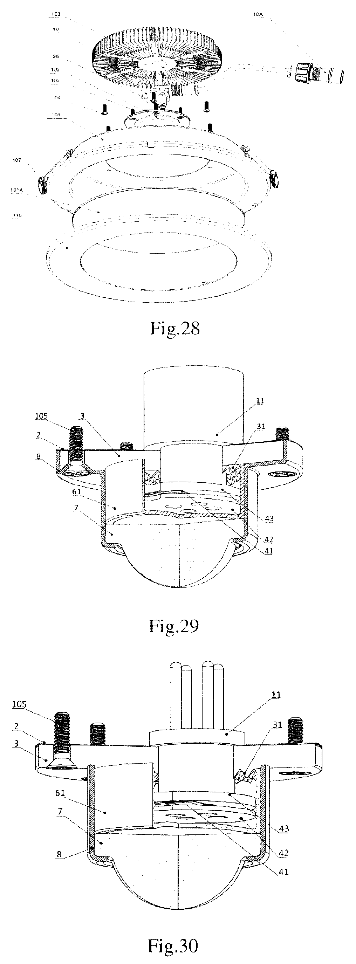

Fig.28 is an illustration of LED light bulb manufactured by the method of the present invention used on down lamps, a electric connector female with flange (10) is fixed on the compressive radiator (103) by the fixed screw (25), the lampshade (101) is fixed on the compressive radiator (103) by the fixed screw (104), a transparent lampshade piece (101 A) is got stuck by a lampshade piece supporting cover (110), a light bulb (102) is fixed on the compressive radiator (103) by the fixed screw (105) and is connected with the electric connector female (10), then the lampshade piece supporting cover (110) is covered, thereby forming an LED down lamp. A spring fixing clip (107) is used in the assembly of down lamp.

Embodiment 2-3: A light engine module of LED light bulb, comprising preparing the thin epitaxial wafer (46) formed by the transitional epitaxial layer on the existing substrate, putting the epitaxial wafer (46) into a reacting furnace to grow by layers to form an LED wafer and relevant circuits, and the epitaxial wafer (46) is soldered with relevant components, then conducting wire bonding to connect LED wafer and relevant components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer (46) is soldered with relevant components, then conducting wire bonding to connect the LED wafer and relevant components. The LED relevant components (41) are formed by the LED wafer, relevant circuits and relevant components; the transparent sealant (45) and/or the transparent cover plate (42) are used to cover the LED relevant components (41), and only the correlated bonding pad of the LED relevant components (41) is shown. The methods of covering LED relevant components by transparent sealant (45) and/or transparent cover plate (42) are as follows: filling in a little transparent sealant between LED relevant components (41) to level, and forming the transparent sealant between the surface of LED wafer and the transparent cover plate as little possible, then covering the transparent cover plate (42) whose profile is the same with that of light engine plate (43) on LED relevant components, besides, opening area is provided on transparent cover plate (42) to show the bonding pad, as Fig. 17 shown; or filling in a little transparent sealant between LED relevant components (41) to level, and forming the transparent sealant between the surface of LED wafer and the transparent cover plate(42) as little as possible, then covering the transparent cover plate (42) whose profile is smaller than that of light engine plate (43) on LED relevant components (41), then the transparent sealant (45) is wrapped around transparent cover plate (42) to level the profile of transparent sealant (45) with that of light engine plate (43), opening area is provided on transparent cover plate (42) to show the bonding pad, as Fig. 18 shown; or the LED relevant components (41) is wrapped up with the transparent sealant (45) directly to level the profile of transparent sealant (45) with that of light engine plate (43), opening area is provided on transparent cover plate (42) to show the bonding pad and fix holes, as Fig.16 shown.

As Fig. 19 shown, the light engine plate (43) is circular plate, both sides of the circular plate is provided with two symmetrical gaps, each gap is formed by cutting a string along the circle the circular plate, moreover, both ends of the string tilt outwards to 120 degrees and transit to the circle of the circular plate by circular arc; the shape is to cut both sides of the circle according to the diameter of d_{G}, the symmetry of X axis, the length of I_{G}, the string length of w_{G}, the ends of the string tilt outwards to 120 degrees, and it is transited to the diameter d_{G} with the arc of R= 1.0mm, thereby forming the gaps, when the light engine module is used for the plan of liquid-cooling method, the heated transparent insulated heat conduction fluid can conduct thermal cycle from gaps. As Fig.18 shown, the circle diameter d_{G} of the circular plate is 20mm 38mm or 50mm; if the length between the gap subtract the outward tilting part, the length is 10mm, the radius of circular arc used for transition is 1 mm, the two corresponding strings of two gaps are parallel to each other; when it is 20mm, the distance between two strings is 15mm; when it is 38mm, the distance between two strings is 33mm when it is 50mm, the distance two strings is 45mm;The bonding pad is located at the inner side of the gaps of circular plate, each pad is disposed on the inner side of two gaps or that of one gap respectively, the electric connector (11) is connected with the bonding pad through the flexible built-up circuit (44).

The phosphor and protective layer are coated on the transparent cover plate (42) and /or the light engine plate (43); or the transparent cover plate (42) and /or the light engine plate (43) are molded transparent fluorophor. Transparent fluorophor is prepared by the fluorescent materials and transparent materials according to the weight ratio of 1:10. There are two fixed holes provided on the light engine module (43), the two fixed holes are symmetric around the center circular plate with a distance of dG-6, the diameter of fixed holes is 2.2mm; the link of two fixed holes is orthogonal with that of gaps center, as Fig.19 shown; when the diameter d_{G} = 20mm, a fixed hole of one side need to be opened.

The method of light engine module of the present invention to assemble the LED light bulb is as follows: the opening is provided on the heat conduction support (3), the electric connector (11) is fixed on the heat conduction support (3) after inserting the opening and through the fixed end (15), the electric connector (11) is soldered with the bonding pad on the LED relevant components (41), the light engine module of LED light bulb is disposed at the confined space between the heat conduction support (3) and the concave inner cover (61), steps are provided on the light engine module of LED light bulb, the light engine module is laid on the steps and fixed on the steps through the periphery of the light engine module, besides, the external diameter of light engine plate for the light engine module of LED light bulb is tightly closed to the inner diameter of the concave inner cover (61). The differences with embodiment 1 and embodiment are as follows, the connector, located at the periphery of the concave inner cover (61), is connected with the bonding pad of LED relevant components (41) in the concave inner cover (61) by the flexible built-up circuit (44), and finally the transparent insulated heat conduction fluid is injected into the inner cover (61), the pressure relief hole (61.1) and the pressure relief membrane (61.2) used to seal are provided on the concave inner cover (61), as Fig.20 shown, the structure is the plan of preparing the transitional epitaxial layer on the light engine plate directly.

Fig.24 is an illustration of LED light bulb manufactured by the present invention (assembled by large-sized light engine module), the light distribution optical lens (7) is provided around a periphery the concave inner cover (61), the lens snap ring (8) is fixed on the heat conduction support (3) by the inner snap ring (81) and the lens snap ring (8); the welding point of the flexible built-up circuit (44) and the electric connector (11) is covered by the inner ring cover (62) for decoration, the fixed screw of light bulb (105) is used for the light bulb when assembling.

Fig. 25 is an illustration of LED light bulb constructed by the light engine module and manufactured by the method of the present invention used on street lamps, the lampshade (101) and the driving power with lighting control (106) are fixed on the assembly interface board (103A) by the fixed screw, the light bulb (102) with radiator is fixed on the assembly interface board (103A) by the fixed screw, the light bulb (102) with nut waterproof connector male (10A) is connected with the driving power with lighting control (106), the assembly interface board (103A) is fixed on a lamp post (108) by the fixed screw.

Fig. 27 is an illustration of LED light bulb constructed by the light engine module manufactured by the method of the present invention used on tunnel lamps, the driving power with lighting control (106) is fixed on a radiator support (117) by the fixed screw, the radiator support (117) is fixed on the compressive radiator (103) by the fixed screw, the light bulb (102) is fixed on the compressive radiator (103) by the fixed screw, The waterproof connector female with nut (10A) on the light bulb (102) is connected with the driving power with lighting control (106), thereby forming the tunnel lamp.

The following seven specifications of the light engine module are realized by above three embodiments, which can meet a majority of lighting requirements.

| Types of the module | d_{G}/mm | I_{G}/mm | w_{G}/mm | h_{G}/mm | notes |
|---|---|---|---|---|---|
| Embodiment 1 | 11 | 13 | 3.2 | 0.6-3.0 (it is for reference, not a compulsive demand) | |
| | 16 | 19 | 3.6 | | |
| Embodiment 2 | 18 | 16 | 8.2 | | |
| | 25 | 23 | 9.8 | | |
| Embodiment 3 | 20 | 15 | 10.0 | | |
| | 38 | 33 | 10.0 | | |
| | 50 | 45 | 10.0 | | |

The mark of figures in the embodiments 3-1, 3-2 and 3-3 is respectively: (2)-heat conduction pad, (3)-heat conduction support, (4)-light engine module, (7)-light distribution optical lens, (8)-lens snap ring, (10)-electric connector female with flange, (10A) -waterproof connector male with nut, (11)-electric connector, (15)-fixed end, (16)-waterproof rubber ring, (25)-fixed screw of connector female, (31)-reflector, (41)-LED relevant components, (42)-transparent cover plate, (43)-light engine plate, (44)-flexible built-up circuit, (45)-transparent sealant, (61)-concave inner cover of light bulb, (61.1)-pressure relief hole, (61.2)-pressure relief membrane, (62)-inner ring cover, (81)-inner snap ring, (101)-lampshade, (101A)-lampshade piece, (102)-LED light bulb, (103)- compressive radiator, (103A)-assembly interface board, (104)-fixed screw, (105)-fixed screw of light bulb, (106)-driving power with lighting control, (107)- spring fixing clip, (108)-lamp post, (110)- supporting cover of lampshade piece, (117)-radiator support, (118)-steering fixed screw, (431)-alignment pin.

Embodiment 3-1: A light engine module used for small-sized LED light bulb, comprising preparing the thin epitaxial wafer (46) formed by the transitional epitaxial layer on the existing LED substrate, putting the epitaxial wafer (46) into a reacting furnace to grow by layers to form an LED wafer and relevant circuits at the specific position, the LED wafer will not be cut after the completion of the growth, and the epitaxial wafer (46) is soldered with relevant components after the LED wafer passes inspection, then conducting wire bonding to connect LED wafer and relevant components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits at specific position; and the LED wafer will not be cut after the completion of the growth, the epitaxial wafer (46) is soldered with relevant components after the LED wafer passes inspection, then conducting wire bonding to connect the LED wafer and relevant components. The LED relevant components (41) are formed by the LED wafer, relevant circuits and relevant components; the transparent sealant (45) and/or the transparent cover plate (42) are used to cover the LED relevant components (41), and only the correlated bonding pad of the LED relevant components (41) is shown. The methods of covering LED relevant components by transparent sealant (45) and /or transparent cover plate (42) are as follows as Fig.2 and Fig.3 shown: filling in a little transparent sealant between LED relevant components (41) to level, and forming the transparent sealant between the surface of LED wafer and the transparent cover plate as little as possible, then covering the transparent cover plate (42) whose profile is the same with that of light engine plate (43) on LED relevant components, besides, opening area is provided on transparent cover plate (42) to show the bonding pad; or as Fig.5 and Fig.6 shown, filling in a little transparent sealant between LED relevant components (41) to level, and forming the transparent sealant between the surface of LED wafer and the transparent cover plate as little as possible, then covering the transparent cover plate (42) whose profile is smaller than that of light engine plate on LED relevant components (41), then the transparent sealant (45) is wrapped around the transparent cover plate (42) to level the profile of transparent sealant (45) with that of the light engine plate (43), opening area is provided on the transparent cover plate (42) to show the bonding pad; or as Fig. 4 shown, the LED relevant components (41) are wrapped up with the transparent sealant (45) directly to level the profile of transparent sealant (45) with that of light engine plate (43), opening area is provided on transparent cover plate (42) to show the bonding pad.

The phosphor and protective layer are coated on the transparent cover plate (42) and /or the light engine plate (43); or the transparent cover plate (42) and /or the light engine plate (43) are molded transparent fluorophor. Transparent fluorophor is prepared by the fluorescent materials and transparent materials according to the weight ratio of 5-30:100.

As Fig.7 shown, the light engine plate (43) is circular plate, two inner arc gaps are provided symmetrically on both sides of the circular plate, the center of gaps is at the concentric circle of the periphery of the circular plate, the cutting way is to cut both sides of the circle according to the diameter of d_{G}, the symmetry of X axis, the length of I_{G}, the radius of R, and the string length of w_{G}, thereby forming two circle gaps whose radius is R. when the light engine module is used for the plan of liquid-cooling method, the heated transparent insulated heat conduction fluid can conduct thermal cycle from gaps; circle holes used for the connection with the contact pin of the electric connector (11) are further provided on the light engine plate (43), there are four circle holes whose diameter is 1.4mm distributed symmetrically utilizing the 2mm position of X axis of the light engine plate (43) as the center with the spacing of 3.5mm; the bonding pad, located at the position of the circle hole, is on the LED relevant components (41), the contact pin of the electric connector (11) is soldered with the bonding pad after inserting into the circle hole, as Fig. 7 shown, there are four circle holes connected with the contact pin of the electric connector 11, and they are distributed symmetrically with an equal distance of 3.5mm, the center of four circle holes is located at a distance of 2mm with the center of the circular plate, moreover, the center of four circle holes is the same distance with the two gaps. That is, there are four circle holes whose diameter is 1.4mm distributed symmetrically utilizing the 2mm position of X axis of the light engine plate (43) as the center with the spacing of 3.5mmThe circle diameter d_{G} of the circular plate is 11 mm or 16mm; when it is 11 mm, the center two circular arc gaps is in the circle whose diameter d_{G} is 13mm, the radius of two circular arc gaps is 3.2mm; when it is 16 mm, the center of two circular arc gaps is in the circle whose diameter is 19mm, the radius of two circular arc gaps is 3.6mm

The light engine module of LED light bulb of the present invention is as follows: passing through the heat conduction support (3), the electric connector (11) is soldered with the heat conduction support (3),, the contact pin of the electric connector (11) is soldered with the bonding pad on the LED relevant components (41) after inserting the circle hole of the light engine plate (43), the concave inner cover (61) is provided around a periphery of the light engine module of LED light bulb, finally, the light engine module of LED light bulb is disposed at the confined space between the heat conduction support (3) and the concave inner cover (61), the external diameter of light engine plate for the light engine module of LED light bulb is tightly closed to the inner diameter of the inner cover (61). In this way, a core structure of LED light bulb is formed, and finally the transparent insulated heat conduction fluid is injected into the inner cover (61) as Fig. 9 shown, the pressure relief hole (61.1) and the pressure relief membrane (61.2) used to seal are provided on the concave inner cover (61). Both the structures of Fig.8 and Fig.9 are the plan of preparing the transitional epitaxial layer on the light engine plate directly.

Embodiment 3-: A light engine module used for medium-sized LED light bulb, comprising preparing the thin epitaxial wafer (46) formed by the transitional epitaxial layer on the existing LED substrate, putting the epitaxial wafer (46) into a reacting furnace to grow by layers to form an LED wafer and relevant circuits at the specific position, the LED wafer will not be cut after the completion of the growth, and the epitaxial wafer (46) is soldered with relevant components after the LED wafer passes inspection, then conducting wire bonding to connect LED wafer and relevant components. The LED relevant components (41) are formed by relevant circuits and relevant components. The epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to an LED wafer and relevant circuits at specific position; and the LED wafer will not be cut after the completion of the growth, the epitaxial wafer (46) is soldered with relevant components after the LED wafer passes inspection, then conducting wire bonding to connect the LED wafer and relevant components. The LED relevant components (41) are formed by the LED wafer, relevant circuits and relevant components; the transparent sealant (45) and/or the transparent cover plate (42) are used to cover the LED relevant components (41), and only the correlated bonding pad of the LED relevant components (41) is shown. The methods of covering LED relevant components by transparent sealant (45) and/or transparent cover plate (42) are as follows : filling in a little transparent sealant between LED relevant components (41) to level, and forming the transparent sealant between the surface of LED wafer and the transparent cover plate as little as possible, then covering the transparent cover plate (42) whose profile is the same with that of light engine plate (43) on LED relevant components, besides, opening area is provided on transparent cover plate (42) to show the bonding pad, as Fig.11 shown; or filling in a little transparent sealant between LED relevant components (41) to level, and forming the transparent sealant between the surface of LED wafer and the transparent cover plate (42) as little as possible, then covering the transparent cover plate (42) whose profile is smaller than that of light engine plate (43) on LED relevant components (41), then the transparent sealant (45) is wrapped around transparent cover plate (42) to level the profile of transparent sealant (45) with that of light engine plate (43), opening area is provided on transparent cover plate (42) to show the bonding pad, as Fig. 12 shown; or as Fig.10 shown, the LED relevant components (41) is wrapped up with the transparent sealant (45) directly to level the profile of transparent sealant (45) with that of light engine plate (43), opening area is provided on transparent cover plate (42) to show the bonding pad. The phosphor and protective layer are coated on the transparent cover plate (42) and /or the light engine plate (43); or the transparent cover plate (42) and /or the light engine plate (43) are molded transparent fluorophor. Transparent fluorophor is prepared by the fluorescent materials and transparent materials according to the weight ratio of 5~30:100.

As Fig. 14 shown, the light engine plate (43) is circular plate, two symmetrical gaps are formed by removing the two bow shapes of the circle on both sides of the circular plate symmetrically; the circle hole with alignment pin is provided on the light engine plate (43), the circle hole is used for the alignment connection with the electric connector (11); the gaps are formed by cutting the both sides of the circle utilizing the d_{G} as diameter, the symmetry of X axis, the length of I_{G}, and the string length of w_{G}, when the light engine module is used for the plan of liquid-cooling method, the heated transparent insulated heat conduction fluid can conduct thermal cycle from gaps, as Fig. 15 shown. The circle utilizing the 2mm position of X axis of the light engine plate (43) as the center and 8mm as the diameter is opened, the alignment pin (431) of the electric connector (11) is provided on the circle, as Fig.13 shown; the flexible built-up circuit (44) is soldered with the connection point of the LED relevant components (41). The circle diameter of the circular plate is 18mm or 25mm When it is 18mm, the string length of the removed two bow shape is 8.2mm, and the distance between two strings is 16mm; when it is 25mm, the string length of the removed two bow shape is 9.8mm, and the distance between two strings is 23mm; wherein the diameter of circle hole with alignment pin is 8mm, the center of which is located at a distance of 2mm with the center of the circular plate, and the center of circle hole is the same distance with the two gaps, that is, the circle utilizing the 2mm position of X axis of the light engine plate (43) as the center and 8mm as the diameter is opened, the alignment pin (431) of the electric connector (11) is provided on the circle. The bonding pad is disposed at the position of circle center by LED relevant components (41) through the flexible built-up circuit (44), the electric connector (11) is soldered with the bonding pad after inserting into circle hole, as Fig. 13 shown.

The light engine module of LED light bulb of the present invention is assembled as follows: the electric connector (11) is fixed on the heat conduction support (3) by the fixed end (15), the electric connector (11) is soldered with the bonding pad on the flexible built-up circuit (44) after inserting the circle hole with alignment pin of the light engine plate (43), the concave inner cover (61) is provided around a periphery of the light engine module of LED light bulb, finally, the light engine module of LED light bulb is disposed at the confined space between the heat conduction support (3) and the concave inner cover (61), the external diameter of light engine plate (43) for the light engine module of LED light bulb is tightly closed to the inner diameter of the inner cover (61). In this way, a core structure of LED light bulb is formed, and finally the transparent insulated heat conduction fluid is injected into the inner cover (61) as Fig.15 shown, the pressure relief hole (61.1) and the pressure relief membrane (61.2) used to seal are provided on the concave inner cover (61). Both the structures of Fig.13 and Fig.15 are the plan of preparing the transitional epitaxial layer on the light engine plate directly.

Embodiment 3-3: A light engine module of LED light bulb, comprising preparing the thin epitaxial wafer (46) formed by the transitional epitaxial layer on the existing substrate, putting the epitaxial wafer (46) into a reacting furnace to grow by layers to form an LED wafer and relevant circuits, and the epitaxial wafer (46) is soldered with relevant components, then conducting wire bonding to connect LED wafer and relevant components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer (46) is soldered with relevant components, then conducting wire bonding to connect the LED wafer and relevant components. The LED relevant components (41) are formed by the LED wafer, relevant circuits and relevant components; the transparent sealant (45) and/or the transparent cover plate (42) are used to cover the LED relevant components (41), and only the correlated bonding pad of the LED relevant components (41) is shown. The methods of covering LED relevant components by transparent sealant (45) and/or transparent cover plate (42) are as follows: filling in a little transparent sealant between LED relevant components (41) to level, and forming the transparent sealant between the surface of LED wafer and the transparent cover plate as little possible, then covering the transparent cover plate (42) whose profile is the same with that of light engine plate (43) on LED relevant components, besides, opening area is provided on transparent cover plate (42) to show the bonding pad, as Fig. 17 shown; or filling in a little transparent sealant between LED relevant components (41) to level, and forming the transparent sealant between the surface of LED wafer and the transparent cover plate(42) as little as possible, then covering the transparent cover plate (42) whose profile is smaller than that of light engine plate (43) on LED relevant components (41), then the transparent sealant (45) is wrapped around transparent cover plate (42) to level the profile of transparent sealant (45) with that of light engine plate (43), opening area is provided on transparent cover plate (42) to show the bonding pad, as Fig. 17 shown; or the LED relevant components (41) is wrapped up with the transparent sealant (45) directly to level the profile of transparent sealant (45) with that of light engine plate (43), opening area is provided on transparent cover plate (42) to show the bonding pad and fix holes, as Fig. 16 shown.

As Fig. 19 shown, the light engine plate (43) is circular plate, both sides of the circular plate is provided with two symmetrical gaps, each gap is formed by cutting a string along the circle the circular plate, moreover, both ends of the string tilt outwards to 120 degrees and transit to the circle of the circular plate by circular arc; the shape is to cut both sides of the circle according to the diameter of d_{G}, the symmetry of X axis, the length of I_{G}, the string length of w_{G}, the ends of the string tilt outwards to 120 degrees, and it is transited to the diameter d_{G} with the arc of R= 1.0mm, thereby forming the gaps, when the light engine module is used for the plan of liquid-cooling method, the heated transparent insulated heat conduction fluid can conduct thermal cycle from gaps. As Fig. 19 shown, the circle diameter d_{G} of the circular plate is 20mm, 38mm or 50mm; if the length between the gap subtract the outward tilting part, the length is 10mm, the radius of circular arc used for transition is 1 mm, the two corresponding strings of two gaps are parallel to each other; when it is 20mm, the distance between two strings is 15mm; when it is 38mm, the distance between two strings is 33mm when it is 50mm, the distance two strings is 45mm;The bonding pad is located at the inner side of the gaps of circular plate, each pad is disposed on the inner side of two gaps or that of one gap respectively, the electric connector (11) is connected with the bonding pad through the flexible built-up circuit (44).

The phosphor and protective layer are coated on the transparent cover plate (42) and /or the light engine plate (43); or the transparent cover plate (42) and /or the light engine plate (43) are molded transparent fluorophor. Transparent fluorophor is prepared by the fluorescent materials and transparent materials according to the weight ratio of 5~30:100.There are two fixed holes provided on the light engine module (43), the two fixed holes are symmetric around the center circular plate with a distance of dG-6, the diameter of fixed holes is 2.2mm; the link of two fixed holes is orthogonal with that of gaps center, as Fig.18 shown; when the diameter d_{G}= 20mm, a fixed hole of one side need to be opened.

The light engine module of LED light bulb of the present invention is assembled as follows: the opening is provided on the heat conduction support (3), the electric connector (11) is fixed on the heat conduction support (3) after inserting the opening and through the fixed end (15), the electric connector (11) is soldered with the bonding pad on the LED relevant components (41), the light engine module of LED light bulb is disposed at the confined space between the heat conduction support (3) and the concave inner cover (61), steps are provided on the light engine module of LED light bulb, the light engine module is laid on the steps and fixed on the steps through the periphery of the light engine module, besides, the external diameter of light engine plate for the light engine module of LED light bulb is tightly closed to the inner diameter of the concave inner cover (61). The differences with embodiment 1 and embodiment are as follows, the connector, located at the periphery of the concave inner cover (61), is connected with the bonding pad of LED relevant components (41) in the concave inner cover (61) by the flexible built-up circuit (44), and finally the transparent insulated heat conduction fluid is injected into the inner cover (61), the pressure relief hole (61.1) and the pressure relief membrane (61.2) used to seal are provided on the concave inner cover (61), as Fig.20 shown, the structure is the plan of preparing the transitional epitaxial layer on the light engine plate directly.

The following seven specifications of the light engine module are realized by above three embodiments, which can meet a majority of lighting requirements.

| Types of the module | d_{G}/mm | l_{G}/mm | w_{G}/mm | h_{G}/mm | notes |
|---|---|---|---|---|---|
| Embodiment 1 | 11 | 13 | 3.2 | 0.6-3.0 (it is for reference, not a compulsive demand) | |
| | 16 | 19 | 3.6 | | |
| Embodiment 2 | 18 | 16 | 8.2 | | |
| | 25 | 23 | 9.8 | | |
| | 20 | 15 | 10.0 | | |
| Embodiment 3 | 38 | 33 | 10.0 | | |
| | 50 | 45 | 10.0 | | |

The light principle of the present invention is as Fig.21 shown.

The mark of figures in the embodiments 3-1, 3-2 and 3-3 is respectively: (2)-heat conduction pad, (3)-heat conduction support, (4)-light engine module, (7)-light distribution optical lens, (8)-lens snap ring, (11)-electric connector, (15)-fixed end, 16-waterproof rubber ring, (31)-reflector, (41)-LED relevant components, (42)-transparent cover plate, (43)-light engine plate, (44)-flexible built-up circuit, (45)-transparent sealant, (46)-epitaxial wafer, (61)-concave inner cover of light bulb, (61.1)-pressure relief hole, (61.2)-pressure relief membrane, (81)-inner snap ring, (105)-fixed screw of light bulb, (431)-alignment pin.

Embodiment 4-1: A liquid-cooling method of small LED light bulb as Fig.29 shown, it comprises a heat conduction support (3), passing through the heat conduction support (3), the electric connector (11) is bonded on the heat conduction support (3), the contact pin (17) on the top end of the electric connector (11) is soldered with the light engine module (4) after aligning the position and inserting from four holes of the backside of the light engine module (4);moreover, the inner cover (61) is provided around a periphery of the light engine module (4), the inner cover (61) is bonded in the inserting recess (61.3) of the heat conduction support (3), a confined space is formed between the heat conduction support (3) and the light engine module (4), and the confined space is filled with transparent insulated heat conduction , the light engine module (4) is immersed into the transparent insulated heat conduction fluid, the reflector (31) is provided on the surface of the covered part of the heat conduction support (3) by the inner cover (61). The lens snap ring (8) is provided on the heat conduction support (3), the edge of the heat conduction support (3) is wrapped up with the lens snap ring (8), six uniformly distributed flange holes are provided on the edge of the heat conduction support (3) as fixed holes of light bulb, the corresponding fixed holes of light bulb are also provided on the lens snap ring (8), the fixed screw (105) is provided in the fixed hole of the light bulb to fix the light bulb, forming a basic support structure for light bulb; the lens (7) is provided at the bottom of the lens snap ring (8), and the lens (7) is connected with the inner cover (61) through bonding; the heat conduction pad (2) is provided on the surface of the heat conduction support (3).

Embodiment 4-2: A liquid-cooling method of small LED light bulb as Fig. 30 shown, it comprises a heat conduction support (3), passing through the heat conduction support (3), the electric connector (11) is bonded on the heat conduction support (3), the contact pin (17) on the top end of the electric connector (11) is soldered with the light engine module (4) after aligning the position and inserting from four holes of the backside of the light engine module (4); moreover, the inner cover (61) is provided around a periphery of the light engine module (4), the inner cover (61) is bonded in the inserting recess (61.3) of the heat conduction support (3), a confined space is formed between the heat conduction support (3) and the light engine module (4), and the confined space is filled with transparent insulated heat conduction, the light engine module (4) is immersed into the transparent insulated heat conduction fluid, the reflector (31) is provided on the surface of the covered part of the heat conduction support (3) by the inner cover (61). Six uniformly distributed flange holes are provided on the heat conduction support (3) as fixed holes of light bulb, the light bulb is fixed by the fixed screw (105), thereby forming a basic support structure of light bulb; the heat conduction pad (2) is provided on the surface of the heat conduction support (3); wherein the bottom of the inner cover (61) is bonded with the lens; the lens snap ring (8) is provided around a periphery of the inner cover (61), in this way, the lens (7) will be got stuck.

Embodiment 4- 3: A liquid-cooling method of small LED light bulb as Fig. 31 shown, it comprises a heat conduction support (3), passing through the heat conduction support (3), the electric connector (11) is bonded on the heat conduction support (3), the contact pin (17) on the top end of the electric connector (11) is soldered with the light engine module (4) after aligning the position and inserting from four holes of the backside of the light engine module (4); moreover, the inner cover (61) is provided around a periphery of the light engine module (4), the inner cover (61) is bonded in the inserting recess (61.3) of the heat conduction support (3), a confined space is formed between the heat conduction support (3) and the light engine module (4), and the confined space is filled with transparent insulated heat conduction, the light engine module (4) is immersed into the transparent insulated heat conduction fluid, the reflector (31) is provided on the surface of the covered part of the heat conduction support (3) by the inner cover (61). The heat conduction support (3) is fixed on the inner cover (61) by bonding, forming a basic support structure of light bulb; the heat conduction pad (2) is provided on the surface of the heat conduction support (3); wherein the bottom of the inner cover (61) is bonded with the lens (7); the lens snap ring (8) is provided around a periphery of the inner cover (61), in this way, the lens (7) will be got stuck, and the lens snap (8) is connected with the periphery of the inner cover (61) and the heat conduction support (3) by bonding, six uniformly distributed flange holes are provided on the heat conduction support (3) as fixed holes of light bulb, the light bulb is fixed by the fixed screw of light bulb (105).

In the embodiment 4-1, 4-2 and 4-3, the light engine module (4) comprises the light engine plate (43); wherein the light engine plate (43) is preparing the thin epitaxial wafer (46) formed by the transitional epitaxial layer on the existing LED substrate, putting the epitaxial wafer (46) into a reacting furnace to grow by layers to form an LED wafer and relevant circuits, the LED wafer will not cut after the completion of the growth; and die bonding relevant components and conducting wire bonding to connect the wafer driving chip and other components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer is soldered with relevant components, then conducting wire bonding to connect the LED wafer and relevant components. The LED relevant components (41) are formed by the LED wafer, relevant circuits and relevant components; or the light engine plate (43) is transparent material substrate, utilizing the existing wafer, fitting, printing, die bonding, wire bonding other technologies to realize LED wafer, relevant circuits and relevant components on the light engine plate (43). The LED relevant components (41) are formed by the LED wafer, relevant circuits and relevant components, the transparent sealant (45) and/or the transparent cover plate (42) are utilized on the LED relevant components (41) to cover, and only the correlated bonding pad on the LED relevant components (41) is shown; the methods of covering LED relevant components by transparent sealant (45) and /or transparent cover plate (42) are as follows as Fig.2 and Fig.3 shown: filling in a little transparent sealant between LED relevant components (41) to level, and forming the transparent sealant (45) between the surface of LED wafer and the transparent cover plate (42) as little as possible, then covering the transparent cover plate (42) whose profile is the same with that of light engine plate (43) on LED relevant components, besides, opening area is provided on transparent cover plate (42) to show the bonding pad; or as Fig.5 and Fig.6 shown, filling in a little transparent sealant (45) between LED relevant components (41) to level, and forming the transparent sealant (45) between the surface of LED wafer and the transparent cover plate (42) as little as possible, then covering the transparent cover plate (42) whose profile is smaller than of light engine plate on LED relevant components (41), then the transparent sealant (45) is wrapped around transparent cover plate to level the profile of transparent sealant (45) with that of light engine plate (43), opening area is provided on transparent cover plate (42) to show the bonding pad; or the transparent sealant 45 is wrapped around transparent cover plate directly to level the profile of transparent sealant with that of light engine plate (43), opening area is provided on transparent cover plate (42) to show the bonding pad.

The lens (7) can be replaced by the outer cover (9), if the outer cover (9) is used in the light bulb, the outer cover (9) need to be bonding disposed around a periphery of the inner cover (61) or the lens snap ring (8) as Fig.32 shown.

The phosphor and protective layer are coated on the transparent cover plate (42), or the transparent cover plate (42) is molded transparent fluorophor. Transparent fluorophor is prepared by the fluorescent materials and transparent materials according to the weight ratio of 5~30:100.

The concave part can be protruded to the outside to increase the volume to accommodate the inflated volume of the transparent insulated heat conduction fluid, preventing the failure of the sealing due to the swelling of transparent insulated heat conduction fluid; the phosphor and protective layer are coated on the surface of the inner cover (61); or the inner cover (61) is molded transparent fluorophor. Transparent fluorophor is prepared by the fluorescent materials and transparent materials according to the weight ratio of 5~30:100.

As Fig.7 shown, the light engine plate (43) is circular plate, two inner arc gaps are provided symmetrically on both sides of the circular plate, the center of gaps is at the concentric circle of the periphery of the circular plate, the cutting way is to cut both sides of the circle according to the diameter of d_{G}, the symmetry of X axis , the length of I_{G}, the radius of R, and the string length of w_{G}, thereby forming two circle gaps whose radius is R. when the light engine module is used for the plan of liquid-cooling method, the heated transparent insulated heat conduction fluid can conduct thermal cycle from gaps; circle holes used for the connection with the contact pin of the electric connector (11) are further provided on the light engine plate (43), there are four circle holes whose diameter is 1.4mm distributed symmetrically utilizing the 2mm position of X axis of the light engine plate (43) as the center with the spacing of 3.5mm; the bonding pad, located at the position of the circle hole, is on the LED relevant components (41), the contact pin of the electric connector (11) is soldered with the bonding pad after inserting into the circle hole, as Fig.8 shown. there are four circle holes connected with the contact pin of the electric connector (11), and they are distributed symmetrically with an equal distance of 3.5mm, the center of four circle holes is located at a distance of 2mm with the center of the circular plate, moreover, the center of four circle holes is the same distance with the two gaps. That is, there are four circle holes whose diameter is 1.4mm distributed symmetrically utilizing the 2mm position of X axis of the light engine plate (43) as the center with the spacing of 3.5mm.

The connection between the light engine module and the electric connector is as Fig.8 shown, passing through the heat conduction support (3), the electric connector (11) is bonded with the heat conduction support (3), the contact pin of the electric connector (11) is soldered with the bonding pad on the LED relevant components (41) after inserting the circle hole of the light engine plate (43), the concave inner cover (61) is provided around a periphery of small-sized LED light bulb with liquid-cooling method, finally, the liquid-cooling method of small-sized LED light bulb is disposed at the confined space between the heat conduction support (3) and the concave inner cover (61), the external diameter of light engine plate for the liquid-cooling method of small-sized LED light bulb is tightly closed to the inner diameter of the inner cover (61). In this way, a core structure of LED light bulb is formed, and finally the transparent insulated heat conduction fluid is injected into the inner cover (61) as Fig.34 shown, the pressure relief hole (61.1) and the pressure relief membrane (61.2) used to seal are provided on the concave inner cover (61).

The thermal cycle of the present invention is as Fig.33 shown.

The following two specifications of the light engine module are realized by above three embodiments.

| d _{G}/mm | l _{G}/mm | w _{G}/mm | h _{G}/mm | notes |
|---|---|---|---|---|
| 11 | 13 | 3.2 | 0.6-3.0 (it is for reference, not a compulsive demand) | |
| 16 | 19 | 3.6 | | |

The mark of figures of three embodiments is respectively: (2)-heat conduction pad, (3)-heat conduction support, (4)-light engine module, (7)-lens, (8)-lens snap ring, (9) -outer cover, (11)-electric connector, (17)-contact pin, (31)-reflector, (41)-LED relevant components, (42)-transparent cover plate, (43)-light engine plate, (45)-transparent sealant, (46)-chip substrate, (61)-inner cover, (61.1)-pressure relief hole, (61.2)-pressure relief membrane, (61.3)-inserting recess, (81)-inner snap ring, (105)-fixed screw of light bulb.

Embodiment 5-1: A liquid-cooling method of medium-sized LED light bulb, as Fig. 35 shown, it comprises a heat conduction support (3), passing through the heat conduction support (3), the electric connector (11) is inserting the center hole of the light engine module (4) exactly and the electric connector (11) is soldered with the contact pin (17) of the electric connector (11) by the flexible built-up circuit (44); moreover, the inner cover (61) is provided around a periphery of the light engine module (4), the inner cover (61) is bonded in the inserting recess (61.3) of the heat conduction support (3), a confined space is formed between the heat conduction support (3) and the light engine module (4), and the confined space is filled with transparent insulated heat conduction, the light engine module (4) is immersed into the transparent insulated heat conduction fluid, the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected through the pressure relief hole (61.1); when the temperature of the inner cover (61) is anormal, the fluid will break through the pressure relief membrane and leak out of the pressure relief hole (61.1), preventing the expansion of accident. Six uniformly distributed flange holes are provided on the heat conduction support (3) as fixed holes of light bulb, the light bulb is fixed by the fixed screw of light bulb (105), the support bushing (5) is riveted to the below of the heat conduction support (3), the basic support structure of light bulb is formed by the heat conduction support (3) and the support bushing (5); the heat conduction pad (2) is provided on the heat conduction support (3); the lens (7) is bonded with the below of the support bushing (5), a confined space is formed between the heat conduction support (3), the support bushing (5) and the lens (7) (the heat conduction support (3) and the lens (7) are the top and bottom surfaces and the support bushing (5) is the side), the confined space is provided with the light engine plate (4) and the inner cover (61), passing through the heat conduction support (3), the electric connector (11) is fixed on the heat conduction support (3) through the fixed end (15), and the electric connector (11) is connected with the light engine module (4) through the flexible built-up circuit (44); the inner cover (61) is provided around a periphery of the light engine module (4); the lens snap ring (8) is provided around a periphery of the support bushing, in this way, the lens (7) will be got stuck, the lens snap ring(8) is fixed on the support bushing (5) through the fixed screw (14), preventing lens accidental detachment.

Embodiment 5-2: A liquid-cooling method of medium-sized LED light bulb, as Fig. 36 shown, it comprises a heat conduction support (3), passing through the heat conduction support (3), the electric connector (11) is inserting the center hole of the light engine module (4) exactly and the electric connector (11) is soldered with the contact pin (17) of the electric connector (11) by the flexible built-up circuit (44); moreover, the inner cover (61) is provided around a periphery of the light engine module (4), the inner cover (61) is bonded in the inserting recess (61.3) of the heat conduction support (3), a confined space is formed between the heat conduction support (3) and the light engine module (4), and the confined space is filled with transparent insulated heat conduction, the light engine module (4) is immersed into the transparent insulated heat conduction fluid, the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected through the pressure relief hole (61.1); when the temperature of the inner cover (61) is anormal, the fluid will break through the pressure relief membrane and leak out of the pressure relief hole (61.1), preventing the expansion of accident. The lens snap ring (8) is provided on the heat conduction support (3), the edge of the heat conduction support (3) is wrapped up with the lens snap ring, six uniformly distributed flange holes are provided on the edge of the heat conduction support (3) as fixed holes of light bulb, the corresponding fixed holes of light bulb are also provided on the lens snap ring (8), the fixed screw is provided in the fixed hole of the light bulb to fix the light bulb, and the inner snap ring is provided below the heat conduction support (3), the inner snap ring (81) is connected with the heat conduction support (3) by bonding and fixed screw (12), a basic support structure of light bulb is formed by the lens snap ring (8), the heat conduction support (3) and the inner snap ring (81); the heat conduction pad (2) is provided on the heat conduction support (3); the lens (7) is connected with the inner snap ring (81) by bonding; a confined space is formed between the heat conduction support (3), the inner snap ring (81) and the lens (7) (the heat conduction support (3) and the lens (7) are the top and bottom surfaces and the inner snap ring (5) is the side), the inner cover (61) and the light engine module (4) are fixed therein; passing through the heat conduction support (3), the electric connector is fixed on the heat conduction support (3) by the fixed end (15), and the electric connector (11) is connected with the light engine module (4) through the flexible built-up circuit (44).

Embodiment 5-3: A liquid-cooling method of medium-sized LED light bulb, as Fig. 37 shown, it comprises a heat conduction support (3), passing through the heat conduction support (3), the electric connector (11) is inserting the center hole of the light engine module (4) exactly and the electric connector (11) is soldered with the contact pin (17) of the electric connector (11) by the flexible built-up circuit (44); moreover, the inner cover (61) is provided around a periphery of the light engine module (4), the inner cover (61) is bonded in the inserting recess (61.3) of the heat conduction support (3), a confined space is formed between the heat conduction support (3) and the light engine module (4), and the confined space is filled with transparent insulated heat conduction, the light engine module (4) is immersed into the transparent insulated heat conduction fluid, the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected through the pressure relief hole (61.1); when the temperature of the inner cover (61) is anormal, the fluid will break through the pressure relief membrane and leak out of the pressure relief hole (61.1), preventing the expansion of accident. Six uniformly distributed flange holes are provided on the heat conduction support (3) as fixed holes of light bulb, the light bulb is fixed by the fixed screw of light bulb (105), the inner snap ring (81) is connected with the heat conduction support (3) by bonding and fixed screw (12), thereby forming a basic support structure of light bulb; the heat conduction pad (2) is provided on the heat conduction support (3); the lens (7) is connected with the inner snap ring (81) by bonding; a confined space is formed between the heat conduction support (3), the inner snap ring (81) and the lens (7) (the heat conduction support (3) and the lens (7) are the top and bottom surfaces and the inner snap ring (5) is the side), the inner (61) and the light engine module (4) are fixed therein; passing through the heat conduction support (3), the electric connector is fixed on the heat conduction support (3) by the fixed end (15), and the electric connector (11) is connected with the light engine module (4) through the flexible built-up circuit (44).

Embodiment 5-4: A liquid-cooling method of medium-sized LED light bulb, as Fig. 38 shown, it comprises a heat conduction support (3), passing through the heat conduction support (3), the electric connector (11) is inserting the center hole of the light engine module (4) exactly and the electric connector (11) is soldered with the contact pin (17) of the electric connector (11) by the flexible built-up circuit (44); moreover, the inner cover (61) is provided around a periphery of the light engine module (4), the inner cover (61) is bonded in the inserting recess (61.3) of the heat conduction support (3), a confined space is formed between the heat conduction support (3) and the light engine module (4), and the confined space is filled with transparent insulated heat conduction, the light engine module (4) is immersed into the transparent insulated heat conduction fluid, the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected through the pressure relief hole (61.1); when the temperature of the inner cover (61) is anormal, the fluid will break through the pressure relief membrane and leak out of the pressure relief hole (61.1), preventing the expansion of accident. The heat conduction support (3) is fixed on the inner snap ring (81) by bonding, the lens (7) is connected with the inner snap ring (81) by bonding, thereby forming the basic support structure of light bulb. the heat conduction pad (2) is provided on the heat conduction support (3); the lens (7) is bonded with the inner snap ring (81) by bonding, a confined space is formed between the heat conduction support (3), the inner snap ring (5) and the lens (7) (the heat conduction support (3) and the lens (7) are the top and bottom surfaces and the inner snap ring (81) is the side), the inner cover (61) and the light engine module (4) are fixed therein, passing through the heat conduction support (3), the electric connector is fixed on the heat conduction support (3) through the fixed end (15), and the electric connector (11) is connected with the light engine module (4) through the flexible built-up circuit (44); the lens snap ring (8) is provided around a periphery of the inner snap ring (8), in this way, the lens (7) will be got stuck, the lens snap ring (8) is connected with the inner snap ring (81) by bonding, six uniformly distributed flange holes are disposed on the lens snap ring (81) as the fixed holes of light bulb, the light bulb is fixed through the fixed screw of light bulb (105).

Embodiment 5- 5: A liquid-cooling method of medium-sized LED light bulb, as Fig. 39 shown, it comprises a heat conduction support (3), passing through the heat conduction support (3), the electric connector (11) is inserting the center hole of the light engine module (4) exactly and the electric connector (11) is soldered with the contact pin (17) of the electric connector (11) by the flexible built-up circuit (44); moreover, the inner cover (61) is provided around a periphery of the light engine module (4), the inner cover (61) is bonded in the inserting recess (61.3) of the heat conduction support (3), a confined space is formed between the heat conduction support (3) and the light engine module (4), and the confined space is filled with transparent insulated heat conduction, the light engine module (4) is immersed into the transparent insulated heat conduction fluid, the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected through the pressure relief hole (61.1); when the temperature of the inner cover (61) is anormal, the fluid will break through the pressure relief membrane and leak out of the pressure relief hole (61.1), preventing the expansion of accident. The heat conduction support (3) is fixed in the lens (7) by bonding, thereby forming the basic support structure of light bulb. the heat conduction pad (2)is provided on the heat conduction support (3); a confined space is formed between the heat conduction support (3) and the lens (7), the light engine module are fixed therein, passing through the heat conduction support (3), the electric connector (11) is fixed on the heat conduction support (3) through the fixed end (15), and the electric connector (11) is connected with the light engine module (4) through the flexible built-up circuit (44); the lens snap ring (8) is provided around a periphery of the lens (7), in this way, the lens (7) will be got stuck, the lens snap ring (8) is connected with the lens (7) by bonding, six uniformly distributed flange holes are disposed on the lens snap ring (8) as the fixed holes of light bulb, the light bulb is fixed through the fixed screw (105) of light bulb.

In the embodiment 5-1, 5-2, 5-3, 5-4 and 5-5, the light engine module (4) comprises the light engine plate (43); wherein the light engine plate (43) is preparing the thin epitaxial wafer (46) formed by the transitional epitaxial layer on the existing LED substrate, putting the epitaxial wafer (46) into a reacting furnace to grow by layers to form an LED wafer and relevant circuits, the LED wafer will not cut after the completion of the growth; and die bonding relevant components and conducting wire bonding to connect the wafer driving chip and other components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer is soldered with relevant components, then conducting wire bonding to connect the LED wafer and relevant components. The LED relevant components (41) are formed by the LED wafer, relevant circuits and relevant components; or the light engine plate (43) is transparent material substrate, utilizing the existing wafer, fitting, printing, die bonding, wire bonding other technologies to realize LED wafer, relevant circuits and relevant components on the light engine plate (43). The LED relevant components (41) are formed by the LED wafer, relevant circuits and relevant components, the transparent sealant (45) and/or the transparent cover plate (42) are utilized on the LED relevant components (41) to cover, and only the correlated bonding pad on the LED relevant components (41) is shown; the methods of covering LED relevant components by transparent sealant (45) and /or transparent cover plate (42) are as follows as Fig.2 and Fig.3 shown: filling in a little transparent sealant between LED relevant components (41) to level, and forming the transparent sealant (45) between the surface of LED wafer and the transparent cover plate (42) as little as possible, then covering the transparent cover plate (42) whose profile is the same with that of light engine plate (43) on LED relevant components, besides, opening area is provided on transparent cover plate (42) to show the bonding pad; or as Fig.5 and Fig.6 shown, filling in a little transparent sealant (45) between LED relevant components (41) to level, and forming the transparent sealant (45) between the surface of LED wafer and the transparent cover plate (42) as little as possible, then covering the transparent cover plate (42) whose profile is smaller than of light engine plate on LED relevant components (41), then the transparent sealant (45) is wrapped around transparent cover plate to level the profile of transparent sealant (45) with that of light engine plate (43), opening area is provided on transparent cover plate (42) to show the bonding pad; or the transparent sealant 45 is wrapped around transparent cover plate directly to level the profile of transparent sealant with that of light engine plate (43), opening area is provided on transparent cover plate (42) to show the bonding pad.

The lens (7) can be replaced by the outer cover (9), if the outer cover (9) is used in the light bulb, the outer cover (9) need to be bonding disposed around a periphery of the inner cover (61) or the lens snap ring (8) as Fig. 40 shown; or the lens (7) can be replaced by the outer cover with lens-type interface (7.1) directly as Fig. 1E shown.

The phosphor and protective layer are coated on the transparent cover plate (42), or the transparent cover plate (42) is molded transparent fluorophor. Transparent fluorophor is prepared by the fluorescent materials and transparent materials according to the weight ratio of 5~30:100.

The concave part can be protruded to the outside to increase the volume to accommodate the inflated volume of the transparent insulated heat conduction fluid, preventing the failure of the sealing due to the swelling of transparent insulated heat conduction fluid; the phosphor and protective layer are coated on the surface of the inner cover (61); or the inner cover (61) is molded transparent fluorophor. Transparent fluorophor is prepared by the fluorescent materials and transparent materials according to the weight ratio of 5~30:100.

As Fig. 7 shown, the light engine plate (43) is circular plate, two symmetrical gaps are formed by removing the two bow shapes of the circle on both sides of the circular plate symmetrically; the circle hole with alignment pin is provided on the light engine plate (43), the circle hole is used the alignment connection with the electric connector (11); the gaps are formed by cutting the both sides of the circle utilizing the d_{G} as diameter, the symmetry of X axis, the length of I_{G}, and the string length of w_{G}, when the light engine module is used for the plan of liquid-cooling method, the heated transparent insulated heat conduction fluid can conduct thermal cycle from gaps, as Fig. 41 shown. The circle utilizing the 2mm position of X axis of the light engine plate (43) as the center and 8mm as the diameter is opened, the alignment pin (431) of the electric connector (11) is provided on the circle, as Fig.13 shown; the flexible built-up circuit (44) is soldered with the connection point of the LED relevant components (41). The circle diameter d_{G} of the circular plate is 18mm or 25mm; When it is 18mm, the string length of the removed two bow shape is 8.2mm and the distance between two strings is 16mm; when it is 25mm, the string length of the removed two bow shape is 9.8mm, and the distance between two strings is 23mm; wherein the diameter d_{G} of circle hole with alignment pin is 8mm the center of which is located at a distance of 2mm with the center of the circular plate, and the center of circle hole is the same distance with the two gaps, that is, the circle utilizing the 2mm position of X axis of the light engine plate (43) as the center and 8mm as the diameter is opened, the alignment pin (431) of the electric connector (11) is provided on the circle. The bonding pad is disposed at the position of circle center by LED relevant components (41) through the flexible built-up circuit (44), the electric connector (11) is soldered with the bonding pad after inserting into circle hole, as Fig. 8 shown.

The concave inner cover (61) is provided around a periphery of medium-sized LED light bulb with liquid-cooling method, finally, the liquid-cooling method of medium-sized LED light bulb is disposed at the confined space between the heat conduction support (3) and the concave inner cover (61), the external diameter of light engine plate for the liquid-cooling method of small-sized LED light bulb is tightly closed to the inner diameter of the inner cover (61). In this way, a core structure of LED light bulb is formed, and finally the transparent insulated heat conduction fluid is injected into the inner cover (61) as Fig. shown, the pressure relief hole (61.1) and the pressure relief membrane (61.2) used to seal are provided on the concave inner cover (61).

The thermal cycle of the present invention is as Fig. 41 shown.

The following two specifications of the light engine module are realized by above five embodiments.

| d _{G}/mm | l _{G}/mm | w_{G}/mm | h _{G}/mm | notes |
|---|---|---|---|---|
| 18 | 16 | 8.2 | 0.6-3.0 (it is for reference, not a compulsive demand) | |
| 25 | 23 | 9.8 | | |

The mark of figures of above embodiments is respectively: (2)-heat conduction pad, (3)-heat conduction support, (4)-light engine module, (5)-support bushing, (7)-lens, (7.1)-lens type interface outer cover, (8)-lens snap ring, (9) -outer cover, (11)-electric connector, (12)-fixed screw, 14-snap ring fixed screw,15-fixed end, (16)-waterproof rubber ring, (17)- contact pin, (31)-reflector, (41)-LED relevant components, (42)-transparent cover plate, (43)-light engine plate, (44)-flexible built-up circuit, (45)-transparent sealant, (46)-chip substrate, (61)-inner cover, (61.1)-pressure relief hole, (61.2)-pressure relief membrane, (61.3)-inserting recess, (81)-inner snap ring, (105)-fixed screw of light bulb, (431 )-alignment pin.

Embodiment 6-1: A liquid-cooling method of large-sized LED light, characterized in that it comprises a heat conduction support (3), the inner cover (61) is provided below the heat conduction support (3), the inner cover (61) is bonded in the inserting recess (61.3) of the heat conduction support (3), a confined space is formed between the heat conduction support (3) and the inner cover (61) 44 and the confined space is filled with transparent insulated heat conduction, wherein the light engine module (4) is provided in the inner cover (61), steps are provided in the inner cover (61) to support the light engine module (4), the light engine module (4) is immersed into the transparent insulated heat conduction fluid; the light engine module (4) is soldered with the contact pin (17) of the electric connector (11) around a periphery of the inner cover (61) by flexible built-up circuit (44), passing through the heat conduction support (3), the electric connector (11) is fixed on the heat conduction heat (3) by the fixed end (15); the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected into the pressure relief hole (61.1); when the temperature of the inner cover (61) is anormal, the fluid will break through the pressure relief membrane and leak out of the pressure relief hole (61.1), preventing the expansion of accident, or the inner ring cover (62) is provided around a periphery of the inner cover (61) to cover the fixed end (15) of the electric connector (11). Six uniformly distributed flange holes are provided on the heat conduction support (3) as fixed holes of light bulb, the light bulb is fixed by the fixed screw of light bulb (105), the support bushing (5) is riveted to the below of the heat conduction support (3), the basic support structure of light bulb is formed by the heat conduction support (3) and the support bushing (5); the heat conduction pad (2) is provided on the heat conduction support; the lens (7) is bonded with the below of the support bushing (5), a confined space is formed between the heat conduction support (3), the support bushing (5) and the lens (7) (the heat conduction support (3) and the lens (7) are the top and bottom surfaces and the support bushing (5) is the side), the confined space is provided with the light engine plate (4) and the inner cover (61), passing through the heat conduction support (3), the electric connector (11) is fixed on the heat conduction support (3) through the fixed end (15), and the electric connector (11) is connected with the light engine module (4) through the flexible built-up circuit (44); the inner cover (61) is provided around a periphery of the light engine module (4); the lens snap ring (8) is provided around a periphery of the support bushing, in this way, the lens (7) will be got stuck, the lens snap ring(8) is fixed on the support bushing (5) through the fixed screw (14), preventing lens accidental detachment.

Embodiment 6-2: A liquid-cooling method of large-sized LED light, characterized in that it comprises a heat conduction support (3), the inner cover (61) is provided below the heat conduction support (3), the inner cover (61) is bonded in the inserting recess (61.3) of the heat conduction support (3), a confined space is formed between the heat conduction support (3) and the inner cover (61) 44 and the confined space is filled with transparent insulated heat conduction, wherein the light engine module (4) is provided in the inner cover (61), steps are provided in the inner cover (61) to support the light engine module (4), the light engine module (4) is immersed into the transparent insulated heat conduction fluid; the light engine module (4) is soldered with the contact pin (17) of the electric connector (11) around a periphery of the inner cover (61) by flexible built-up circuit (44), passing through the heat conduction support (3), the electric connector (11) is fixed on the heat conduction heat (3) by the fixed end (15); the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected into the pressure relief hole (61.1); when the temperature of the inner cover (61) is anormal, the fluid will break through the pressure relief membrane and leak out of the pressure relief hole (61.1), preventing the expansion of accident, or the inner ring cover (62) is provided around a periphery of the inner cover (61) to cover the fixed end (15) of the electric connector (11). The lens snap ring (8) is provided on the heat conduction support (3), the edge of the heat conduction support (3) is wrapped up with the lens snap ring, six uniformly distributed flange holes are provided on the edge of the heat conduction support (3) as fixed holes of light bulb, the corresponding fixed holes of light bulb are also provided on the lens snap ring (8), the fixed screw is provided in the fixed hole of the light bulb to fix the light bulb, and the inner snap ring is provided below the heat conduction support (3) (the inner snap ring (81) is connected with the heat conduction support (3) by bonding and fixed screw (12), a basic support structure of light bulb is formed by the lens snap ring (8), the heat conduction support (3) and the inner snap ring (81); the heat conduction pad (2) is provided on the heat conduction support (3); the lens (7) is connected with the inner snap ring (81) by bonding; a confined space is formed between the heat conduction support (3), the inner snap ring (81) and the lens (7) (the heat conduction support (3) and the lens (7) are the top and bottom surfaces and the inner snap ring (5) is the side), the inner cover (61) and the light engine module (4) are fixed therein; passing through the heat conduction support (3), the electric connector is fixed on the heat conduction support (3) by the fixed end (15), and the electric connector (11) is connected with the light engine module (4) through the flexible built-up circuit (44).

Embodiment 6-3:A liquid-cooling method of large-sized LED light, characterized in that it comprises a heat conduction support (3), the inner cover (61) is provided below the heat conduction support (3), the inner cover (61) is bonded in the inserting recess (61.3) of the heat conduction support (3), a confined space is formed between the heat conduction support (3) and the inner cover (61) 44 and the confined space is filled with transparent insulated heat conduction, wherein the light engine module (4) is provided in the inner cover (61), steps are provided in the inner cover (61) to support the light engine module (4), the light engine module (4) is immersed into the transparent insulated heat conduction fluid; the light engine module (4) is soldered with the contact pin (17) of the electric connector (11) around a periphery of the inner cover (61) by flexible built-up circuit (44), passing through the heat conduction support (3), the electric connector (11) is fixed on the heat conduction heat (3) by the fixed end (15); the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected into the pressure relief hole (61.1); when the temperature of the inner cover (61) is anormal, the fluid will break through the pressure relief membrane and leak out of the pressure relief hole (61.1), preventing the expansion of accident, or the inner ring cover (62) is provided around a periphery of the inner cover (61) to cover the fixed end (15) of the electric connector (11). Six uniformly distributed flange holes are provided on the heat conduction support (3) as fixed holes of light bulb, the light bulb is fixed by the fixed screw of light bulb (105), the inner snap ring (81) is connected with the heat conduction support (3) by bonding and fixed screw (12), thereby forming a basic support structure of light bulb; the heat conduction pad (2) is provided on the heat conduction support (3); the lens (7) is connected with the inner snap ring (81) by bonding; a confined space is formed between the heat conduction support (3), the inner snap ring (81) and the lens (7) (the heat conduction support (3) and the lens (7) are the top and bottom surfaces and the inner snap ring (5) is the side), the inner (61) and the light engine module (4) are fixed therein; passing through the heat conduction support (3), the electric connector is fixed on the heat conduction support (3) by the fixed end (15), and the electric connector (11) is connected with the light engine module (4) through the flexible built-up circuit (44), the lens snap ring (8) is provided around a periphery of the inner snap ring (81), in this way, the lens (7) will be got stuck, the lens snap ring(8) is fixed on the support bushing through the fixed screw(14), preventing lens accidental detachment.

Embodiment 6-4: A liquid-cooling method of large-sized LED light, characterized in that it comprises a heat conduction support (3), the inner cover (61) is provided below the heat conduction support (3), the inner cover (61) is bonded in the inserting recess (61.3) of the heat conduction support (3), a confined space is formed between the heat conduction support (3) and the inner cover (61) and the confined space is filled with transparent insulated heat conduction, wherein the light engine module (4) is provided in the inner cover (61), steps are provided in the inner cover (61) to support the light engine module (4), the light engine module (4) is immersed into the transparent insulated heat conduction fluid; the light engine module (4) is soldered with the contact pin (17) of the electric connector (11) around a periphery of the inner cover (61) by flexible built-up circuit (44), passing through the heat conduction support (3), the electric connector (11) is fixed on the heat conduction heat (3) by the fixed end (15); the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected into the pressure relief hole (61.1); when the temperature of the inner cover (61) is anormal, the fluid will break through the pressure relief membrane and leak out of the pressure relief hole (61.1), preventing the expansion of accident, or the inner ring cover (62) is provided around a periphery of the inner cover (61) to cover the fixed end (15) of the electric connector (11). The heat conduction support (3) is fixed on the inner snap ring (81) by bonding, the lens (7) is connected with the inner snap ring (81) by bonding, thereby forming the basic support structure of light bulb. the heat conduction pad (2) is provided on the heat conduction support (3); the lens (7) is bonded with the inner snap ring (81) by bonding, a confined space is formed between the heat conduction support (3), the inner snap ring (5) and the lens (7) (the heat conduction support (3) and the lens (7) are the top and bottom surfaces and the inner snap ring (81) is the side), the inner cover (61) and the light engine module (4) are fixed therein, passing through the heat conduction support (3), the electric connector is fixed on the heat conduction support (3) through the fixed end (15), and the electric connector (11) is connected with the light engine module (4) through the flexible built-up circuit (44); the lens snap ring (8) is provided around a periphery of the inner snap ring (8), in this way, the lens (7) will be got stuck, the lens snap ring (8) is connected with the inner snap ring (81) by bonding, six uniformly distributed flange holes are disposed on the lens snap ring (81) as the fixed holes of light bulb, the light bulb is fixed through the fixed screw of light bulb (105).

Embodiment 6-5: A liquid-cooling method of large-sized LED light, characterized in that it comprises a heat conduction support (3), the inner cover (61) is provided below the heat conduction support (3), the inner cover (61) is bonded in the inserting recess (61.3) of the heat conduction support (3), a confined space is formed between the heat conduction support (3) and the inner cover (61) and the confined space is filled with transparent insulated heat conduction, wherein the light engine module (4) is provided in the inner cover (61), steps are provided in the inner cover (61) to support the light engine module (4), the light engine module (4) is immersed into the transparent insulated heat conduction fluid; the light engine module (4) is soldered with the contact pin (17) of the electric connector (11) around a periphery of the inner cover (61) by flexible built-up circuit (44), passing through the heat conduction support (3), the electric connector (11) is fixed on the heat conduction heat (3) by the fixed end (15); the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2), the transparent insulated heat conduction fluid is injected into the pressure relief hole (61.1); when the temperature of the inner cover (61) is anormal, the fluid will break through the pressure relief membrane and leak out of the pressure relief hole (61.1), preventing the expansion of accident, or the inner ring cover (62) is provided around a periphery of the inner cover (61) to cover the fixed end (15) of the electric connector (11). The heat conduction support (3) is fixed in the lens (7) by bonding, thereby forming the basic support structure of light bulb. the heat conduction pad (2) is provided on the heat conduction support (3); a confined space is formed between the heat conduction support (3) and the lens (7), the light engine module are fixed therein, passing through the heat conduction support (3), the electric connector (11) is fixed on the heat conduction support (3) through the fixed end (15), and the electric connector (11) is connected with the light engine module (4) through the flexible built-up circuit (44); the lens snap ring (8) is provided around a periphery of the lens (7), in this way, the lens (7) will be got stuck, the lens snap ring (8) is connected with the lens (7) by bonding, six uniformly distributed flange holes are disposed on the lens snap ring (8) as the fixed holes of light bulb, the light bulb is fixed through the fixed screw (105) of light bulb.

In the embodiment 6-1, 6-2, 6-3, 6-4 and 6-5, the light engine module (4) comprises a light engine plate (43); wherein the light engine plate (43) is preparing the thin epitaxial wafer (46) formed by the transitional epitaxial layer on the existing LED substrate, putting the epitaxial wafer (46) into a reacting furnace to grow by layers to form an LED wafer and relevant circuits, the LED wafer will not cut after the completion of the growth; and die bonding relevant components and conducting wire bonding to connect the wafer driving chip and other components. The LED relevant components (41) are formed by the LED wafer, relevant circuits and relevant components, the epitaxial wafer (46) is bonded with the light engine plate (43), and the outline of the light engine plate (43) is the same with that of the epitaxial wafer (46), moreover, both sides of the light engine plate (43) and the epitaxial wafer (46) are provided with gaps; or preparing the transitional epitaxial layer on the light engine plate (43) directly, putting the epitaxial wafer (46) into a reacting furnace and grow by layers to form an LED wafer and relevant circuits; and the epitaxial wafer is soldered with relevant components, then conducting wire bonding to connect the LED wafer and relevant components. The LED relevant components (41) are formed by the LED wafer, relevant circuits and relevant components; or the light engine plate (43) is transparent material substrate, utilizing the existing wafer, fitting, printing, die bonding, wire bonding other technologies to realize LED wafer, relevant circuits and relevant components on the light engine plate (43). The LED relevant components (41) are formed by the LED wafer, relevant circuits and relevant components, the transparent sealant (45) and/or the transparent cover plate (42) are utilized on the LED relevant components (41) to cover, and only the correlated bonding pad on the LED relevant components (41) is shown; the methods of covering LED relevant components by transparent sealant (45) and /or transparent cover plate (42) are as follows as Fig.2 and Fig.3 shown: filling in a little transparent sealant between LED relevant components (41) to level, and forming the transparent sealant (45) between the surface of LED wafer and the transparent cover plate (42) as little as possible, then covering the transparent cover plate (42) whose profile is the same with that of light engine plate (43) on LED relevant components, besides, opening area is provided on transparent cover plate (42) to show the bonding pad; or as Fig.5 and Fig.6 shown, filling in a little transparent sealant (45) between LED relevant components (41) to level, and forming the transparent sealant (45) between the surface of LED wafer and the transparent cover plate (42) as little as possible, then covering the transparent cover plate (42) whose profile is smaller than of light engine plate on LED relevant components (41), then the transparent sealant (45) is wrapped around transparent cover plate to level the profile of transparent sealant (45) with that of light engine plate (43), opening area is provided on transparent cover plate (42) to show the bonding pad; or the transparent sealant 45 is wrapped around transparent cover plate directly to level the profile of transparent sealant with that of light engine plate (43), opening area is provided on transparent cover plate (42) to show the bonding pad.

As Fig. 7 shown, the light engine plate (43) is circular plate, both sides of the circular plate is provided with two symmetrical gaps, each gap is formed by cutting a string along the circle the circular plate, moreover, both ends of the string tilt outwards to 120 degrees and transit to the circle of the circular plate by circular arc; the shape is to cut both sides of the circle according to the diameter of d_{G}, the symmetry of X axis, the length of I_{G}, the string length of w_{G}, the ends of the string tilt outwards to 120 degrees, and it is transited to the diameter d_{G} with the arc of R= 1.0mm, thereby forming the gaps, when the light engine module is used for the plan of liquid-cooling method, the heated transparent insulated heat conduction fluid can conduct thermal cycle from gaps. As Fig. shown, the circle diameter of the circular plate is 20mm, 38mm or 50mm; if the length between the gap subtract the outward tilting part, the length is 10mm, the radius of circular arc used for transition is 1 mm, the two corresponding strings of two gaps are parallel to each other; when it is 20mm, the distance between two strings is 15mm; when it is 38mm, the distance between two strings is 33mm when it is 50mm, the distance two strings is 45mm ;The bonding pad is located at the inner side of the gaps of circular plate, each pad is disposed on the inner side of two gaps or that of one gap respectively, the electric connector (11) is connected with the bonding pad through the flexible built-up circuit (44). The bonding pad is soldered with the electric connector (11) outside of the inner cover (61) by LED relevant components (41) through flexible built-up circuit (44), the flexible built-up circuit (44) is bonded closely to the heat conduction support (3), a confined space is formed between the inner cover (61) and the heat conduction support (3) through inserting recess (61.3) and bonding, and the flexible built-up circuit (44) is compressed tightly by the inner cover (61), as Fig. 8 and Fig.51 shown.

Fixed holes for fixing are further provided on the light engine module (43). There are two fixed holes provided on the light engine module (43), the two fixed holes are symmetric around the center circular plate with a distance of dG-6, the diameter of fixed holes is 2.2mm;, the link of two fixed holes is orthogonal with that of gaps center; when the diameter d_{G} = 20mm, a fixed hole of one side need to be opened, that is, two fixed holes whose diameter is 2.2mm are disposed symmetrically on the light engine plate (43) utilizing Y axis as the center and dG-6 as the diameter, when the diameter d_{G}=20mm, a fixed hole of one side need to be opened.

The concave inner cover (61) is provided around a periphery of large-sized LED light bulb with liquid-cooling method, finally, the liquid-cooling method of large-sized LED light bulb is disposed at the confined space between the heat conduction support (3) and the concave inner cover (61), the external diameter of the light engine module of LED light bulb is tightly closed with the inner diameter of the inner cover (61). In this way, a core structure of LED light bulb is formed, and finally the transparent insulated heat conduction fluid is injected into the inner cover (61) as Fig. shown, the pressure relief hole (61.1) and the pressure relief membrane (61.2) used to seal are provided on the concave inner cover (61).

The lens (7) can be replaced by the outer cover (9), if the outer cover (9) is used in the light bulb, the outer cover (9) need to be bonding disposed around a periphery of the inner cover (61) or the lens snap ring (8) as Fig.48 shown; or the lens (7) can be replaced by the outer cover with lens-type interface (7.1) directly as Fig.53 shown.

The inner ring cover (61) is provided around a periphery of the inner cover (62), when utilizing the small driving power, the driving power can be disposed in the inner cover (62) with annular shape ,as Fig.52 shown, the orientation of the light engine module (4) input end does a 180-degree rotation from +X to -X. The shape of the flexible built-up circuit (44) has also been changed, the A-type flexible built-up circuit (44.1) will be connected with the annular driving power (62.1) and the electric connector (11); the inner ring cover (62) has a function of beautification by covering the fixed end (15) of the electric connector (11) and connecting components of the annular driving power (62.1).

The phosphor and protective layer are coated on the transparent cover plate (42), or the transparent cover plate (42) is molded transparent fluorophor. Transparent fluorophor is prepared by the fluorescent materials and transparent materials according to the weight ratio of 5∼30:100.

The concave part can be protruded to the outside to increase the volume to accommodate the inflated volume of the transparent insulated heat conduction fluid, preventing the failure of the sealing due to the swelling of transparent insulated heat conduction fluid; the phosphor and protective layer are coated on the surface of the inner cover (61); or the inner cover (61) is molded transparent fluorophor. Transparent fluorophor is prepared by the fluorescent materials and transparent materials according to the weight ratio of 5∼30:100.

The thermal cycle of the present invention is as Fig. 49 shown.

The following three specifications of the light engine module are realized by above five embodiments:

| d _{G}/mm | l _{G}/mm | w _{G}/mm | h _{G}/mm | notes |
|---|---|---|---|---|
| 20 | 15 | 10.0 | 0.6-3.0 (it is for reference, not a compulsive demand) | |
| 38 | 33 | 10.0 | | |
| 50 | 45 | 10.0 | | |

The mark of figures of above embodiments is respectively: (2)-heat conduction pad, (3)-heat conduction support, (4)-light engine module, (5)-support bushing, (7)-lens, (7.1)-lens type interface outer cover, (8)-lens snap ring, (9) -outer cover, (11)-electric connector, (12)-fixed screw, 14-snap ring fixed screw, 15-fixed end, (16)-waterproof rubber ring, (17)- contact pin, (31)-reflector, (41)-LED relevant components, (42)-transparent cover plate, (43)-light engine plate, (44)-flexible built-up circuit, (44)- A-type flexible built-up circuit, (45)-transparent sealant, (46)-chip substrate, (61)- inner cover, (61.1)-pressure relief hole, (61.2)-pressure relief membrane, (61.3)-inserting recess, (62)-inner ring cover, (62.1)-annular driving power, (81)-inner snap ring, (105)-fixed screw of light bulb,(431 )-alignment pin.

## Claims

1. An LED light bulb manufacturing method, **characterized in that** it comprises following steps:
1) preparing a transitional epitaxial layer on a substrate to form an epitaxial wafer;
2) putting the epitaxial wafer into a reacting furnace to undergo such process steps as silicon coating, sizing, photolithography, etching, film coating, alloying, and slice grinding, the epitaxial wafer growing by layers to form an LED wafer at a specific position and relevant circuits; the LED wafer will not be cut after the completion of the growth; obtaining product A after the LED wafer passes inspection, and die bonding relevant components on product A and conducting wire bonding (conducting wire bonding to connect LED wafer and relevant components) to obtain product B;
3) on product B, performing the process steps of sealant pouring to cover the wafer and baking, and after inspection, conducting color separation and light splitting, so as to form a finished light engine module;
4) utilizing the light engine module and light bulb accessories to assemble an LED light bulb, and aging and packaging the assembled LED light bulb to obtain a finished LED light bulb.

2. An LED illumination lamp manufacturing method, **characterized in that** it comprises following steps:
1) preparing a transitional epitaxial layer on a substrate to form an epitaxial wafer;
2) putting the epitaxial wafer into a reacting furnace and growing by layers to form an LED wafer; the LED wafer will not be cut after the completion of the growth; obtaining product A after the LED wafer passes inspection, and die bonding relevant components on product A and conducting wire bonding to connect LED wafer and relevant components to obtain product B;
3) assembling product B into light engine module directly;
4) utilizing the light engine module and light bulb accessories to assemble an LED light bulb.
5) utilizing the assembled LED light bulb in step 4 and lamps in terminal market and/or lighting control products to assemble the LED illumination lamp.

3. The methods as claimed in Claim 1 or Claim 2, **characterized in that** the light engine plate is used as substrate directly in step 1, or the existing LED thin substrate whose shape is the same with that of light engine plate is used as substrate; wherein the specific step of the sealant pouring to cover the wafer is to use a transparent sealant (45) and/or a transparent cover plate (42) on the LED relevant components (41) of product B and only the correlated bonding pad of LED relevant components(41) is shown; when the thin substrate whose shape is the same with that of light engine plate is used as substrate in step 1, then the product B is further needed to be bonded with a light engine plate (43) in step 3; wherein the both sides of the light engine plate (43) are provided with gap; the LED relevant components comprise an LED wafer, relevant circuits and relevant components; the light bulb accessories mainly comprise a heat conducting support(3), a light distribution optical lens (7), a lens snap ring (8), an electric connector male (11), a flexible built-up circuit (44), a light bulb concave inner cover (61), an inner ring cover (62) and an inner snap ring (81).

4. A construction method of light engine module of LED light bulb, **characterized in that** the constructed light engine module by this method comprises preparing a thin epitaxial wafer (46) formed by the transitional epitaxial layer on existing LED substrate, putting the epitaxial wafer (46) into a reacting furnace and growing by layers to form an LED wafer; the LED wafer will not be cut after the completion of the growth; and conducting wire bonding to connect the LED wafer and relevant components; the LED relevant components (41) are formed by the LED wafer, relevant circuits and relevant components (41), the epitaxial wafer (46) is bonded with the light engine plate (43), wherein the outline of the light engine plate (43) is the same with that of the epitaxial wafer (46), moreover, both sides of the light engine plate (43) and the epitaxial wafer (46) are provided with gap; or preparing a transitional epitaxial layer directly on the light engine plate (43), putting the transitional epitaxial layer into a reacting furnace and growing to form an LED wafer and relevant circuits thereon; and die bonding relevant components; then conducting wire bonding to connect the LED wafer and relevant components; the LED relevant components (41) are formed by the LED wafer, relevant circuits and relevant components (41); the transparent sealant (45) and/or the transparent cover plate (42) are used on the LED relevant components (41) to cover and only correlated bonding on the LED relevant components (41) is shown.

5. A liquid-cooling method of small LED light bulb, **characterized in that** it comprises light engine core members and peripheral members of LED light bulb, wherein the light engine core members of LED light bulb comprise a heat conduction support (3), passing through the heat conduction support (3), the electric connector (11) is bonded on the heat conduction support (3), the contact pin on the top end of the electric connector (11) is soldered with the bonding pad on a light engine module (4) after aligning the position and inserting from four holes of the backside of the light engine module; moreover, the inner cover (61) is provided around a periphery of the light engine module (4), the inner cover (61) is bonded in a inserting recess (61.3) of the heat conduction support (3), a confined space is formed between the heat conduction support (3) and the light engine module (4), and the confined space is filled with transparent insulated heat conduction fluid, the light engine module (4) is immersed into the transparent insulated heat conduction fluid, a reflector (31) is provided on the surface of the covered part of the heat conduction support (3) by the inner cover (61); wherein a pressure relief hole (61.1) is provided on the inner cover (61), the pressure relief hole (61.1) is covered with a pressure relief membrane (61.2) the transparent insulated heat conduction fluid is injected through the pressure relief hole (61.1); when the temperature of the inner cover (61) is anormal, the fluid will break through the pressure relief membrane and leak out of the pressure relief hole (61.1), preventing the expansion of accident.

6. The liquid-cooling method of small LED light bulb as claimed in claim 5, **characterized in that** the light engine module (4) comprises a light engine plate (43); wherein the light engine plate (43) is preparing thin epitaxial wafer (46) formed by the transitional epitaxial layer on existing LED substrate, putting the epitaxial wafer (46) into a reacting furnace and growing by layers to form an LED wafer; the LED wafer will not be cut after the completion of the growth, and die bonding relevant components, then conducting wire bonding to connect the LED wafer and relevant components, the epitaxial wafer (46) is bonded with the light engine plate (43), the outline of the light engine plate (43) is the same with that of the epitaxial wafer (46), moreover, both sides of the light engine plate (43) and the epitaxial wafer (46) are provided with gap; or preparing a transitional epitaxial layer directly on the light engine plate (43), putting the transitional epitaxial layer into a reacting furnace and growing to form an LED wafer and relevant circuits thereon; and die bonding relevant components; then conducting wire bonding to connect the LED wafer and relevant components; or the light engine plate (43) is transparent material substrate, utilizing the existing wafer, fitting, printing, die bonding, wire bonding and other technologies to realize LED wafer, relevant circuits and relevant components on the light engine plate (43). The LED relevant components (41) are formed by the LED wafer, relevant circuits and relevant components (41); the transparent sealant (45) and/or the transparent cover plate (42) are used on the LED relevant components (41) to cover and only correlated bonding on the LED relevant components (41) is shown.

7. The liquid-cooling method of small LED light bulb as claimed in claim 5, **characterized in that** peripheral members of the light bulb comprise a heat conduction support (3) having a lens snap ring (8), the edge of the heat conduction support (3) is wrapped up with the lens snap ring (8), six uniformly distributed flange holes are provided on the edge of the heat conduction support (3) as fixed holes of light bulb, the corresponding fixed holes of light bulb are also provided on the lens snap ring (8) , the fixed screw (105) is provided in the fixed hole of the light bulb to fix the light bulb, forming a basic support structure for light bulb; the lens (7) is provided at the bottom of the lens snap ring (8), and the lens (7) is connected with the inner cover (61) through bonding; wherein a heat conduction pad (2) is provided on the surface of the heat conduction support (3).

8. The liquid-cooling method of small LED light bulb as claimed in claim 5, **characterized in that** the peripheral members of light bulb comprise a heat conduction support (3) having six uniformly distributed flange holes on the heat conduction support (3) as fixed holes of light bulb, the light bulb is fixed by a light bulb fixed screw (105), thereby forming a basic support structure of light bulb; a heat conduction pad (2) is provided on the surface of the heat conduction support (3); wherein the bottom of the inner cover (61) is bonded with a lens (7); a lens snap ring (8) is provided around a periphery of the inner cover (61), in this way, the lens (7) get stuck.

9. The liquid-cooling method of small LED light bulb as claimed in claim 5, **characterized in that** the peripheral members of light bulb comprise a heat conduction support (3), the heat conduction support (3) is fixed on the inner cover (61) by bonding, thereby forming a basic support structure of light bulb; the heat conduction pad (2) is provided on the surface of the heat conduction support (3); wherein the bottom of the inner cover (61) is bonded with the lens (7); the lens snap ring (8) is provided around a periphery of the inner cover (61), in this way, the lens (7) get stuck, and the lens snap is connected with the periphery of the inner cover (61) and the heat conduction support ring (3) by bonding, Six uniformly distributed flange holes are provided on the heat conduction support (3) as fixed holes of light bulb, the light bulb is fixed by the fixed screw (105) of light bulb .

10. A liquid-cooling method of medium LED light , **characterized in that** it comprises light engine core members and peripheral members of LED light bulb, wherein the light engine core members of LED light bulb comprise a heat conduction support (3), the heat conduction support (3) is passed through the electric connector (11), and the center hole of the light engine module (3) is inserted by the electric connector (11) exactly and the electric connector (11) is soldered with a contact pin (17) of the electric connector (11) by a flexible built-up circuit (44); moreover, the inner cover (61) is provided around a periphery of the light engine module (4), the inner cover (61) is bonded in the inserting recess (61.3) of the heat conduction support (3), a confined space is formed between the light engine module (3) and the light engine module (4), and the confined space is filled with transparent insulated heat conduction, the light engine module (4) is immersed into the transparent insulated heat conduction fluid, a reflector (31) is provided on the surface of the covered part of the heat conduction support (3) by the inner cover (61); wherein a pressure relief (61.1) is provided on the inner cover (61), the pressure relief hole (61.1) is covered with a pressure relief membrane (61.2) the transparent insulated heat conduction fluid is injected through the pressure relief hole (61.1); when the temperature of the inner cover (61) is anormal, the fluid will break through the pressure relief membrane and leak out of the pressure relief hole (61.1), preventing the expansion of accident.

11. The liquid-cooling method of medium LED light bulb as claimed in claim 10, **characterized in that** the light engine module (4) comprises a light engine plate (43); wherein the light engine plate (43) is preparing thin epitaxial wafer (46) formed by the transitional epitaxial layer on existing LED substrate, putting the epitaxial wafer (46) into a reacting furnace and growing by layers to form an LED wafer; the LED wafer will not be cut after the completion of the growth, and die bonding relevant components, then conducting wire bonding to connect the LED wafer and relevant components, the epitaxial wafer (46) is bonded with the light engine plate (43), the outline of the light engine plate (43) is the same with that of the epitaxial wafer (46), moreover, both sides of the light engine plate (43) and the epitaxial wafer (46) are provided with gap; or preparing a transitional epitaxial layer directly on the light engine plate (43), putting the transitional epitaxial layer into a reacting furnace and growing to form an LED wafer and relevant circuits thereon; and die bonding relevant components; then conducting wire bonding to connect the LED wafer and relevant components; or the light engine plate (43) is transparent material substrate, utilizing the existing wafer, fitting, printing, die bonding, wire bonding and other technologies to realize LED wafer, relevant circuits and relevant components on the light engine plate (43). The LED relevant components (41) are formed by the LED wafer, relevant circuits and relevant components (41); the transparent sealant (45) and/or the transparent cover plate (42) are used on the LED relevant components (41) to cover and only correlated bonding on the LED relevant components (41) is shown.

12. The liquid-cooling method of medium LED light bulb as claimed in claim 10, **characterized in that** the peripheral members of LED light bulb comprise a heat conduction support (3) having six uniformly distributed flange holes on the heat conduction support (3) as fixed holes of light bulb, the light bulb is fixed by the fixed screw (105) of light bulb ; a support bushing (5) is riveted to the below of the heat conduction support (3), a light bulb basic support structure is formed by the heat conduction support (3) and the support bushing (5);the heat conduction pad (2) is provided on the heat conduction support(3); the lens (7) is bonded with the below of the support bushing (5), a confined space is formed between the heat conduction support (3), the support bushing (5) and the lens (7), the confined space is provided with the light engine plate (4) and the inner cover (6); passing through the heat conduction support (3), the electric connector is fixed on the heat conduction support by a fixed end (15), and the electric connector (11) is connected with the light engine module (4) through the flexible built-up circuit (44); the inner cover (61) is provided around a periphery of the light engine module (4); the lens snap ring (8) is provided around a periphery of the support bushing (5), in this way, the lens (7) get stuck.

13. The liquid-cooling method of medium LED light bulb as claimed in claim 10, **characterized in that** the peripheral members of LED light bulb comprise a heat conduction support (3) having the lens snap ring (8), the edge of the heat conduction support (3) is wrapped up with the lens snap ring (8), six uniformly distributed flange holes are provided on the edge of the heat conduction support (3) as fixed holes of light bulb, the corresponding fixed holes of light bulb are also provided on the lens snap ring (8), a fixed screw (105) is provided in the fixed hole of the light bulb to fix the light bulb, and the inner snap ring (81) is provided below the heat conduction support (3), a basic support structure of light bulb is formed by the lens snap ring (8), the heat conduction support (3) and the inner snap ring (81);the heat conduction pad (2) is provided on the heat conduction support(3); the lens (7) is connected with the inner snap ring (81) by bonding, the lens (7) get stuck by the lens snap ring (8); a confined space is formed between the heat conduction support (3), the inner snap ring (81) and the lens (7), the inner cover (61) and the light engine module (4) is fixed therein; passing through the heat conduction support (3), the electric connector (11) is fixed on the heat conduction support (3) by the fixed end (15), and the electric connector (11) is connected with the light engine module (4) through the flexible built-up circuit (44);
Or the peripheral members of LED light bulb comprise a heat conduction support (3) having six uniformly distributed flange holes on the heat conduction support (3) as fixed holes of light bulb, the light bulb is fixed by the fixed screw (105) of light bulb, the inner snap ring (81) is connected with the below of the heat conduction support (3) through bonding and fixing screw, thereby forming a basic support structure of light bulb; the heat conduction pad (2) is provided on the heat conduction support(3); the lens (7) is connected with the inner snap ring by bonding, a confined space is formed between the heat conduction support (3), the inner snap ring (81) and the lens(7), the inner cover (61) and the light engine module (4) are fixed therein; the electric connector (11) is fixed on the heat conduction support (3) and the electric connector (11) is connected with the light engine module (4) through the flexible built-up circuit (44); the lens snap ring (8) is provided around a periphery of the inner snap ring (81), in this way, the lens (7)will be got stuck, the fixed screw can be provided to fix the lens snap ring (8) on the inner snap ring (81), preventing lens accidental detachment.

14. The liquid-cooling method of medium LED light bulb as claimed in claim 10, **characterized in that** the peripheral members of LED light bulb comprise a heat conduction support (3), the heat conduction support (3) is fixed on the inner snap ring (81) by bonding, the lens (7) is connected with the inner snap ring (81) by bonding, thereby forming a basic support structure of light bulb; the heat conduction pad (2) is provided on the heat conduction support (3); the lens (7) is connected with the inner snap ring by bonding, a confined space is formed between the heat conduction support (3), the inner snap ring (81) and the lens (7), the inner cover (61) and the light engine module (4) are fixed therein; the electric connector (11) is fixed on the heat conduction support (3) and the electric connector (11) is connected with the light engine module (4) through the flexible built-up circuit (44); the lens snap ring (8) is provided around a periphery of the inner snap ring (81), in this way, the lens (7) get stuck, and the lens snap ring (8) is connected with the inner snap ring (81) by bonding, six uniformly distributed flange holes are provided on the lens snap ring (8) as fixed holes of light bulb, the light bulb is fixed by the fixed screw (105) of light bulb;
Or the heat conduction support (3) is fixed in the lens (7) by bonding, thereby forming a basic support structure of light bulb; the heat conduction pad (2) is provided on the heat conduction support (3); a confined space is formed between the heat conduction support (3) and the lens(7), the inner cover (61) and the light engine module (4) are fixed therein; passing through the heat conduction support, the electric connector (11) is fixed on the heat conduction support (3) by the fixed end (15) and the electric connector (11) is connected with the light engine module (4) through the flexible built-up circuit (44); the lens snap ring (8) is provided around a periphery of the lens (7), in this way, the lens (7) get stuck, and the lens snap ring (8) is connected with the lens (7) by bonding, six uniformly distributed flange holes are provided on the lens snap ring (8) as fixed holes of light bulb, the light bulb is fixed by the fixed screw (105) of light bulb.

15. A liquid-cooling method of large LED light, **characterized in that** it comprises light engine core members and peripheral members of LED light bulb, wherein the light engine core members of LED light bulb comprise a heat conduction support (3), the inner cover (61) is provided below the heat conduction support (3), the inner cover (61) is bonded in the inserting recess (61.3) of the heat conduction support (3), a confined space is formed between the heat conduction support (3) and the inner cover (61) and the confined space is filled with transparent insulated heat conduction, wherein the light engine module (4) is provided in the inner cover (61), steps are provided in the inner cover (61) to support the light engine module (4), the light engine module (4) is immersed into the transparent insulated heat conduction fluid; the light engine module (4) is soldered with the contact pin (17) of the electric connector (11) around a periphery of the inner cover (61) by flexible built-up circuit (44), passing through the heat conduction support (3), the electric connector is fixed on the heat conduction heat (3) by the fixed end (15); the reflector (31) is provided on the surface of the covered part of the heat conduction support (3) by the inner cover (61); wherein the pressure relief (61.1) is provided on the inner cover (61), the pressure relief hole (61.1) is covered with the pressure relief membrane (61.2) the transparent insulated heat conduction fluid is injected the pressure relief hole (61.1); when the temperature of the inner cover (61) is anormal, the fluid will break through the pressure relief membrane and leak out of the pressure relief hole (61.1), preventing the expansion of accident.

16. The liquid-cooling method of large LED light bulb as claimed in claim 15, **characterized in that** the light engine module (4) comprises a light engine plate (43); wherein the light engine plate (43) is preparing thin epitaxial wafer (46) formed by the transitional epitaxial layer on existing LED substrate, putting the epitaxial wafer (46) into a reacting furnace and growing by layers to form an LED wafer; the LED wafer will not be cut after the completion of the growth, and die bonding relevant components, then conducting wire bonding to connect the LED wafer and relevant components, the epitaxial wafer (46) is bonded with the light engine plate (43), the outline of the light engine plate (43) is the same with that of the epitaxial wafer (46), moreover, both sides of the light engine plate (43) and the epitaxial wafer (46) are provided with gap; or preparing a transitional epitaxial layer directly on the light engine plate (43), putting the transitional epitaxial layer into a reacting furnace and growing to form an LED wafer and relevant circuits thereon; and die bonding relevant components; then conducting wire bonding to connect the LED wafer and relevant components; or the light engine plate (43) is transparent material substrate, utilizing the existing wafer, fitting, printing, die bonding, wire bonding and other technologies to realize LED wafer, relevant circuits and relevant components on the light engine plate (43). The LED relevant components (41) are formed by the LED wafer, relevant circuits and relevant components (41); the transparent sealant (45) and/or the transparent cover plate (42) are used on the LED relevant components (41) to cover and only correlated bonding on the LED relevant components (41) is shown.

17. The liquid-cooling method of large LED light bulb as claimed in claim 15, **characterized in that** the peripheral members of LED light bulb comprise a heat conduction support (3) having six uniformly distributed flange holes on the heat conduction support (3) as fixed holes of light bulb, the light bulb is fixed by the fixed screw (105) of light bulb; a support bushing (5) is riveted to the below of the heat conduction support (3), a light bulb basic support structure is formed by the heat conduction support (3) and the support bushing (5); the heat conduction pad (2) is provided on the heat conduction support(3); the lens (7) is bonded with the below of the support bushing (5), a confined space is formed between the heat conduction support (3), the support bushing (5) and the lens (7), the confined space is provided with the light engine plate (4) and the inner cover (6); passing through the heat conduction support (3), the electric connector is fixed on the heat conduction support by a fixed end (15), and the electric connector (11) is connected with the light engine module (4) through the flexible built-up circuit (44); the inner cover (61) is provided around a periphery of the light engine module (4); the lens snap ring (8) is provided around a periphery of the support bushing (5), in this way, the lens (7) get stuck, the lens snap ring (8) is fixed on the support bushing (5) by the fixed screw (14), preventing lens accidental detachment.

18. The liquid-cooling method of large LED light bulb as claimed in claim 15, **characterized in that** the peripheral members of LED light bulb comprise a heat conduction (3) having the lens snap ring (8) , the edge of the heat conduction support (3) is wrapped up with the lens snap ring (8), six uniformly distributed flange holes are provided on the edge of the heat conduction support (3) as fixed holes of light bulb, the corresponding fixed holes of light bulb are also provided on the lens snap ring (8), the fixed screw (105) is provided in the fixed hole of light bulb to fix the light bulb, and the inner snap ring (81) is provided on the heat conduction support (3). A basic support structure of light bulb is formed by the lens snap ring (8), the heat conduction support (3) and the inner snap ring (81); the heat conduction pad (2) is provided on the heat conduction support(3), the lens (7) is connected with the inner snap ring by bonding, a confined space is formed between the heat conduction support (3), the inner snap ring (81) and the lens (7), the inner cover (61) and the light engine module (4) are fixed therein; the electric connector (11) is fixed on the heat conduction support (3) and the electric connector (11) is connected with the light engine module (4) through the flexible built-up circuit (44);
Or the peripheral members of LED light bulb comprise a heat conduction support (3) having six uniformly distributed flange holes on the heat conduction support (3) as fixed holes of light bulb, the light bulb is fixed by the fixed screw (105) of light bulb, the inner snap ring (81) is connected with the below of the heat conduction support (3) through bonding and fixing screw, thereby forming a basic support structure of light bulb the heat conduction pad (2) is provided on the heat conduction support(3); the lens (7) is connected with the inner snap ring by bonding, a confined space is formed between the heat conduction support (3), the inner snap ring (81) and the lens(7), the inner cover (61) and the light engine module (4) are fixed therein; the electric connector (11) is fixed on the heat conduction support (3) and the electric connector (11) is connected with the light engine module (4) through the flexible built-up circuit (44); the lens snap ring (8) is provided around a periphery of the inner snap ring (81), in this way, the lens (7) will be got stuck, the fixed screw can be provided to fix the lens snap ring (8) on the inner snap ring (81 ), preventing lens accidental detachment.

19. The liquid-cooling method of large LED light bulb as claimed in claim 15, **characterized in that** the peripheral members of LED light bulb comprise a heat conduction support (3), the heat conduction support (3) is fixed on the inner snap ring (81) by bonding, the lens (7) is connected with the inner snap ring (81) by bonding, thereby forming a basic support structure of light bulb; the heat conduction pad (2) is provided on the heat conduction support (3); the lens (7) is connected with the inner snap ring by bonding, a confined space is formed between the heat conduction support (3), the inner snap ring (81) and the lens (7), the inner cover (61) and the light engine module (4) are fixed therein; the electric connector (11) is fixed on the heat conduction support (3) and the electric connector (11) is connected with the light engine module (4) through the flexible built-up circuit (44); the lens snap ring (8) is provided around a periphery of the inner snap ring (81), in this way, the lens (7) get stuck, and the lens snap ring (8) is connected with the inner snap ring (81) by bonding, six uniformly distributed flange holes are provided on the lens snap ring (8) as fixed holes of light bulb, the light bulb is fixed by the fixed screw (105) of light bulb.
Or the periphery members of LED light bulb comprise a heat conduction support (3), the heat conduction support (3) is fixed in the lens(7) by bonding, thereby forming a basic support structure of light bulb; the heat conduction pad (2) is provided on the heat conduction support (3); a confined space is formed between the heat conduction support (3) and the lens(7), the inner cover (61) and the light engine module (4) are fixed therein; passing through the heat conduction support, the electric connector (11) is fixed on the heat conduction support (3) by the fixed end (15) and the electric connector (11) is connected with the light engine module (4) through the flexible built-up circuit (44); the lens snap ring (8) is provided around a periphery of the lens (7), in this way, the lens (7) get stuck, and the lens snap ring (8) is connected with the lens (7) by bonding, six uniformly distributed flange holes are provided on the lens snap ring (8) as fixed holes of light bulb, the light bulb is fixed by the fixed screw (105) of light bulb.

20. The methods as claimed in claim 3, claim 4, claim 6, claim 11 or claim 16, **characterized in that** the methods of covering LED relevant components by transparent sealant (45) and/or transparent cover plate (42) are as follows: filling in a little transparent sealant between LED relevant components (41) to level, and forming the transparent sealant between the surface of LED wafer and the transparent cover plate (42) as little as possible, then covering the transparent cover plate (42) whose profile is the same with that of light engine plate (43) on LED relevant components, besides, opening area is provided on transparent cover plate to show the bonding pad; or filling in a little transparent sealant between LED relevant components (41) to level, and forming the transparent sealant between the surface of LED wafer and the transparent cover plate (42) as little as possible, then covering the transparent cover plate (42) whose profile is smaller than that of light engine plate on LED relevant components (41), then the transparent sealant is wrapped around transparent cover plate to level the profile of transparent sealant (45) with that of light engine plate (43), opening area is provided on transparent cover plate (42) to show the bonding pad; or the transparent sealant (45) is wrapped around transparent cover plate (42) directly to level the profile of transparent sealant with that of light engine plate (43), opening area is provided on transparent cover plate (42) to show the bonding pad.

21. The methods as claimed in claim 3, claim 4 or claim 6, **characterized in that** the light engine plate is circular plate, two inner arc gaps are provided on both sides of circular plate symmetrically, the center of the arc gap is on the concentric circle of the periphery of circular plate; the circular hole is further provided on the light engine plate (43) for the connection with contact pin of electric connector (11), wherein the bonding pad is located at the position of circular hole on LED relevant components (41), the contact pin of electric connector (11) is soldered with the bonding pad after inserting into the circle hole.

22. The method as claimed in claim 3, claim 4 or claim 11, **characterized in that** the light engine plate (43) is circular plate, two bow shape of the circle are removed symmetrically on both sides of circular plate, forming two symmetrical gaps; wherein a circle hole with alignment pin is provided on the light engine plate (43), the circle hole is used for the alignment connection with the electric connector (11); wherein the bonding pad is disposed at the position of circle hole by LED relevant components (41) through the flexible built-up circuit (44), wherein the electric connector (11) is soldered with the bonding pad of the flexible built-up circuit (44) after inserting into the circle hole.

23. The method as claimed in claim 3, claim 4 or claim 16, **characterized in that** the light engine plate (43) is a circular plate, both sides of the circular plate is provided with two symmetrical gaps, each gap is formed by cutting a string along the circle of the circular plate, moreover, both ends of the string tilt outwards to 120 degrees, and transit to the circle of the circular plate by circular arc; wherein the bonding pad is located at the inner side of the gap of the circular plate, the bonding pad is disposed at the inner side of two gaps or concentrated at the inner side of one gap therein respectively.

24. The method as claimed in claim 21, **characterized in that** the circle diameter d_{G} of the circular plate is 11 mm or 16mm; when it is 11 mm, the center of two circular arc gaps is in the circle whose diameter d_{G} is 13mm, the radius of two circular arc gaps is 3.2mm; when it is 16mm, the center of two circular arc gaps is in the circle whose diameter d_{G} is 19mm, the radius of two circular arc gaps is 3.6mm; there are four circle holes connected with the contact pin of the electric connector (11), and they are distributed symmetrically with an equal distance of 3.5mm, the center of four circle holes is located at a distance of 2mm with the center of the circular plate, moreover, the center of four circle holes is the same distance with the two gaps.

25. The method as claimed in claim 22, **characterized in that** the circle diameter d_{G} of the circular plate is 18mm or 25mm; when it is 18mm, the string length of the removed two bow shape is 8.2mm, and the distance between two strings is 16mm; when it is 25mm, the string length of the removed two bow shape is 9.8mm, and the distance between two strings is 23mm; wherein the diameter of circle hole with alignment pin is 8mm, the center of which is located at a distance of 2mm with the center of the circular plate, and the center of circle hole is the same distance with the two gaps.

26. The method as claimed in claim 23, **characterized in that** the circle diameter d_{G} of the circular plate is 20mm, 38mm or 50mm; if the string length between the gap subtract the outward tilting part of both sides, the length is 10mm, and the radius of circular arc used for transition is 1 mm; the two corresponding strings of two gaps are parallel to each other; when the circle diameter d_{G} of the circular plate is 20mm, the distance between two strings is 15mm; when the circle diameter d_{G} of the circular plate is 38mm, the distance between two strings is 33mm;when the circle diameter d_{G} of the circular plate is 50mm, the distance between two strings is 45mm;there are two fixed holes provided on the light engine plate for fixing, the two fixed holes are symmetric around the center of circular plate with a distance of dG-6, the diameter of fixed hole is 2.2mm; the link of two fixed holes is orthogonal with that of gaps center; when d_{G}=20mm, a fixed hole of one side need to be opened.

27. The method as claimed in claim 3, claim 4, claim 6, claim 11 and claim 16, **characterized in that** the phosphor and protective layer are coated on the transparent cover plate (42) and the light engine plate (43); or the transparent cover plate (42) and/or the light engine plate (43) are molded transparent fluorophor.

28. The method as claimed in claim 7, claim 8, claim 9, claim 12, claim 13, claim 14, claim 17, claim 18 or claim 19, **characterized in that** the lens (7) can be replaced by an outer cover (9), when the outer cover (9) is used in the light bulb, the outer cover (9) need to be bonding disposed around a periphery of the inner cover (61) or the lens snap ring (8).

29. The method as claimed in claim 5, 11 or 16, **characterized in that** the inner cover (61) is concave shape, when the stress of the inner heat conduction fluid is too large, the concave part can be protruded to the outside to increase the volume to accommodate the inflated volume of transparent insulated heat conduction fluid, preventing the failure of the inner cover (61) sealing due to the swelling of transparent insulated heat conduction fluid; the phosphor and protective layer are coated on the surface of the inner cover (61); or the inner cover (61) is molded transparent fluorophor.
